# EUROPEAN PATENT APPLICATION

(11) **EP 4 593 544 A1**
(43) Date of publication of application: **30.07.2025**
(21) Application number: 24805092.4
(22) Date of filing: 19.09.2024
(51) Int. Cl.: H10B 10/00

(54) **MEMORY CHIP, LOGIC CHIP, CHIP STACK STRUCTURE, AND MEMORY**

(30) Priority: 06.12.2023 CN 202311693030
(71) Applicant: CXMT Corporation, Hefei, Anhui 230601 (CN)
(72) Inventor: ZHANG, Jiarui, Hefei, Anhui 230601 (CN)
(74) Representative: Gulde & Partner
(86) International application number: PCT/CN2024/119832
(87) International publication number: WO 2025/118772

(57) **Abstract**

The present disclosure provides a memory chip, a logic chip, a chip stack structure, and a memory. In a global signal region of the logic chip, a plurality of conductive via groups are provided, where four normal conductive vias in an i^{th} conductive via group are electrically connected in one-to-one correspondence to four internal ports in an i^{th} internal port group, and a correspondence relationship between the four normal conductive vias and the four internal ports is determined based on a select signal.

## Description

### CROSS-REFERENCE TO RELATED APPLICATIONS

The present disclosure claims priority to Chinese Patent Application No. 202311693030.0 filed with China National Intellectual Property Administration on December 6, 2023, and entitled "MEMORY CHIP, LOGIC CHIP, CHIP STACK STRUCTURE, AND MEMORY", the content of which is incorporated herein by reference in its entirety.

### TECHNICAL FIELD

The present disclosure relates to the field of semiconductor technologies, and in particular, relates to a memory chip, a logic chip, a chip stack structure, and a memory.

### BACKGROUND

With the development of integrated circuit technologies, remarkable progress has been made in the manufacturing process of semiconductor devices. In recent years, however, the development of two-dimensional semiconductor technology has been accompanied by various challenges, including physical limits, limits of existing development technology, limits of storage electron density, etc. In this context, to solve the difficulties encountered by two-dimensional semiconductor devices and to pursue lower production costs per unit memory cell, a plurality of chips may be stacked by using a bonding process (e.g., hybrid bonding, bumping, and wire bonding) to form a three-dimensional semiconductor device. However, for the three-dimensional semiconductor device, connection structures between different chips still have problems such as large parasitic capacitance and large parasitic resistance, which affect the signal transmission quality.

### SUMMARY

Embodiments of the present disclosure provide a memory chip, a logic chip, a chip stack structure, and a memory.

According to a first aspect, the embodiments of the present disclosure provide a memory chip.

A center point of an active surface of the memory chip and an area adjacent to the center point are defined as a global signal region, and a center point of the global signal region coincides with the center point of the active surface; the global signal region has a first axis and a second axis, the first axis and the second axis are perpendicular to each other and intersect at the center point of the active surface, the first axis is parallel to a first side of the memory chip, and the second axis is parallel to a second side of the memory chip;
the global signal region is penetrated by n conductive via groups along a third direction, where the third direction is perpendicular to the active surface, and n is a positive integer;
each one of the conductive via groups includes four normal conductive vias; a first normal conductive via and a second normal conductive via are arranged symmetrically about the first axis, a third normal conductive via and a fourth normal conductive via are arranged symmetrically about the first axis, and the first normal conductive via and the fourth normal conductive via are arranged symmetrically about the second axis;
an internal circuit of the memory chip includes n internal port groups, and each one of the internal port groups includes four internal ports; and
the memory chip further includes n select circuits (30); an i^{th} one of the select circuits (30) is configured to receive a select signal, and electrically connect, based on the select signal, four normal conductive vias in an i^{th} one of the conductive via groups in one-to-one correspondence to four internal ports in an i^{th} one of the internal port groups, where a correspondence relationship between the four normal conductive vias and the four internal ports is determined based on the select signal, and i is a positive integer less than or equal to n.

According to a second aspect, the embodiments of the present disclosure provide a logic chip. A center point of an active surface of the logic chip and an area adjacent to the center point are defined as a global signal region, and a center point of the global signal region coincides with the center point of the active surface; the global signal region has a first axis and a second axis, the first axis and the second axis are perpendicular to each other and intersect at the center point of the active surface, the first axis is parallel to a first side of the logic chip, and the second axis is parallel to a second side of the logic chip;
the global signal region is penetrated by n conductive via groups along a third direction, where the third direction is perpendicular to the active surface, and n is a positive integer;
each one of the conductive via groups includes four normal conductive vias; a first normal conductive via and a second normal conductive via are arranged symmetrically about the first axis, a third normal conductive via and a fourth normal conductive via are arranged symmetrically about the first axis, and the first normal conductive via and the fourth normal conductive via are arranged symmetrically about the second axis;
the logic chip further includes n control circuits, and an internal circuit of the logic chip includes n first signal ports, n second signal ports, n third signal ports, and n fourth signal ports, where an i^{th} one of the control circuits is configured to electrically connect the first normal conductive via, the second normal conductive via, the third normal conductive via, and the fourth normal conductive via in an i^{th} one of the conductive via groups in one-to-one correspondence to an i^{th} one of the first signal ports, an i^{th} one of the second signal ports, an i^{th} one of the third signal ports, and an i^{th} one of the fourth signal ports.

According to a third aspect, the embodiments of the present disclosure provide a chip stack structure. The chip stack structure includes the logic chip as described in the second aspect and at least one stack unit, where the logic chip and the at least one stack unit are sequentially stacked along a third direction; each one of the at least one stack unit includes a first memory chip, a second memory chip, a third memory chip, and a fourth memory chip sequentially stacked along the third direction, with the third direction being perpendicular to a top surface of each one of the memory chips; the first memory chip, the second memory chip, the third memory chip, and the fourth memory chip are each the memory chip as described in the first aspect;
the first memory chip and the second memory chip are stacked in a face-to-face manner, the second memory chip and the third memory chip are stacked in a back-to-back manner, and the third memory chip and the fourth memory chip are stacked in a face-to-face manner; and the first memory chip and the logic chip in a first one of the at least one stack unit are stacked in a back-to-face manner, or the first memory chip and the logic chip in the first one of the at least one stack unit are stacked in a back-to-back manner.

In a fourth aspect, the embodiments of the present disclosure provide a memory. The memory includes the chip stack structure as described in any of the third aspect.

The embodiments of the present disclosure provide a memory chip, a logic chip, a chip stack structure, and a memory. A signal is transmitted by each conductive via in the global signal region to the inside of the chip, to improve signal transmission efficiency. In addition, the conductive vias are symmetrically arranged, such that the chip stack structure formed by the memory chip achieves a signal rotation transmission effect through the direct connection configuration of the conductive vias with small parasitic resistance and parasitic capacitance. Meanwhile, through the symmetrically arranged repair units, a redundancy repair function of the above structure can be realized, which improves the stability of the memory chips.

### BRIEF DESCRIPTION OF THE DRAWINGS

FIG. 1 is a schematic structural diagram of a chip;
FIG. 2A is a first schematic constitutional diagram of a chip stack structure;
FIG. 2B is a first schematic constitutional diagram of a chip stack structure;
FIG. 3 is a schematic diagram of a memory chip according to an embodiment of the present disclosure;
FIG. 4 is a first schematic diagram of a global signal region in a memory chip according to an embodiment of the present disclosure;
FIG. 5A is a schematic diagram of chip stacking for a memory chip according to an embodiment of the present disclosure;
FIG. 5B is a schematic diagram of another chip stacking for a memory chip according to an embodiment of the present disclosure;
FIG. 6 is a second schematic diagram of a global signal region in a memory chip according to an embodiment of the present disclosure;
FIG. 7 is a schematic diagram of a select circuit in a memory chip according to an embodiment of the present disclosure;
FIG. 8 is a schematic partial structural diagram of a first select circuit according to an embodiment of the present disclosure;
FIGS. 9A to 9F are schematic diagrams of a repair process in a memory chip according to an embodiment of the present disclosure;
FIG. 10 is a schematic partial structural diagram of a second select circuit according to an embodiment of the present disclosure;
FIG. 11 is a schematic diagram of a logic chip according to an embodiment of the present disclosure;
FIG. 12 is a first schematic diagram of a global signal region in a logic chip according to an embodiment of the present disclosure;
FIG. 13 is a schematic diagram of a select circuit in a logic chip according to an embodiment of the present disclosure;
FIG. 14 is a schematic partial structural diagram of a first control circuit according to an embodiment of the present disclosure;
FIG. 15 is a schematic partial structural diagram of a second control circuit according to an embodiment of the present disclosure;
FIG. 16 is a schematic diagram of a composition structure of a chip stack structure according to an embodiment of the present disclosure;
FIGS. 17A/17B are specific schematic diagrams of a first chip stack structure according to an embodiment of the present disclosure;
FIGS. 18A/18B are specific schematic diagrams of a second chip stack structure according to an embodiment of the present disclosure;
FIG. 19 is a schematic diagram of signal transmission in a chip stack structure according to an embodiment of the present disclosure;
FIGS. 20A/20B are schematic diagrams of repairing for a chip stack structure according to an embodiment of the present disclosure;
FIGS. 21A/21B are specific schematic diagrams of a third chip stack structure according to an embodiment of the present disclosure;
FIGS. 22A/22B are specific schematic diagrams of a fourth chip stack structure according to an embodiment of the present disclosure; and
FIG. 23 is a schematic diagram of a composition structure of a memory according to an embodiment of the present disclosure.

### DETAILED DESCRIPTION

The technical solutions in the embodiments of the present disclosure will be clearly and completely described below with reference to the drawings in the embodiments of the present disclosure. It can be understood that the specific embodiments described herein are merely illustrative of the related applications and are not intended to limit the present disclosure. In addition, it should be noted that for the convenience of description, only the portions relevant to the related applications are shown in the drawings.

Unless defined otherwise, all technical and scientific terms used herein have the same meaning as commonly understood by those skilled in the art to which the present disclosure belongs. The terms used herein are for the purpose of describing the embodiments of the present disclosure only and are not intended to limit the present disclosure.

In the following description, reference is made to "some embodiments" which describe a subset of all possible embodiments, but it can be understood that "some embodiments" may be the same subset or different subsets of all possible embodiments and may be combined with each other without conflict.

It should be noted that the terms "first\second\third" referred to in the embodiments of the present disclosure are merely used for distinguishing similar objects and do not represent a specific ordering for the objects. It can be understood that "first\second\third" may be subjected to interchange of a specific order or sequence if permitted, such that the embodiments of the present disclosure described herein can be implemented in an order other than that shown or described herein.

Before describing the embodiments of the present disclosure, three directions for describing three-dimensional structures that may be used in the planes involved in the following embodiments are defined. Taking the Cartesian coordinate system as an example, the three directions may include a first direction, a second direction, and a third direction.

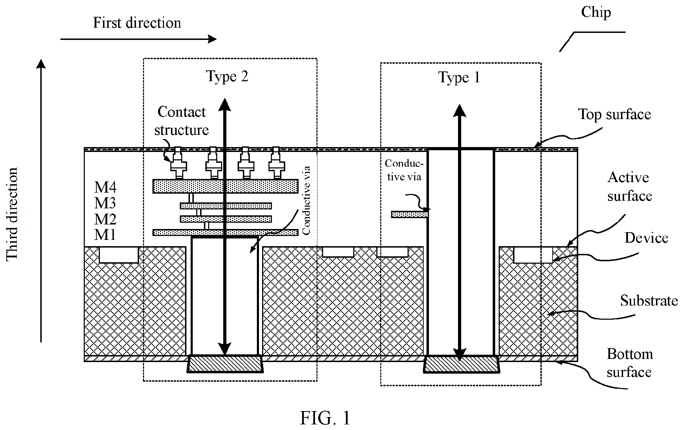

Referring to FIG. 1, a semiconductor chip (specifically, a memory chip or a logic chip) may include a top surface at a front side and a bottom surface at a back side opposite to the front side. A direction intersecting with (e.g., perpendicular to) the top surface and the bottom surface of the semiconductor chip is defined as a third direction in the case that the flatness of the top surface and the bottom surface is ignored. On the top surface of the semiconductor chip, two directions perpendicular to each other, i.e., a first direction and a second direction, are defined, and the first direction is perpendicular to one edge of the semiconductor chip, and the second direction is perpendicular to another edge of the semiconductor chip.

Referring to FIG. 1, the semiconductor chip includes a substrate. An active surface is formed on a side of the substrate for manufacturing devices (e.g., transistors and capacitors), and a plurality of metal layers, for example, M1, M2, M3, ..., are distributed between the substrate and the top surface. FIG. 1 further shows two types of conductive vias (e.g., silicon conductive vias), and both are used for signal connection between different stacked chips.

As shown in FIG. 1, a type 1 conductive via penetrates through the bottom surface and the top surface along the third direction, and the conductive via is connected to an internal circuit of the chip through the metal layers.

As shown in FIG. 1, a type 2 conductive via penetrates through the substrate only along the third direction, and the aid of a contact structure penetrating through the top surface along the third direction is needed for realizing signal transmission. The contact structure and the conductive via are not electrically connected directly, but are electrically connected indirectly through the metal layers. For example, the contact structure in FIG. 1 is connected to M4, M4 is connected to M1 via M3 and M2 in turn, and M1 is connected to the conductive via. Of course, in other embodiments, the contact structure and the conductive via may be designed to be electrically connected directly.

Meanwhile, the types of the conductive vias are not limited to the above two types which are merely examples. In particular, the illustrations presented in the present disclosure are not meant to be actual views of any particular microelectronic apparatus or components thereof, but are merely idealized representations for describing illustrative embodiments. The drawings are not necessarily to scale.

The embodiments of the present disclosure are described in detail below with reference to the drawings.

In an embodiment, a memory chip and a logic chip are provided. The memory chip and the logic chip both include a plurality of conductive vias penetrating through the chip along the third direction. The conductive vias are used for implementing signal transmission between different chips, and all the conductive vias may each be located at any position. In particular, every 4 conductive vias can be functionally regarded as a conductive via group, but the respective positions of the 4 conductive vias are not limited.

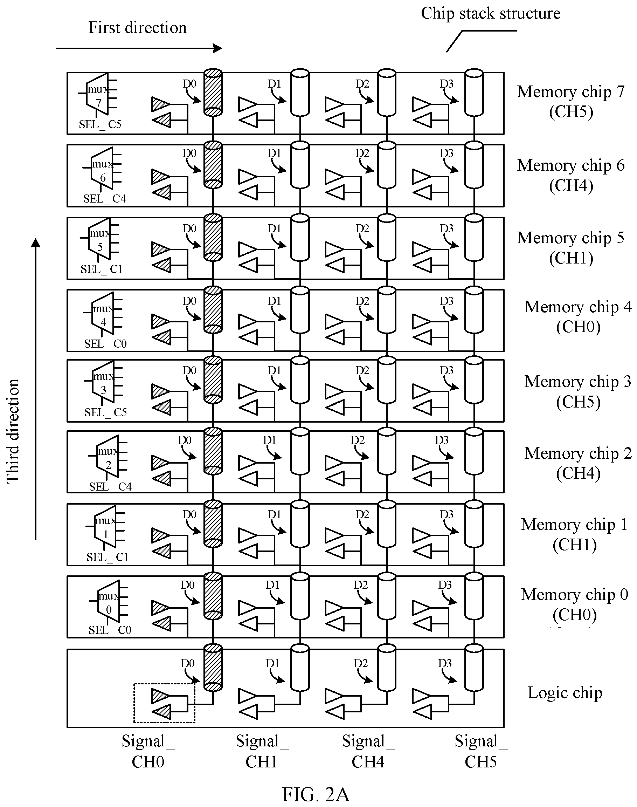

In a specific embodiment, 8 memory chips and 1 logic chip are stacked to form a 3D memory device, the respective conductive vias of the 8 memory chips are aligned along the third direction, and 9 conductive vias aligned along the third direction are connected to form an electrical path. Referring to FIG. 2A, a schematic diagram of signal transmission in a chip stack structure is shown. As shown in FIG. 2A, the chip stack structure includes memory chips 0-7 and a logic chip. FIG. 2A only shows four conductive vias D0-D3 for each memory chip, and the four conductive vias D0-D3 belong to the same conductive via group. In this case, the conductive vias D0 in the eight memory chips and the one logic chip are all aligned to form one electrical path, the conductive vias D1 in the eight memory chips and the one logic chip are all aligned to form one electrical path, ..., and so on.

Meanwhile, each memory chip and the logic chip are further provided with a plurality of driving circuits (only one driving circuit is shown in a dashed box in FIG. 2A, and the other driving circuits are not shown), and each conductive via is connected to one driving circuit. Each memory chip is further provided with a plurality of data selectors (e.g., mux0-7 in FIG. 2A), and each conductive via group corresponds to one data selector, that is, all the conductive vias of one conductive via group are connected to a data port of a data selector through respective driving circuits. That is, the data selector may decide the signal transmitted by which conductive via is to be output to the inside of the memory chip or the signal output by the memory chip is output to which conductive via.

For the whole memory device, different regions in different memory chips are divided into different channels (for example, CH0, CH1, CH4, and CH5) for management, and the signal Signal_CH0 of the channel CH0 is transmitted through an electrical path formed by "the conductive via D0 in the logic chip, the conductive via D0 in the memory chip 0-the conductive via D0 in the memory chip 1-the conductive via D0 in the memory chip 2-the conductive via D0 in the memory chip 3-the conductive via D0 in the memory chip 4-the conductive via D0 in the memory chip 5-the conductive via D0 in the memory chip 6-the conductive via D0 in the memory chip 7". The select signals of the data selector mux0 in the memory chip 0 and the data selector mux4 in the memory chip 4 are both SEL_C0, that is, the signal Signal_CH0 can enter the memory chip 0 and the memory chip 4 through the aforementioned electrical path. The process of signal output can be understood similarly.

As can be seen from the above, the memory chip 0 only needs to acquire signals from the conductive via D0, and the memory chip 1 only needs to acquire signals from the conductive via D1, ..., that is, each memory chip only needs to acquire signals from one conductive via in one conductive via group. It is worth noting that different memory chips may need to acquire signals from different conductive vias. However, since all memory chips need to be designed to have the same structure during the manufacturing process (which can save cost and labor to the maximum), all conductive vias in the memory chips need to be designed with corresponding driving structures and data selectors for structural consistency. Further, in the case that the chip stack structure shown in FIG. 2A is adopted, each conductive via corresponds to a driving circuit. In the working process of the chip stack structure, all driving circuits in all memory chips in the same channel need to be driven, resulting in a large load and large parasitic capacitance, which seriously affects the performance of the chips, restricts the transmission efficiency, increases the power consumption, and restricts the number of stacked chips in the three-dimensional device.

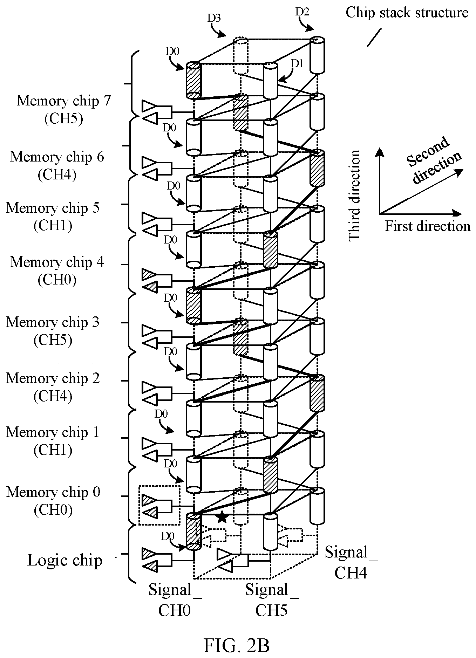

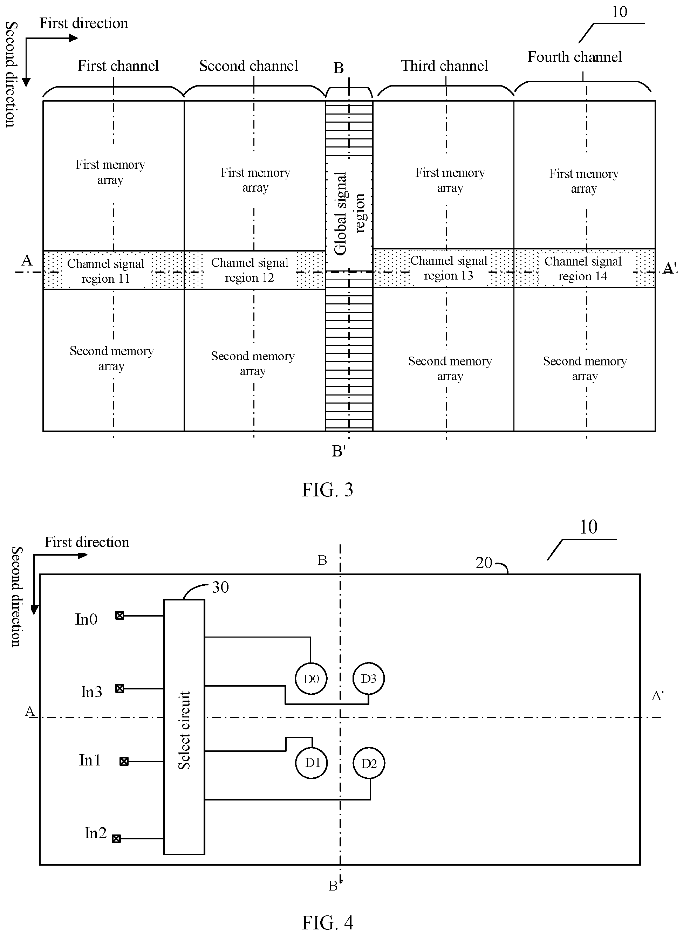

In another embodiment, referring to FIG. 2B, a schematic diagram of signal transmission in another chip stack structure is shown. In particular, in FIG. 2B, only some of the conductive vias (D0-D3) are identified, and others are omitted. However, for FIG. 4, identifiers of the conductive vias aligned along the third direction are the same. As shown in FIG. 2B, the chip stack structure also includes 8 memory chips and 1 logic chip aligned along the third direction, but each conductive via in each memory chip is connected to another conductive via at a different position in another memory chip in a rotating manner, such that a general spiral-up connection is realized, i.e., the signal Signal_CH0 of the channel CH0 is transmitted through "the conductive via D0 in the logic chip-the conductive via D1 in the memory chip 0-the conductive via D2 in the memory chip 1-the conductive via D3 in the memory chip 2-the conductive via D0 in the memory chip 3-the conductive via D1 in the memory chip 4-the conductive via D2 in the memory chip 5-the conductive via D3 in the memory chip 6-the conductive via D0 in the memory chip 7", and other signals are similarly transmitted.

In this way, the memory chip 0 can acquire the signal Signal_CH0 through the output end of the conductive via D0 in the logic chip, the memory chip 1 can acquire the signal Signal_CH1 through the input end of the conductive via D0 in the memory chip 0, the memory chip 2 can acquire the signal Signal_CH4 through the input end of the conductive via D0 in the memory chip 1, and the memory chip 3 can acquire the signal Signal_CH5 through the input end of the conductive via D0 in the memory chip 2, ..., such that for each memory chip, only one conductive via in each conductive via group needs to be connected to the driving circuit, and no data selector is needed, such that the number of devices can be reduced, thereby reducing the parasitic capacitance. However, compared with the direct connection configuration of the conductive vias in FIG. 2A, the process of the rotational connection of the conductive vias in FIG. 2B is more complicated. Specifically, in FIG. 2B, a horizontal interconnection structure needs to be disposed between adjacent conductive vias in each memory chip (only one horizontal interconnection structure is marked with a five-pointed star in FIG. 2B), and the signal interconnection structures may be metal interconnection lines, conductive vias, or the like. To implement the rotational connection of the conductive vias, the input signal signal_CH0 has to be transmitted upward from the conductive via D0 of the logic chip to the interconnection structure below the conductive via D0 of the memory chip 0 (instead of accessing the conductive via D0 of the memory chip 0) and then horizontally transmitted from the interconnection structure below the conductive via D0 of the memory chip 0 to the conductive via D1 of the memory chip 0. That is, for the structure shown in FIG. 2B, a signal also needs to pass through the interconnection structures in each memory chip during the signal process, and the situation is similar for outputting signals, which inevitably results in increased parasitic resistance and increased process complexity.

In particular, in the chip stack structures of FIG. 2A and FIG. 2B, active surfaces of all chips are upward facing, i.e., different memory chips are stacked in a back-to-face manner. The memory chips and the logic chip are also stacked in a back-to-face manner, i.e., the bottom surface of the upper chip is in contact with the top surface of the lower chip.

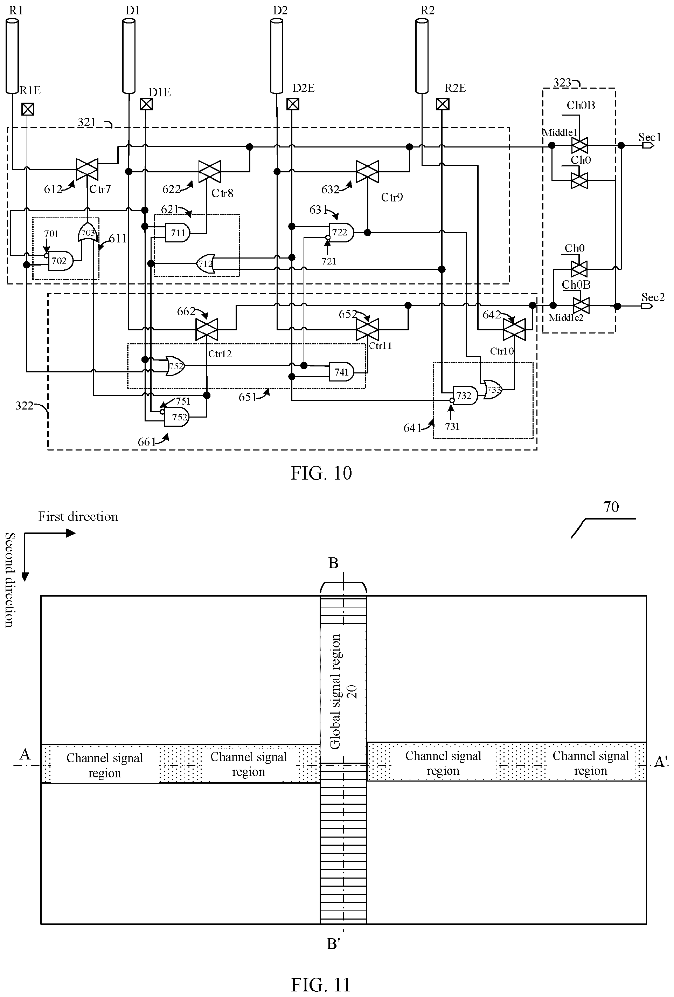

In summary, in one aspect, the chip stack structure in FIG. 2A needs to be provided with more conductive vias to transmit corresponding signals, which, together with the corresponding driving circuits and data selectors, cause a large load and large parasitic capacitance, while the chip stack structure in FIG. 2B causes large parasitic resistance due to the rotational configuration; in another aspect, the stack structures in FIG. 2A and FIG. 2B both have some problems and cannot be directly applied to face-to-face stack structures. Specifically, if a face-to-face chip stack structure is desired to be further realized, one method is to use two sets of masks to manufacture two different chips as a chip with active surface facing upward and a chip with active surface facing downward, respectively, and this process is characterized by high process complexity and uncontrollable cost; another method is to form an additional group of conductive vias and connect the two groups of conductive vias to the same driving circuit in the memory chip, but the method may result in complex internal wiring of the memory chip, which may not only increase the process complexity, but also increase the power consumption. In another embodiment of the present disclosure, referring to FIG. 11, a schematic structural diagram of a memory chip 10 according to an embodiment of the present disclosure is shown, and it can be specifically understood as a schematic sectional diagram of an active surface. As shown in FIG. 11, the memory chip 10 includes m channels (FIG. 11 shows an example where m = 4) sequentially arranged along the first direction, each channel includes a first memory array region, a channel signal region, and a second memory array region that are sequentially distributed along the second direction, and a center of each channel signal region coincides with a center of its respective channel.

A center of the active surface of the memory chip 10 and an area adjacent to the center are defined as a global signal region 20, and a center point of the global signal region 20 coincides with a center point of the active surface; the m channels are arranged symmetrically about the global signal region 20. The global signal region 20 and the channel signal region are both penetrated by a plurality of conductive vias along the third direction, and the third direction is perpendicular to the active surface.

Here, the conductive via may be a through-silicon-via (TSV), specifically a vertical interconnection structure penetrating through a silicon wafer/chip, or in other embodiments, the conductive via may be another conductive via with a conductive function, which is not specifically limited. In addition, the conductive via may take the form of the aforementioned type 1 or the form of the aforementioned type 2.

For the global signal region 20, each conductive via is used for transmitting a global signal, and the global signal is shared among all regions in the memory chip. Specifically, the global signal includes but is not limited to: a reset signal, a power-on signal, a stack identification signal (SID/CID), a power-related signal (Voltage Monitor), and a timing-related signal (Timing Aligner). In some cases, the global signal region 20 may also refer to a pad region. The global signal may be a design for test (DFT) test signal, and the working condition of the internal circuit of the chip and the transmission condition of the related signal may be learned through the global signal. In addition, since a DFT pin pad (PAD) in a logic chip is generally located in the middle of the chip, it is preferable for the conductive vias for DFT and other global signals to be located in a narrower region in the middle of the chip, that is, at the position of the global signal region 20 as shown in FIG. 3. On the contrary, for the channel signal region, each conductive via is used for transmitting a channel signal, and each channel signal is used only by a corresponding channel.

Referring to FIG. 3, the active surface includes a first axis AA' and a second axis BB'. The first axis AA' is parallel to a first side of the memory chip 10, and the first axis AA' and the second axis BB' are perpendicular to each other and intersect at the center point of the active surface. In FIG. 3, the first axis AA' extends along the first direction, and the second axis BB' extends along the second direction. In another embodiment, the first axis AA' may extend along the second direction, and the second axis BB' may extend along the first direction.

For the global signal region 20, the plurality of conductive vias therein are divided into a plurality of conductive via groups. That is, the global signal region 20 is penetrated by n conductive via groups along the third direction, where n is a positive integer. Referring to FIG. 4, each conductive via group includes four normal conductive vias (D0, D1, D2, and D3), where a first normal conductive via D0 and a second normal conductive via D1 are arranged symmetrically about the first axis AA', a third normal conductive via D2 and a fourth normal conductive via D3 are arranged symmetrically about the first axis AA', and the first normal conductive via D0 and the fourth normal conductive via D3 are arranged symmetrically about the second axis BB'.

Referring to FIG. 4, the memory chip 10 further includes n select circuits 30, and an internal circuit of the memory chip 10 includes n internal port groups (In0-In2). Because of limited space, FIG. 4 shows only one conductive via group and one internal port group.

An i^{th} select circuit 30 is configured to receive a select signal and electrically connect, based on the select signal, four normal conductive vias in an i^{th} conductive via group in one-to-one correspondence to four internal ports in an i^{th} internal port group, where a correspondence relationship between the four normal conductive vias and the four internal ports is determined based on the select signal.

For ease of description, the i^{th} internal port group includes an i^{th} first internal port In0, an i^{th} second internal port In1, an i^{th} third internal port In2, and an i^{th} fourth internal port In3.

Referring to Table 1, the i^{th} select circuit is configured to: (1) electrically connect, if the select signal is a first preset value, the first normal conductive via D0, the second normal conductive via D1, the third normal conductive via D2, and the fourth normal conductive via D3 in the i^{th} conductive via group in one-to-one correspondence to the i^{th} first internal ports In0, the i^{th} second internal port In1, the i^{th} third internal port In2, and the i^{th} fourth internal port In3, as shown in Case 1 in Table 1; (2) electrically connect, if the select signal is a second preset value, the first normal conductive via D0, the second normal conductive via D1, the third normal conductive via D2, and the fourth normal conductive via D3 in the i^{th} conductive via group in one-to-one correspondence to the i^{th} second internal port In1, the i^{th} first internal port In0, the i^{th} fourth internal port In3, and the i^{th} third internal port In2, as shown in Case 2 in Table 1; (3) electrically connect, if the select signal is a third preset value, the first normal conductive via D0, the second normal conductive via D1, the third normal conductive via D2, and the fourth normal conductive via D3 in the i^{th} conductive via group in one-to-one correspondence to the i^{th} third internal port In2, the i^{th} fourth internal port In3, the i^{th} first internal port In0, and the i^{th} second internal port In1, as shown in Case 3 in Table 1; or (4) electrically connect, if the select signal is a fourth preset value, the first normal conductive via D0, the second normal conductive via D1, the third normal conductive via D2, and the fourth normal conductive via D3 in the i^{th} conductive via group in one-to-one correspondence to the i^{th} fourth internal port In3, the i^{th} third internal port In2, the i^{th} second internal port In1, and the i^{th} first internal port In0, as shown in Case 4 in Table 1.

**Table 1**

| | Case 1 | Case 2 | Case 3 | Case 4 |
|---|---|---|---|---|
| Select signal Se[1:0] | 00 | 10 | 11 | 01 |
| First internal port In0 | D0 | D1 | D2 | D3 |
| Second internal port In1 | D1 | D0 | D3 | D2 |
| Third internal port In2 | D2 | D3 | D0 | D1 |
| Fourth internal port In3 | D3 | D2 | D1 | D0 |

Referring to FIG. 2A or 2B, the logic chip and a plurality of memory chips 10 are stacked along the third direction to form a chip stack structure; in the chip stack structure, one stack unit is formed with every four memory chips 10. Meanwhile, each memory chip 10 is provided with a chip position identification code CID and a stack position identification code SID, where the chip position identification code CID indicates a position of the memory chip 10 in a stack unit to which the memory chip belongs, and the stack position identification code SID indicates a position of the stack unit to which the memory chip 10 belongs in a chip stack structure to which the stack unit belongs.

For example, a chip stack unit is formed by stacking one logic chip and eight memory chips 10 (with every four memory chips 10 forming one stack unit, totaling two stack units). In this case, the CID has a 2-bit sub-signal CID[1:0], the SID has a 2-bit sub-signal SID[1:0], and the chip position identification code CID[1:0] is decoded from a chip position identification code CID₀[3:0]. In particular, in a normal operation stage of the memory chip 10, numbering is performed from the side of the logic chip (that is, from bottom to top), and in this case, CID[1:0] and SID[1:0] of each chip are shown in Table 2. In an initialization stage of the memory chip 10, numbering is performed from a side distal to the logic chip (that is, from top to bottom), which is not yet illustrated for now but can be understood correspondingly.

**Table 2**

| | CID₀ [3:0] | CID[1:0 ] | SID[1:0 ] | Select signal Ch[1:0] with the stacking form in FIG. 5A | Select signal Ch[1:0] with the stacking form in FIG. 5B |
|---|---|---|---|---|---|
| Fourth memory chip 14 | 1000 | 11 | 01 | 01 | 10 |
| Third memory chip 13 | 0100 | 10 | 01 | 11 | 11 |
| Second memory chip 12 | 0010 | 01 | 01 | 10 | 01 |
| First memory chip 11 | 0001 | 00 | 01 | 00 | 00 |
| Fourth memory chip 14 | 1000 | 11 | 00 | 01 | 10 |
| Third memory chip 13 | 0100 | 10 | 00 | 11 | 11 |
| Second memory chip 12 | 0010 | 01 | 00 | 10 | 01 |
| First memory chip 11 | 0001 | 00 | 00 | 00 | 00 |
| Logic chip | 0001 | 00 | 00 | - | - |

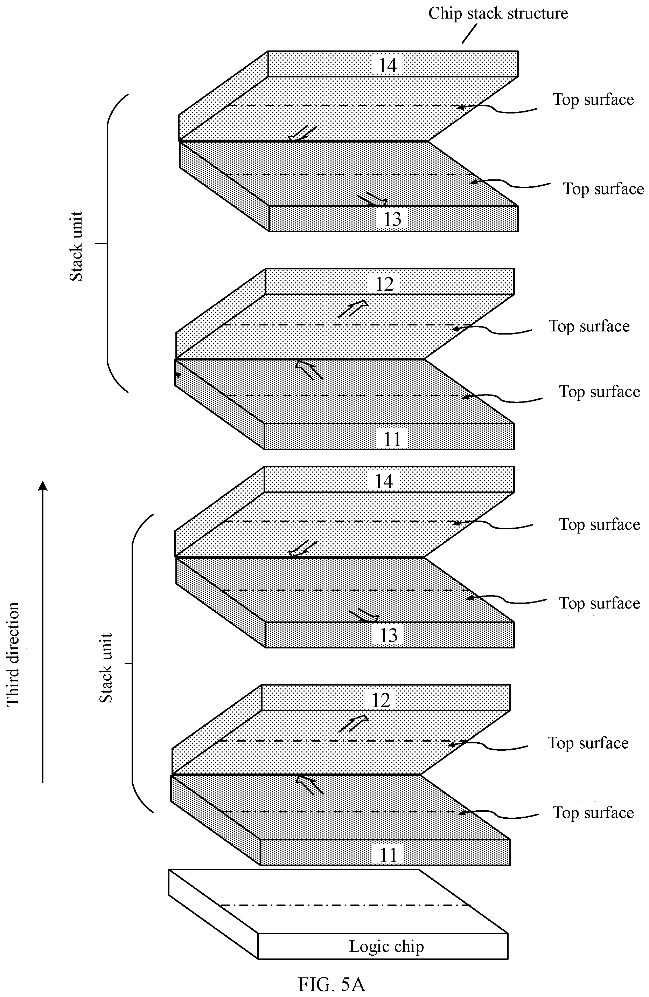

In particular, in the embodiment of the present disclosure, different memory chips 10 are placed at different positions in the chip stack structure. For ease of description, the active surface (a plane where the first direction and the second direction are located) of each memory chip 10 is divided into a lower transmission region and a upper transmission region, as shown in FIG. 5A, where the arrow direction on each chip indicates the upper transmission region.

In the embodiment of the present disclosure, positions of the memory chips 10 are divided into four types: Top surfaces of the memory chips at a first-type position and a third-type position face upward along the third direction, and top surfaces of the memory chips at a second-type position and a fourth-type position face downward along the third direction; the active surface of each memory chip is divided into a lower transmission region and a upper transmission region, and the lower transmission region in the memory chip at the first-type position, the upper transmission region in the memory chip at the second-type position, the upper transmission region in the memory chip at the third-type position, and the lower transmission region in the memory chip at the fourth-type position are aligned along the third direction.

In one stacking manner, referring to FIG. 5A, (1) the first memory chip 11 is at the first-type position, the second memory chip 12 is at the second-type position, the third memory chip 13 is at the third-type position, and the fourth memory chip 14 is at the fourth-type position.

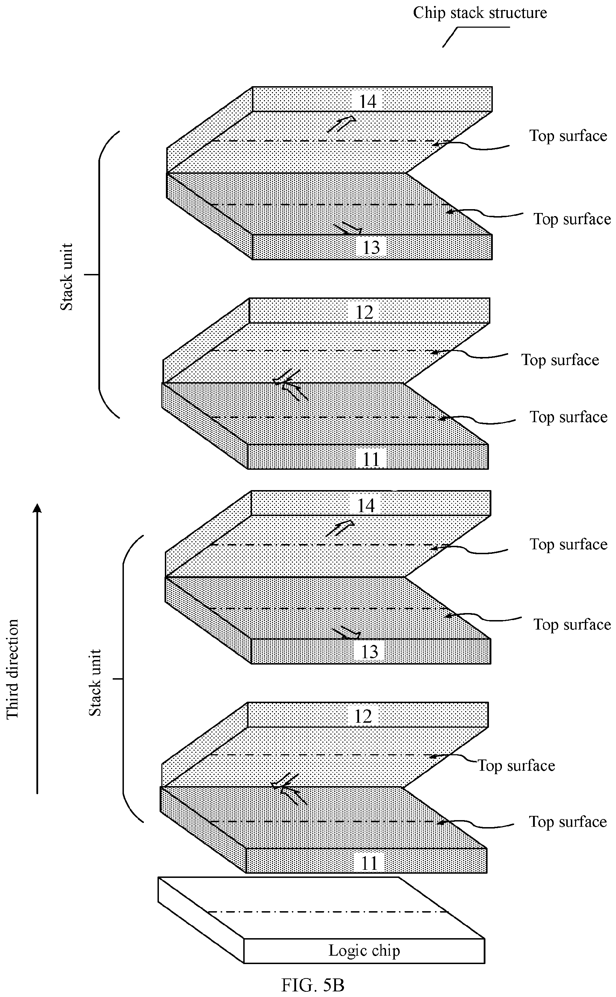

In another stacking manner, referring to FIG. 5B, (1) the first memory chip 11 is at the first-type position, the second memory chip 12 is at the fourth-type position, the third memory chip 13 is at the third-type position, and the fourth memory chip 14 is at the second-type position.

The memory chip 10 further includes a decoding circuit 21, which is configured to receive a chip position identification code CID[1:0]. The decoding circuit outputs a select signal with a first preset value if the chip position identification code CID[1:0] indicates the first-type position; outputs a select signal with a second preset value if the chip position identification code CID[1:0] indicates the second-type position; outputs a select signal with a third preset value if the chip position identification code CID[1:0] indicates the third-type position; or outputs a select signal with a fourth preset value if the chip position identification code CID[1:0] indicates the fourth-type position.

In some other embodiments, the decoding circuit 21 may also generate a select signal based on CID₀[3:0].

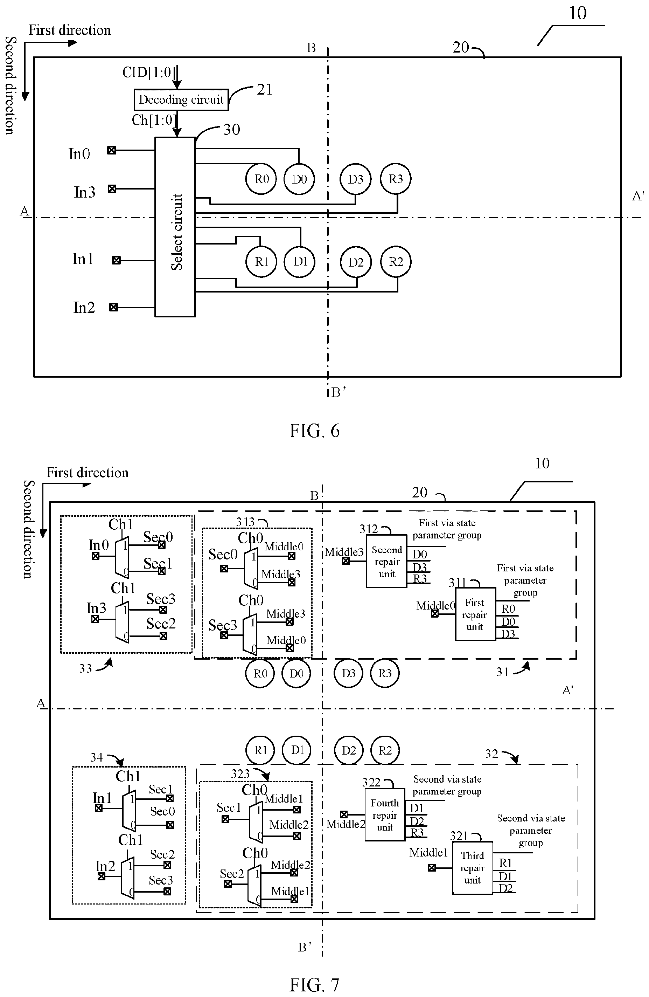

In some embodiments, referring to FIG. 6, each conductive via group further includes a first redundant conductive vias R0, a second redundant conductive vias R1, a third redundant conductive vias R2, and a fourth redundant conductive vias R3. FIG. 6 temporarily shows an example where a = 1, but a may be any other positive integer. As shown in FIG. 6, the a first redundant conductive via R0 and the a second redundant conductive via R1 are arranged symmetrically about the first axis AA', the a third redundant conductive via R2 and the a fourth redundant conductive via R3 are arranged symmetrically about the first axis AA', and the a first redundant conductive via (R0) and the a fourth redundant conductive via (R3) are arranged symmetrically about the second axis BB'.

For each conductive via group, the a first redundant conductive via R0, the a second redundant conductive via R1, the first normal conductive via D0, and the second normal conductive via D1 form one repair unit, and the a third redundant conductive via R2, the a fourth redundant conductive via R3, the third normal conductive via D2, and the fourth normal conductive via D3 form another repair unit.

The select circuit 30 is further configured to replace, when any one of the normal conductive vias fails, the failed normal conductive via with another conductive via in a same repair unit for an electric connection to a corresponding internal port. For example, assuming that the select signal has the first preset value, the select circuit 30 electrically connects the first normal conductive via D0 to the first internal port In0 if the first normal conductive via D0 is not faulty; or electrically connects another conductive via in the same repair unit to the first internal port In0 if the first normal conductive via D0 is faulty.

It should be noted that the failure of a conductive via refers to the failure of a signal transmission channel formed by the conductive via and other conductive vias (belonging to other memory chips) aligned along the third direction. In other words, for the plurality of conductive vias aligned along the third direction, the damage of any conductive via will cause the failure of the signal transmission channel, and as a result, other conductive vias will also enter a failed state even though they are not damaged.

In the present disclosure, a normal conductive via refers to a conductive via for transmitting an effective signal in the initial design, and a redundant conductive via refers to a conductive via not for transmitting any signal in the initial design. However, in the case where any normal conductive via fails, the redundant conductive via may be changed into a normal conductive via for transmitting an effective signal, such that a memory can continue to work normally. That is, for the same repair unit, in the case where any normal conductive via fails, an effective signal transmitted by the normal conductive via is handed over to the next conductive via in the same repair unit along a preset signal handover direction. Specifically, (1) in the case where the next conductive via for the handover is a redundant conductive via, repairing is finished, and the redundant conductive via becomes a new normal conductive via; (2) in the case where the next conductive via for the handover is another normal conductive via, the signal originally transmitted by the switched normal conductive via continues to be handed over to the next conductive via along the preset handover direction.

In this way, through the select circuit 30, any conductive via in any repair unit, when used for transmitting an effective signal, is electrically connected to the internal circuit of the logic chip 10, and any conductive via in any repair unit, when not used for transmitting an effective signal, is electrically isolated from the internal circuit of the logic chip 10.

For a better understanding of the foregoing description, an example of redundancy repair logic is provided below with a = 1 as an example. However, the following example is not the only solution. In this specific embodiment, each normal conductive via may be repaired with two other conductive vias; but this is merely an example. In other embodiments, more redundant conductive vias may be arranged, or each normal conductive via may be repaired through another number of other conductive vias.

In some embodiments, referring to FIG. 6, the select circuit 30 is specifically configured to: replace, if the first normal conductive via D0 fails, the first normal conductive via D0 with the first redundant conductive via R0 or the fourth normal conductive via D3 for an electric connection to the corresponding internal port; replace, if the fourth normal conductive via D3 fails, the fourth normal conductive via D3 with the fourth redundant conductive via R3 or the first normal conductive via D0 for an electric connection to the corresponding internal port; replace, if the second normal conductive via D1 fails, the second normal conductive via D1 with the second redundant conductive via R1 or the third normal conductive via D2 for an electric connection to the corresponding internal port; or replace, if the third normal conductive via D2 fails, the third normal conductive via D2 with the third redundant conductive via R2 or the second normal conductive via D1 for an electric connection to the corresponding internal port.

It should be noted that if one normal conductive via is used to replace another failed normal conductive via, then another redundant conductive via is needed to replace the fourth normal conductive via D3 for an electric connection to the corresponding internal port, until a redundant conductive via is enabled. For example, if the fourth normal conductive via D3 replaces the first normal conductive via D0 for an electric connection to the corresponding internal port, then the fourth redundant conductive via R3 may need to be enabled to replace the fourth normal conductive via D3 for an electric connection to the corresponding internal port.

In this way, the repair units in the logic chip 10 are in four-quadrant symmetry, and the normal conductive vias therein are also in four-quadrant symmetry, such that the chip stack structure formed by the logic chip and memory chips (which also have the characteristics) realizes a signal rotation transmission effect through the direct connection configuration of the conductive vias with small parasitic resistance and parasitic capacitance, as detailed in the following description. Meanwhile, through the four-quadrant symmetrically arranged repair units, a redundancy repair function of the above structure can be realized, which improves the stability of the chip.

In a specific embodiment, referring to FIG. 7, the select signal includes a first select signal Ch0 and a second select signal Ch1. The i^{th} select circuit 30 includes an i^{th} first select circuit 31, an i^{th} second select circuit 32, an i^{th} first signal output circuit 33, and an i^{th} second signal output circuit 34.

One side of the i^{th} first select circuit 31 is coupled to the first normal conductive via D0, the fourth normal conductive via D3, the first redundant conductive via R0, and the fourth redundant conductive via R3 in the i^{th} conductive via group, and the other side is coupled to an i^{th} first secondary node Sec0 and an i^{th} fourth secondary node Sec3.

The i^{th} first select circuit 31 is configured to receive a first via state parameter group and the first select signal Ch0, and electrically connect one of the coupled conductive vias to the i^{th} first secondary node Sec0 as well as electrically connect another one of the coupled conductive vias to the i^{th} fourth secondary node Sec3 based on the first via state parameter group and the first select signal.

One side of the i^{th} second select circuit 32 is coupled to the second normal conductive via D1, the third normal conductive via D2, the second redundant conductive via R1, and the third redundant conductive via R2 in the i^{th} conductive via group, and the other side is coupled to an i^{th} second secondary node Sec1 and an i^{th} third secondary node Sec2.

The i^{th} second select circuit 32 is configured to receive a second via state parameter group and the first select signal Ch0, and electrically connect one of the coupled conductive vias to the i^{th} second secondary node Sec1 as well as electrically connect another one of the coupled conductive vias to the i^{th} third secondary node Sec2 based on the second via state parameter group and the first select signal.

The i^{th} first signal output circuit 33 is configured to receive the second select signal Ch1, and based on the second select signal, electrically connect the i^{th} first secondary node Sec0 to the i^{th} first internal port In0 and electrically connect the i^{th} fourth secondary node Sec3 to the i^{th} fourth internal port In3; or electrically connect an i^{th} second secondary node Sec1 to the i^{th} first internal port In0 and electrically connect the i^{th} third secondary node Sec2 to the i^{th} fourth internal port In3.

The i^{th} second signal output circuit 34 is configured to receive the second select signal Ch1, and based on the second select signal, electrically connect the i^{th} second secondary node Sec1 to the i^{th} second internal port In1 and electrically connect the i^{th} third secondary node Sec2 to the i^{th} third internal port In2; or electrically connect the i^{th} first secondary node Sec0 to the i^{th} second internal port In1 and electrically connect the i^{th} fourth secondary node Sec3 to the i^{th} third internal port In3.

Assuming that when each normal conductive via fails, another redundant conductive via is preferably used for repair; if both the normal conductive via and the corresponding redundant conductive via fail, then another normal conductive via is used for repair. A specific select circuit is provided below.

Referring to FIG. 7, the i^{th} first select circuit 31 includes an i^{th} first repair circuit 311, an i^{th} second repair circuit 312, and an i^{th} first select output circuit 313.

One side of the i^{th} first repair circuit 311 is coupled to the first redundant conductive via R0, the first normal conductive via D0, and the fourth normal conductive via D3 in the i^{th} conductive via group, and the other side is coupled to an i^{th} first primary node Middle0. The first repair circuit 311 is configured to receive an i^{th} first via state parameter group, and electrically connect one of the coupled first normal conductive via D0, first redundant conductive via R0, and fourth normal conductive via D3 to the i^{th} first primary node Middle0 based on the i^{th} first via state parameter group.

One side of the i^{th} second repair circuit 312 is coupled to the first normal conductive via D0, the fourth normal conductive via D3, and the fourth redundant conductive via R3 in the i^{th} conductive via group, and the other side is coupled to an i^{th} fourth primary node Middle3. The second repair circuit 312 is configured to receive the i^{th} first via state parameter group, and electrically connect one of the coupled first normal conductive via D0, fourth normal conductive via D3, and fourth redundant conductive via R3 to the i^{th} fourth primary node Middle3 based on the i^{th} first via state parameter group.

The i^{th} first select output circuit 313 is configured to receive the first select signal Ch0, and based on the first select signal, electrically connect the i^{th} first primary node Middle0 to the i^{th} first secondary node Sec0 and electrically connect the i^{th} fourth primary node Middle3 to the i^{th} fourth secondary node Sec3; or electrically connect the i^{th} fourth primary node Middle3 to the i^{th} first secondary node Sec0 and electrically connect the i^{th} first primary node Middle0 to the i^{th} fourth secondary node Sec3.

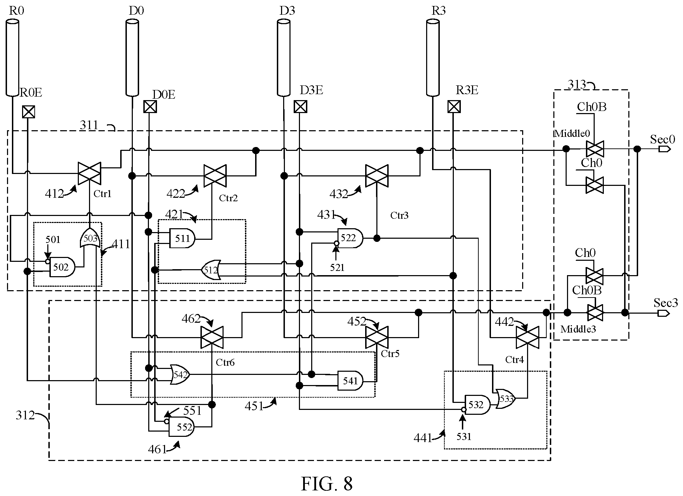

In a specific embodiment, a precondition is that the first preset value refers to the select signal Ch[1:0]=00, the second preset value refers to the select signal Ch[1:0]=10, the third preset value refers to the select signal Ch[1:0]=11, and the fourth preset value refers to the select signal Ch[1:0]=01. In this case, a feasible structure of the first select output circuit 313 is shown in FIG. 8.

As shown in FIG. 8, each select output circuit 313 may include four enabling transmission gates. A first enabling transmission gate is coupled between the first primary node Middle0 and the first secondary node Sec0, a second enabling transmission gate is coupled between the first primary node Middle0 and the fourth secondary node Sec3, an enabling terminal of the first enabling transmission gate receives an inverted signal of the first select signal Ch0, and an enabling terminal of the second enabling transmission gate receives the first select signal Ch0. A third enabling transmission gate is coupled between the fourth primary node Middle3 and the first secondary node Sec0, a fourth enabling transmission gate is coupled between the fourth primary node Middle3 and the fourth secondary node Sec3, an enabling terminal of the third enabling transmission gate receives the first select signal Ch0, and an enabling terminal of the fourth enabling transmission gate receives the inverted signal of the first select signal Ch0. The structure of the first signal output circuit 33 and the second signal output circuit 34 is similar to that described above.

In a specific embodiment, the i^{th} first via state parameter group includes a first state parameter R0E, a second state parameter D0E, a third state parameter D3E, and a fourth state parameter R3E, which indicates, in a one-to-one corresponding manner, whether the first redundant conductive via R0, the first normal conductive via D0, the fourth normal conductive via D3, and the fourth redundant conductive via R3 in the i^{th} conductive via group have failed. Any one of the state parameters being in the enabled state indicates that a corresponding conductive via has not failed; and any one of the state parameters being in the disabled state indicates that a corresponding conductive via has failed.

Referring to FIG. 8, the i^{th} first repair circuit 311 includes a first switching unit 412, a second switching unit 422, a third switching unit 432, a first logic unit 411, a second logic unit 421, and a third logic unit 431.

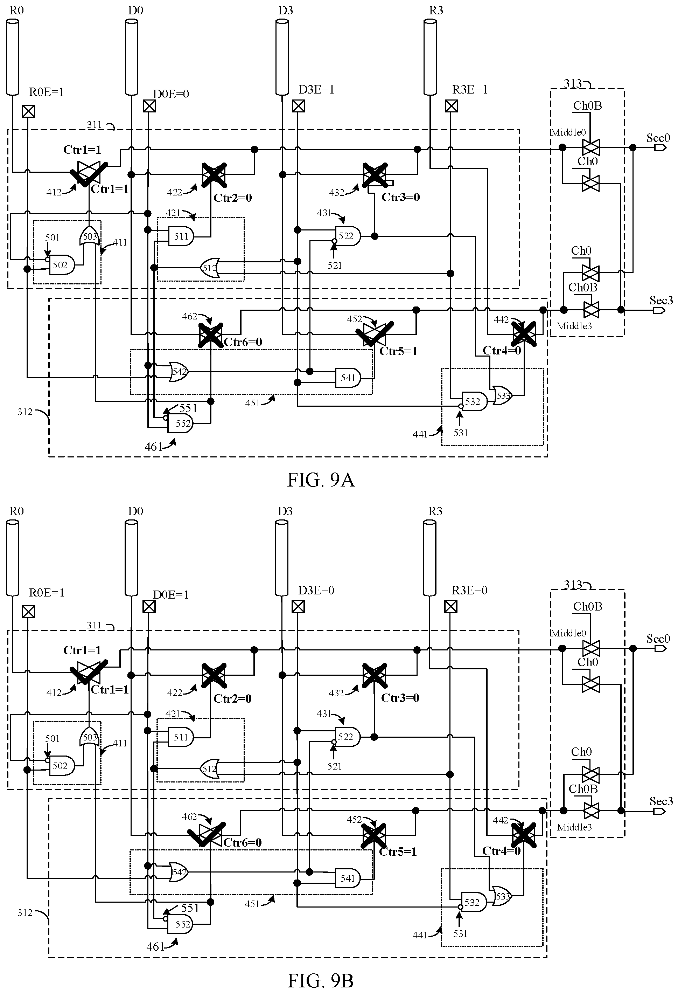

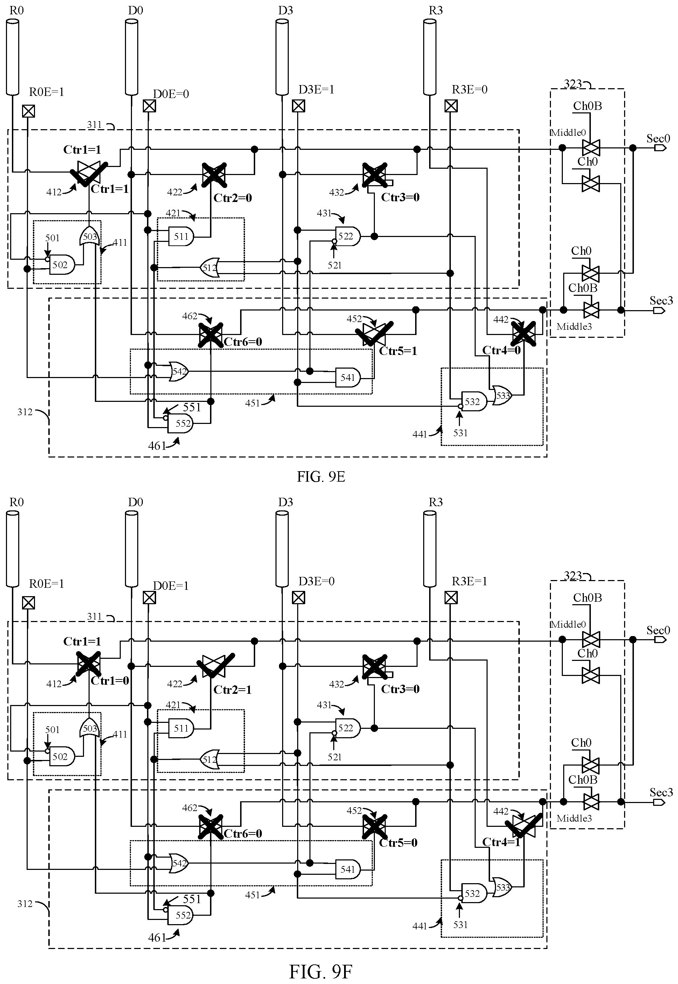

The first logic unit 411 is configured to output a first control signal Ctr1 in the enabled state only when the i^{th} first via state parameter group satisfies a first preset condition, where the first preset condition is that the first state parameter R0E is in the enabled state and the second state parameter D0E is in the disabled state, or that the first state parameter R0E and the second state parameter D0E are both in the enabled state and the third state parameter D3E and the fourth state parameter R3E are both in the disabled state. The first switching unit 412 is configured to control the i^{th} first redundant conductive via R0 to be electrically connected to the i^{th} first primary node Middle0 only when the first control signal Ctr1 is in the enabled state. In this way, R0 replaces D0 in operation (R0 is electrically connected to the first primary node Middle0) in the following two cases: (1) R0 has not failed and D0 has failed, referring to FIGS. 9A and 9E; (2) R0 and D0 have not failed and D3 and R3 have both failed, and in this case, the non-failed D0 needs to replace the failed D3 for an electric connection to the corresponding internal port, so R0 also needs to replace D0 in operation, referring to FIG. 9B.

The second logic unit 421 is configured to output a second control signal Ctr2 in the enabled state only when the i^{th} first via state parameter group satisfies a second preset condition, where the second preset condition is that the second state parameter D0E is in the enabled state, and at least one of the third state parameter D3E and the fourth state parameter R3E is in the enabled state. The second switching unit 422 is configured to control the i^{th} first normal conductive via D0 to be electrically connected to the i^{th} first primary node Middle0 only when the second control signal Ctr2 is in the enabled state.

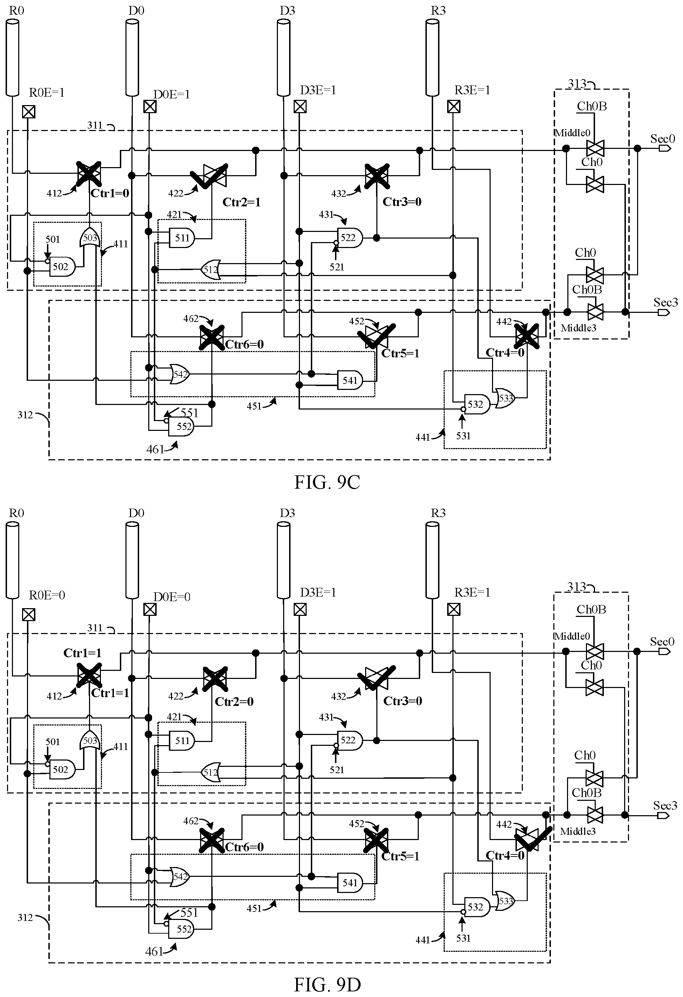

In this way, referring to FIG. 9C or 9F, D0 operates normally (D0 is electrically connected to the first primary node Middle0) in the following case: (1) D0 is not failed and at least one of D3 and R3 is not failed.

The third logic unit 431 is configured to output a third control signal Ctr3 in the enabled state only when the i^{th} first via state parameter group satisfies a third preset condition, where the third preset condition is that the first state parameter R0E and the second state parameter D0E are both in the disabled state, and the third state parameter D3E is in the enabled state. The third switching unit 432 is configured to control the i^{th} fourth normal conductive via D3 to be electrically connected to the i^{th} first primary node Middle0 only when the third control signal Ctr3 is in the enabled state.

In this way, referring to FIG. 9D, D3 replaces D0 in operation (D3 is electrically connected to the first primary node Middle0) in the following case: (1) D0 and R0 have both failed and D3 has not failed.

Similarly, the i^{th} second repair circuit 312 includes a fourth switching unit 442, a fifth switching unit 452, a sixth switching unit 462, a fourth logic unit 441, a fifth logic unit 451, and a sixth logic unit 461.

The fourth logic unit 441 is configured to output a fourth control signal Ctr4 in the enabled state only when the i^{th} first via state parameter group satisfies a fourth preset condition, where the fourth preset condition is that the fourth state parameter R3E is in the enabled state and the third state parameter D3E is in the disabled state, or that the fourth state parameter R3E and the third state parameter D3E are both in the enabled state and the second state parameter D0E and the first state parameter R0E are both in the disabled state. The fourth switching unit 442 is configured to control the i^{th} fourth redundant conductive via R3 to be electrically connected to the i^{th} fourth primary node Middle3 only when the fourth control signal Ctr4 is in the enabled state.

In this way, R3 replaces D3 in operation (R3 is electrically connected to the fourth primary node Middle3) in the following two scenarios: (1) R3 has not failed and D3 has failed, referring to FIG. 9F; (2) R3 and D3 have not failed and D0 and R0 have both failed, and in this case, the non-failed D3 needs to replace the failed D0 for an electric connection to the corresponding internal port, so R3 also needs to replace D3 in operation.

The fifth logic unit 451 is configured to output a fifth control signal Ctr5 in the enabled state only when the i^{th} first via state parameter group satisfies a fifth preset condition, where the fifth preset condition is that the third state parameter D3E is the enabled state, and at least one of the second state parameter D0E and the first state parameter R0E is in the enabled state. The fifth switching unit 452 is configured to control the i^{th} fourth normal conductive via D3 to be electrically connected to the i^{th} fourth primary node Middle3 only when the fifth control signal Ctr5 is in the enabled state.

In this way, D3 operates normally (D3 is electrically connected to the fourth primary node Middle3) in the following case: (1) D3 is not failed and at least one of D0 and R0 is not failed, referring to FIGS. 9C and 9E.

The sixth switching unit 462 is configured to output a sixth control signal Ctr6 in the enabled state only when the i^{th} first via state parameter group satisfies a sixth preset condition, where the sixth preset condition is that the fourth state parameter R3E and the third state parameter D3E are both in the disabled state, and the second state parameter D0E is in the enabled state. The sixth switching unit 462 is configured to control the i^{th} first normal conductive via D0 to be electrically connected to the i^{th} fourth primary node Middle3 only when the sixth control signal Ctr6 is in the enabled state.

In this way, D0 replaces D3 for an electric connection to the corresponding internal port (D0 is electrically connected to the fourth primary node Middle3) in the following case: D3 and R3 have both failed and D0 has not failed, referring to FIG. 9B.

For the following circuit settings: The enabled state is at a high level and the disabled state is at a low level; a feasible structure, but not the only structure, for each one of the above circuit units is provided.

As shown in FIG. 8, the first logic unit 411 includes a first NOT gate 501, a first AND gate 502, and a first OR gate 503; the second logic unit 421 includes a second AND gate 511 and a second OR gate 512; the third logic unit 431 includes a third NOT gate 521 and a third AND gate 522; the fourth logic unit 441 includes a fourth NOT gate 531, a fourth AND gate 532, and a fourth OR gate 533; the fifth logic unit 451 includes a fifth AND gate 541 and a fifth OR gate 542; and the sixth logic unit 461 includes a sixth NOT gate 551 and a sixth AND gate 552.

An input end of the first NOT gate 501 receives the second state parameter D0E, an output end of the first NOT gate 501 is connected to one input end of the first AND gate 502, another input end of the first AND gate 502 receives the first state parameter R0E, an output end of the first AND gate 502 and an output end of the sixth AND gate 552 are respectively connected to two input ends of the first OR gate 503, and the first OR gate 503 outputs the first control signal Ctr1. Two input ends of the second OR gate 512 respectively receive the third state parameter D3E and the fourth state parameter R3E, an output end of the second OR gate 512 is connected to one input end of the second AND gate 511, another input end of the second AND gate 511 receives the second state parameter D0E, and the second AND gate 511 outputs the second control signal Ctr2. An input end of the third NOT gate 521 is connected to an output end of the fifth OR gate 542, an output end of the third NOT gate 521 is connected to one input end of the third AND gate 522, another input end of the third AND gate 522 receives the third state parameter D3E, and the third AND gate 522 outputs the third control signal Ctr3.

An input end of the fourth NOT gate 531 receives the third state parameter D3E, an output end of the fourth NOT gate 531 is connected to one input end of the fourth AND gate 532, another input end of the fourth AND gate 532 receives the fourth state parameter R3E, an output end of the fourth AND gate 532 and an output end of the third AND gate 522 are respectively connected to two input ends of the fourth OR gate 533, and the fourth OR gate 533 outputs the fourth control signal Ctr4. Two input ends of the fifth OR gate 542 respectively receive the first state parameter R0E and the second state parameter D0E, an output end of the fifth OR gate 542 is connected to one input end of the fifth AND gate 541, another input end of the fifth AND gate 541 receives the third state parameter D3E, and the fifth AND gate 541 outputs the fifth control signal Ctr5. An input end of the sixth NOT gate 551 is connected to an output end of the second OR gate 512, an output end of the sixth NOT gate 551 is connected to one input end of the sixth AND gate 552, another input end of the sixth AND gate 552 receives the second state parameter D0E, and the sixth AND gate 552 outputs the sixth control signal Ctr6.

The structure of the second select circuit 32 is similar to that of the first select circuit 31, and the operation principle thereof can be understood correspondingly.

In some specific embodiments, as shown in FIG. 10, the i^{th} second select circuit 32 includes an i^{th} third repair unit 321, an i^{th} fourth repair unit 322, and an i^{th} second select output circuit 323.

One side of the i^{th} third repair unit 321 is coupled to the second redundant conductive via R1, the first normal conductive via D0, and the second normal conductive via D1 in the i^{th} conductive via group, and the other side is coupled to an i^{th} second primary node Middle1. The third repair unit 321 is configured to receive the i^{th} second via state parameter group, and electrically connect one of the coupled second normal conductive via D1, second redundant conductive via R1, and third normal conductive via D2 to the i^{th} second primary node Middle1 based on the i^{th} second via state parameter group.

One side of the i^{th} fourth repair unit 322 is coupled to the second normal conductive via D1, a normal conductive via, and the third redundant conductive via R2 in the i^{th} conductive via group, and the other side is coupled to an i^{th} third primary node Middle2. The fourth repair unit 322 is configured to receive the i^{th} second via state parameter group, and electrically connect one of the coupled second normal conductive via D1, third normal conductive via D2, and third redundant conductive via R2 to the i^{th} third primary node Middle2 based on the i^{th} second via state parameter group.

The i^{th} second select output circuit 323 is configured to receive the first select signal Ch0, and based on the first select signal, electrically connect the i^{th} second primary node Middle1 to the i^{th} second secondary node Sec1 and electrically connect the i^{th} third primary node Middle2 to the i^{th} third secondary node Sec2; or electrically connect the i^{th} third primary node Middle2 to the i^{th} second secondary node Sec1 and electrically connect the i^{th} second primary node Middle1 to the i^{th} third secondary node Sec2.

Similarly, the second select output circuit 323 also includes four enabling transmission gates. For the principle, reference can be made to the above description of the first select output circuit 313.

In some embodiments, the i^{th} second via state parameter group includes a fifth state parameter R1E, a sixth state parameter D1E, a seventh state parameter D2E, and an eighth state parameter R2E, which indicates, in a one-to-one corresponding manner, whether the second redundant conductive via R1, the second normal conductive via D1, the third normal conductive via D2, and the third redundant conductive via R2 in the corresponding i^{th} conductive via group have failed. Any one of the state parameters being in the enabled state indicates that a corresponding conductive via has not failed; and any one of the state parameters being in the disabled state indicates that a corresponding conductive via has failed. Referring to FIG. 10, the i^{th} third repair unit 321 includes a seventh switching unit 612, an eighth switching unit 622, a ninth switching unit 632, a seventh logic unit 611, an eighth logic unit 621, and a ninth logic unit 631.

Referring to FIG. 10, the seventh logic unit 611 is configured to output a seventh control signal Ctr7 in the enabled state only when the i^{th} second via state parameter group satisfies a seventh preset condition, where the seventh preset condition is that the fifth state parameter R1E is in the enabled state and the sixth state parameter D1E is in the disabled state, or that the fifth state parameter R1E and the sixth state parameter D1E are both in the enabled state and the seventh state parameter D2E and the eighth state parameter R2E are both in the disabled state. The i^{th} seventh switching unit 612 is configured to control the i^{th} second redundant conductive via R1 to be electrically connected to the i^{th} third primary node Middle2 only when the seventh control signal Ctr7 is in the enabled state.

In this way, R1 replaces D1 in operation (R1 is electrically connected to the second primary node Middle1) in the following two cases: (1) R1 has not failed and D1 has failed; (2) R1 and D1 have not failed and D2 and R2 have both failed, and in this case, the non-failed D1 needs to replace the failed D2 for an electric connection to the corresponding internal port, so R1 also needs to replace D1 in operation.

Referring to FIG. 10, the eighth logic unit 621 is configured to output an eighth control signal Ctr8 in the enabled state only when the i^{th} second via state parameter group satisfies an eighth preset condition, where the eighth preset condition is that the sixth state parameter D1E is in the enabled state, and at least one of the seventh state parameter D2E and the eighth state parameter R2E is in the enabled state. The eighth switching unit 622 is configured to control the i^{th} second normal conductive via D1 to be electrically connected to the i^{th} third primary node Middle2 only when the eighth control signal Ctr8 is in the enabled state.

In this way, D1 operates normally (D1 is electrically connected to the second primary node Middle1) in the following case: (1) D1 is not failed and at least one of D2 and R2 is not failed. Referring to FIG. 10, the ninth logic unit 631 is configured to output a ninth control signal Ctr9 in the enabled state only when the i^{th} second via state parameter group satisfies a ninth preset condition, where the ninth preset condition is that the fifth state parameter R1E and the sixth state parameter D1E are both in the disabled state, and the seventh state parameter D2E is in the enabled state. The ninth switching unit 632 is configured to control the i^{th} third normal conductive via D2 to be electrically connected to the i^{th} third primary node Middle2 only when the ninth control signal Ctr9 is in the enabled state.

In this way, D2 replaces D1 for an electric connection to the corresponding internal port (D2 is electrically connected to the second primary node Middle1) in the following case: (1) D1 and R1 have both failed and D2 has not failed.

In a specific embodiment, referring to FIG. 10, the fourth repair unit 322 includes a tenth switching unit 642, an eleventh switching unit 652, a twelfth switching unit 662, a tenth logic unit 641, an eleventh logic unit 651, and a twelfth logic unit 661.

Referring to FIG. 10, the tenth logic unit 641 is configured to output the tenth control signal Ctr10 in the enabled state only when the i^{th} second via state parameter group satisfies a tenth preset condition, where the tenth preset condition is that the eighth state parameter R2E is in the enabled state and the seventh state parameter D2E is in the disabled state, or that the eighth state parameter R2E and the seventh state parameter D2E are both in the enabled state and the sixth state parameter D1E and the fifth state parameter R1E are both in the disabled state. The tenth switching unit 642 is configured to control the i^{th} third redundant conductive via R2 to be electrically connected to the i^{th} fourth primary node only when the tenth control signal Ctr10 is in the enabled state.

In this way, R2 replaces D2 in operation (R2 is electrically connected to the third primary node Middle2) in the following two cases: (1) R2 has not failed and D2 has failed; (2) R2 and D2 have not failed and D1 and R1 have both failed, and in this case, the non-failed D2 needs to replace the failed D1 for an electric connection to the corresponding internal port, so R2 also needs to replace D2 in operation.

Referring to FIG. 10, the eleventh logic unit 651 is configured to output an eleventh control signal Ctr11 in the enabled state only when the i^{th} second via state parameter group satisfies an eleventh preset condition, where the eleventh preset condition is that the seventh state parameter D2E is in the enabled state, and at least one of the sixth state parameter D1E and the fourth state parameter R3E is in the enabled state. The eleventh switching unit 652 is configured to control the i^{th} third normal conductive via D2 to be electrically connected to the i^{th} fourth primary node only when the eleventh control signal Ctr11 is in the enabled state.

In this way, D2 operates normally (D2 is electrically connected to the third primary node Middle2) in the following case: (1) D2 is not failed and at least one of D1 and R1 is not failed. Referring to FIG. 10, the twelfth logic unit 661 is configured to output a twelfth control signal Ctr12 in the enabled state only when the i^{th} second via state parameter group satisfies a twelfth preset condition, where the twelfth preset condition is that the eighth state parameter R2E and the seventh state parameter D2E are both in the disabled state, and the sixth state parameter D1E is in the enabled state. The twelfth switching unit 662 is configured to control the i^{th} second normal conductive via D1 to be electrically connected to the i^{th} fourth primary node only when the twelfth control signal Ctr12 is in the enabled state.

In this way, D1 replaces D2 for an electric connection to the corresponding internal port (D1 is electrically connected to the third primary node Middle2) in the following case: D1 and R1 have both failed and D2 has not failed.

In a specific embodiment, referring to FIG. 9, when the enabled state is at a high level and the disabled state is at a low level, the seventh logic unit 611 includes a seventh NOT gate 701, a seventh AND gate 702, and a seventh OR gate 703; the eighth logic unit 621 includes an eighth AND gate 711 and an eighth OR gate 712; the ninth logic unit 631 includes a ninth NOT gate 721 and a ninth AND gate 722; the tenth logic unit 641 includes a tenth NOT gate 731, a tenth AND gate 732, and a tenth OR gate 733; the eleventh logic unit 651 includes an eleventh AND gate 741 and an eleventh OR gate 742; and the twelfth logic unit 631 includes a twelfth NOT gate 751 and a twelfth AND gate 752.

An input end of the seventh NOT gate 701 receives the sixth state parameter D1E, an output end of the seventh NOT gate 701 is connected to one input end of the seventh AND gate 702, another input end of the seventh AND gate 702 receives the fifth state parameter R1E, and an output end of the seventh AND gate 702 and an output end of the twelfth AND gate 752 are respectively connected to two input ends of the seventh OR gate 703. Two input ends of the eighth OR gate 712 respectively receive the seventh state parameter D2E and the eighth state parameter R2E, an output end of the eighth OR gate 712 is connected to one input end of the eighth AND gate 711, and another input end of the eighth AND gate 711 receives the sixth state parameter D1E. An input end of the ninth NOT gate 721 is connected to an output end of the eleventh OR gate 742, an output end of the ninth NOT gate 721 is connected to one input end of the ninth AND gate 722, and another input end of the ninth AND gate 722 receives the seventh state parameter D2E. The seventh OR gate 703 outputs the seventh control signal Ctr7, the eighth AND gate 711 outputs the eighth control signal Ctr8, and the ninth AND gate 722 outputs the ninth control signal Ctr9.

An input end of the tenth NOT gate (731) receives the seventh state parameter D2E, an output end of the tenth NOT gate (731) is connected to one input end of the tenth AND gate (732), another input end of the tenth AND gate (732) receives the eighth state parameter R2E, an output end of the tenth AND gate (732) and an output end of the ninth AND gate (722) are respectively connected to two input ends of the tenth OR gate (733), and the tenth OR gate (733) outputs the tenth control signal Ctr10. Two input ends of the eleventh OR gate (742) respectively receive the fifth state parameter R1E and the sixth state parameter D1E, an output end of the eleventh OR gate (742) is connected to one input end of the eleventh AND gate (741), another input end of the eleventh AND gate (741) receives the seventh state parameter D2E, and the eleventh AND gate (741) outputs the eleventh control signal Ctr11. An input end of the twelfth NOT gate (751) is connected to an output end of the eighth OR gate (712), an output end of the twelfth NOT gate (751) is connected to one input end of the twelfth AND gate (752), another input end of the twelfth AND gate (752) receives the sixth state parameter D1E, and the twelfth AND gate (752) outputs the twelfth control signal Ctr12.

It should be further noted that the conductive via mentioned above can at least be embodied as a through silicon via (TSV), specifically a vertical interconnection structure penetrating a silicon wafer/memory chip 10, such as Type 1 in FIG. 1. Of course, the conductive via may also be Type 2 in FIG. 1, which, together with a contact structure, achieves signal transmission. In other embodiments, other electrical connection structures may be used as the conductive vias.

The conductive vias may be prepared via one or more of the following processes: a via-first process, a via-middle process, a via-last process, and a back side via-last process. The via-first process refers to a via process method in which a via structure is manufactured before a device structure, such as a metal oxide semiconductor field effect transistor (MOSFET, or MOS transistor), is manufactured. The via-middle process refers to a via process in which a via structure is formed during the manufacturing process in the process flow, often after a device is formed and before a stack is manufactured. The via-last process refers to a manufacturing process in which vias are formed at the front side of a wafer after a back end of line (BEOL) process is completed. The back side via-last process refers to a manufacturing process in which a via structure is formed at the back side of a wafer after a BEOL process is completed. That is, the via-first process may refer to first manufacturing vias and then manufacturing a circuit; the via-middle process may refer to first manufacturing a circuit and a portion of metal layers, then manufacturing vias, and finally manufacturing the remaining vias; the via-last process and the back side via-last process may refer to first manufacturing a circuit and metal layers and then manufacturing vias.

In summary, the embodiments of the present disclosure provide a memory chip in which four different global signals are transmitted through four different normal conductive vias with high signal transmission efficiency. Meanwhile, every four different normal conductive vias further correspond to 4a redundant conductive vias, and a redundancy repair function can be achieved. The chip stack structure formed by the memory chip and the logic chip (which also has the characteristics) can achieve a signal rotation transmission effect through the direct connection configuration of the conductive vias, resulting in small parasitic resistance and parasitic capacitance.

In another embodiment of the present disclosure, referring to FIG. 11, a schematic structural diagram of a logic chip 70 according to an embodiment of the present disclosure is shown, and it can be specifically understood as a schematic sectional diagram of an active surface. As shown in FIG. 11, the logic chip 70 includes m channel signal regions (FIG. 10 shows an example where m = 4) sequentially arranged along a first direction, and a center of each channel signal region coincides with a center of the corresponding channel.

A center of the active surface of the logic chip 70 and an area adjacent to the center are defined as a global signal region 20, and a center point of the global signal region 20 coincides with a center point of the active surface; the m channel signal regions are arranged symmetrically about the global signal region 20. The global signal region 20 and the channel signal region are both penetrated by a plurality of conductive vias along the third direction, and the third direction is perpendicular to the active surface. For the global signal region 20, each conductive via is used for transmitting a global signal, and the global signal is shared by all regions of the memory chip 10. For the channel signal region, each conductive via is used for transmitting a channel signal, and each channel signal is used only by a corresponding channel.

In particular, the area of the global signal region 20 of the logic chip 70 is the same as the area of the global signal region of the memory chip 10, but the active surface area of the logic chip 70 may be greater than or equal to the active surface area of the memory chip 10.

Referring to FIG. 11, the global signal region 20 includes a first axis AA' and a second axis BB'. The first axis AA' is parallel to a first side of the logic chip 70, and the first axis AA' and the second axis BB' are perpendicular to each other and intersect at the center point of the active surface. In FIG. 11, the first axis AA' extends along the first direction and the second axis BB' extends along the second direction, but this is only an example and not a specific limitation.

The logic chip 70 also has conductive via groups similar to those in the logic chip 70 described above. Details are described below.

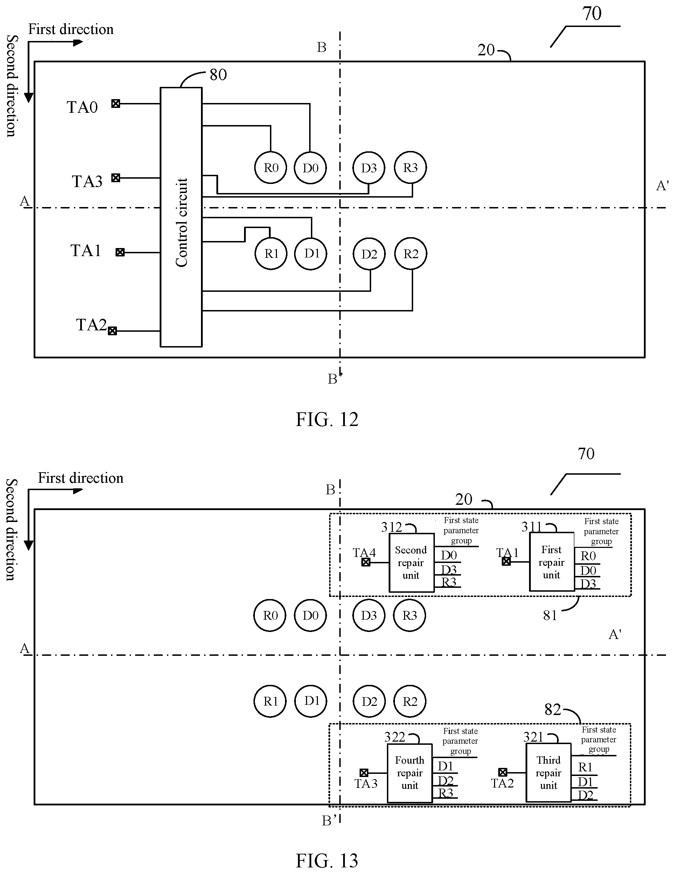

Referring to FIG. 12, the global signal region 20 is penetrated by n conductive via groups along a third direction. Each conductive via group includes four normal conductive vias (D0, D1, D2, and D3), where a first normal conductive via D0 and a second normal conductive via D1 are arranged symmetrically about the first axis AA', a third normal conductive via D2 and a fourth normal conductive via D3 are arranged symmetrically about the first axis AA', and the first normal conductive via D0 and the fourth normal conductive via D3 are arranged symmetrically about the second axis BB'.

Referring to FIG. 12, the logic chip 70 further includes n control circuits 80, and an internal circuit of the logic chip 70 includes n first signal ports TA0, n second signal ports TA1, n third signal ports TA2, and n fourth signal ports TA3.

An i^{th} control circuit 80 is configured to electrically connect the first normal conductive via D0, the second normal conductive via D1, the third normal conductive via D2, and the fourth normal conductive via D3 in an i^{th} conductive via group in one-to-one correspondence to an i^{th} first signal port TA0, an i^{th} second signal port TA1, an i^{th} third signal port TA2, and an i^{th} fourth signal port TA3.

In some embodiments, referring to FIG. 12, each conductive via group further includes 4a redundant conductive vias (FIG. 12 shows an example where a = 1). Additionally, 4a first redundant conductive vias R0 and 4a second redundant conductive vias R1 are arranged symmetrically about the first axis AA', 4a third redundant conductive vias R2 and 4a fourth redundant conductive vias R3 are arranged symmetrically about the first axis AA', and the 4a first redundant conductive vias R0 and the 4a fourth redundant conductive vias R3 are arranged symmetrically about the second axis BB'. The a first redundant conductive via R0, the a second redundant conductive via R1, the first normal conductive via D0, and the second normal conductive via D1 form one repair unit, and the a third redundant conductive via R2, the a fourth redundant conductive via R3, the third normal conductive via D2, and the fourth normal conductive via D3 form another repair unit.

The control circuit 80 is further configured to replace, when any one of the normal conductive vias fails, the failed normal conductive via with another conductive via in a same repair unit for an electric connection to a corresponding signal port.

In a specific embodiment, the control circuit 80 is specifically configured to: replace, if the first normal conductive via D0 fails, the first normal conductive via D0 with the first redundant conductive via R0 or the fourth normal conductive via D3 for an electric connection to the corresponding signal port (that is, to the first signal port TA1); replace, if the fourth normal conductive via D3 fails, the fourth normal conductive via D3 with the fourth redundant conductive via R3 or the first normal conductive via D0 for an electric connection to the corresponding signal port (that is, to the fourth signal port TA3); replace, if the second normal conductive via D1 fails, the second normal conductive via D1 with the second redundant conductive via R1 or the third normal conductive via D2 for an electric connection to the corresponding signal port (that is, to the second signal port TA2); or replace, if the third normal conductive via D2 fails, the third normal conductive via D2 with the third redundant conductive via R2 or the second normal conductive via D1 for an electric connection to the corresponding signal port (that is, to the third signal port TA2).

In a specific embodiment, referring to FIG. 12, the i^{th} control circuit 80 includes an i^{th} first control circuit 81 and an i^{th} second control circuit 82.

One side of the i^{th} first control circuit 81 is coupled to the first normal conductive via D0, the fourth normal conductive via D3, the first redundant conductive via R0, and the fourth redundant conductive via R3 in the i^{th} conductive via group, and the other side is coupled to the i^{th} first signal port TA1 and the i^{th} fourth signal port TA4. The i^{th} first control circuit 81 is configured to receive an i^{th} first via state parameter group, and electrically connect one of the coupled conductive vias to the i^{th} first signal port TA1 as well as electrically connect another one of the coupled conductive vias to the i^{th} fourth signal port TA4 based on the i^{th} first via state parameter group and a select signal.

One side of the i^{th} second control circuit 82 is coupled to the second normal conductive via D1, the third normal conductive via D2, the second redundant conductive via R1, and the third redundant conductive via R2 in the i^{th} conductive via group, and the other side is coupled to the i^{th} second signal port TA2 and the i^{th} third signal port TA3. The i^{th} second control circuit 82 is configured to receive an i^{th} second via state parameter group, and electrically connect one of the coupled conductive vias to the second signal port TA2 as well as electrically connect another one of the coupled conductive vias to the third signal port TA3 based on the i^{th} second via state parameter group and the select signal.

In a specific embodiment, referring to FIG. 13, the i^{th} first control circuit 81 includes an i^{th} first repair circuit 311 and an i^{th} second repair circuit 312.

One side of the i^{th} first repair circuit 311 is coupled to the first redundant conductive via R0, the first normal conductive via D0, and the second normal conductive via D1 in the i^{th} conductive via group, and the other side is coupled to the first signal port TA1. The first repair circuit 311 is configured to receive a first via state parameter group, and electrically connect one of the coupled first normal conductive via D0, first redundant conductive via R0, and fourth normal conductive via D3 to the i^{th} first signal port TA0 based on the first via state parameter group. One side of the i^{th} second repair circuit 312 is coupled to the first normal conductive via D0, a normal conductive via, and the fourth redundant conductive via R3 in the i^{th} conductive via group, and the other side is coupled to the third signal port TA2. The second repair circuit 312 is configured to receive an i^{th} first via state parameter group, and electrically connect one of the first normal conductive via D0, the fourth normal conductive via D3, and the fourth redundant conductive via R3 to the i^{th} third signal port TA2 based on the i^{th} first via state parameter group.

In some embodiments, the i^{th} first via state parameter group includes a first state parameter R0E, a second state parameter D0E, a third state parameter D3E, and a fourth state parameter R3E, which indicates, in a one-to-one corresponding manner, whether the first redundant conductive via R0, the first normal conductive via D0, the fourth normal conductive via D3, and the fourth redundant conductive via R3 in the i^{th} conductive via group have failed. Any one of the state parameters being in the enabled state indicates that a corresponding conductive via has not failed; and any one of the state parameters being in the disabled state indicates that a corresponding conductive via has failed.

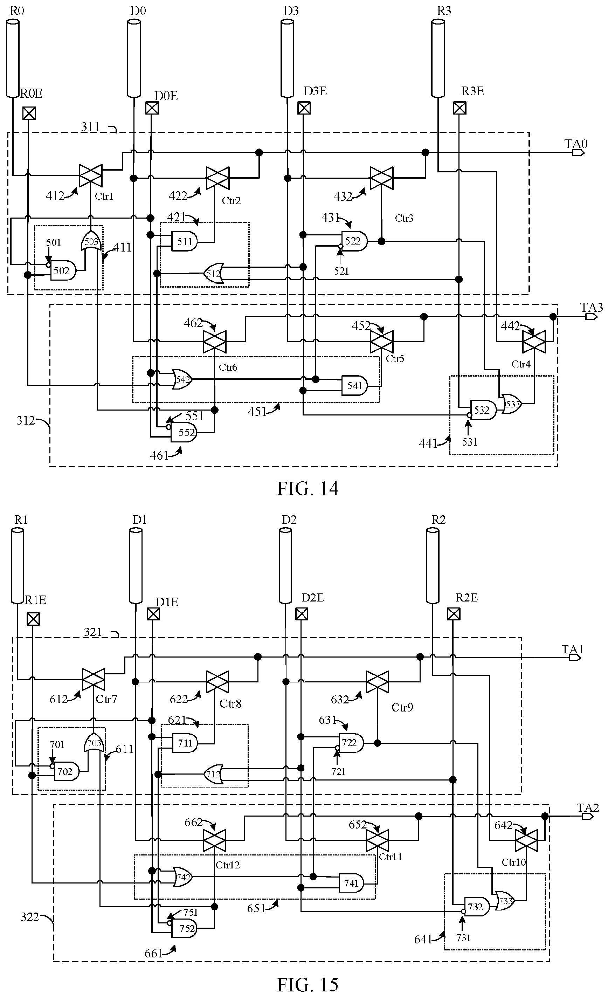

Referring to FIG. 14, the i^{th} first repair circuit 311 includes a first switching unit 412, a second switching unit 422, a third switching unit 432, a first logic unit 411, a second logic unit 421, and a third logic unit 431.

The first logic unit 411 is configured to output a first control signal Ctr1 in the enabled state only when the i^{th} first via state parameter group satisfies a first preset condition, where the first preset condition is that the first state parameter R0E is in the enabled state and the second state parameter D0E is in the disabled state, or that the first state parameter R0E and the second state parameter D0E are both in the enabled state and the third state parameter D3E and the fourth state parameter R3E are both in the disabled state. The first switching unit 412 is configured to control the i^{th} first redundant conductive via R0 to be electrically connected to the i^{th} first signal port TA0 only when the first control signal Ctr1 is in the enabled state.

The second logic unit 421 is configured to output a second control signal Ctr2 in the enabled state only when the i^{th} first via state parameter group satisfies a second preset condition, where the second preset condition is that the second state parameter D0E is in the enabled state, and at least one of the third state parameter D3E and the fourth state parameter R3E is in the enabled state. The second switching unit 422 is configured to control the i^{th} first normal conductive via D0 to be electrically connected to the i^{th} first signal port TA0 only when the second control signal Ctr2 is in the enabled state.

The third logic unit 431 is configured to output a third control signal Ctr3 in the enabled state only when the i^{th} first via state parameter group satisfies a third preset condition, where the third preset condition is that the first state parameter R0E and the second state parameter D0E are both in the disabled state, and the third state parameter D3E is in the enabled state. The third switching unit 432 is configured to control the i^{th} fourth normal conductive via D3 to be electrically connected to the i^{th} first signal port TA0 only when the third control signal Ctr3 is in the enabled state.

In some embodiments, referring to FIG. 14, the i^{th} second repair circuit 312 includes a fourth switching unit 442, a fifth switching unit 452, a sixth switching unit 462, a fourth logic unit 441, a fifth logic unit 451, and a sixth logic unit 461.

The fourth logic unit 441 is configured to output a fourth control signal Ctr4 in the enabled state only when the i^{th} first via state parameter group satisfies a fourth preset condition, where the fourth preset condition is that the fourth state parameter R3E is in the enabled state and the third state parameter D3E is in the disabled state, or that the fourth state parameter R3E and the third state parameter D3E are both in the enabled state and the second state parameter D0E and the first state parameter R0E are both in the disabled state. The fourth switching unit 442 is configured to control the i^{th} fourth redundant conductive via R3 to be electrically connected to the i^{th} fourth signal port TA3 only when the fourth control signal Ctr4 is in the enabled state.

The fifth logic unit 451 is configured to output a fifth control signal Ctr5 in the enabled state only when the i^{th} first via state parameter group satisfies a fifth preset condition, where the fifth preset condition is that the third state parameter D3E is the enabled state, and at least one of the second state parameter D0E and the first state parameter R0E is in the enabled state. The fifth switching unit 452 is configured to control the i^{th} fourth normal conductive via D3 to be electrically connected to the i^{th} fourth signal port TA3 only when the fifth control signal Ctr5 is in the enabled state.

The sixth switching unit 462 is configured to output a sixth control signal Ctr6 in the enabled state only when the i^{th} first via state parameter group satisfies a sixth preset condition, where the sixth preset condition is that the fourth state parameter R3E and the third state parameter D3E are both in the disabled state, and the second state parameter D0E is in the enabled state. The sixth switching unit 462 is configured to control the i^{th} first normal conductive via D0 to be electrically connected to the i^{th} fourth signal port TA3 only when the sixth control signal Ctr6 is in the enabled state.

In some embodiments, referring to FIG. 14, when the enabled state is at a high level and the disabled state is at a low level, the first logic unit 411 includes a first NOT gate 501, a first AND gate 502, and a first OR gate 503; the second logic unit 421 includes a second AND gate 511 and a second OR gate 512; the third logic unit 431 includes a third NOT gate 521 and a third AND gate 522; the fourth logic unit 441 includes a fourth NOT gate 531, a fourth AND gate 532, and a fourth OR gate 533; the fifth logic unit 451 includes a fifth AND gate 541 and a fifth OR gate 542; and the sixth logic unit 431 includes a sixth NOT gate 551 and a sixth AND gate 552.

An input end of the first NOT gate 501 receives the second state parameter D0E, an output end of the first NOT gate 501 is connected to one input end of the first AND gate 502, another input end of the first AND gate 502 receives the first state parameter R0E, and an output end of the first AND gate 502 and an output end of the sixth AND gate 552 are respectively connected to two input ends of the first OR gate 503. Two input ends of the second OR gate 512 respectively receive the third state parameter D3E and the fourth state parameter R3E, an output end of the second OR gate 512 is connected to one input end of the second AND gate 511, and another input end of the second AND gate 511 receives the second state parameter. An input end of the third NOT gate 521 is connected to an output end of the fifth OR gate 542, an output end of the third NOT gate 521 is connected to one input end of the third AND gate 522, and another input end of the third AND gate 522 receives the third state parameter D0E D3E. The first OR gate 503 outputs the first control signal Ctr1, the second AND gate 511 outputs the second control signal Ctr2, and the third AND gate 522 outputs the third control signal Crt3.

An input end of the fourth NOT gate 531 receives the third state parameter D3E, an output end of the fourth NOT gate 531 is connected to one input end of the fourth AND gate 532, another input end of the fourth AND gate 532 receives the fourth state parameter R3E, and an output end of the fourth AND gate 532 and an output end of the third AND gate 522 are respectively connected to two input ends of the fourth OR gate 533. Two input ends of the fifth OR gate 542 respectively receive the first state parameter R0E and the second state parameter D0E, an output end of the fifth OR gate 542 is connected to one input end of the fifth AND gate 541, and another input end of the fifth AND gate 541 receives the third state parameter D3E. An input end of the sixth NOT gate 551 is connected to an output end of the second OR gate 512, an output end of the sixth NOT gate 551 is connected to one input end of the sixth AND gate 552, and another input end of the sixth AND gate 552 receives the second state parameter D0E. The fourth OR gate 533 outputs the fourth control signal Ctr4, the fifth AND gate 541 outputs the fifth control signal Ctr5, and the sixth AND gate 552 outputs the sixth control signal Crt6.

In some embodiments, referring to FIG. 15, the i^{th} second select circuit 32 includes a third repair unit 321 and a fourth repair unit 322.

One side of the third repair unit 321 is coupled to the second redundant conductive via R1, the second normal conductive via D1, and the third normal conductive via D2 in the i^{th} conductive via group, and the other side is coupled to the second signal port TA1. The third repair unit 321 is configured to receive a second via state parameter group, and electrically connect one of the coupled second normal conductive via D1, second redundant conductive via R1, and third normal conductive via D2 to the i^{th} second signal port TA1 based on the second via state parameter group.

One side of the fourth repair unit 322 is coupled to the second normal conductive via D1, the third normal conductive via D2, and the fourth redundant conductive via R3 in the i^{th} conductive via group, and the other side is coupled to a fourth signal port TA2. The fourth repair unit 322 is configured to receive a second via state parameter group, and electrically connect one of the second normal conductive via D1, the third normal conductive via D2, and the third redundant conductive via R2 to the i^{th} third signal port TA2 based on the second via state parameter group.

In some embodiments, the i^{th} second via state parameter group includes four state parameters, and a fifth state parameter R1E, a sixth state parameter **D1E,** a seventh state parameter D2E, and an eighth state parameter R2E indicate, in a one-to-one corresponding manner, whether the second redundant conductive via R1, the second normal conductive via D1, the third normal conductive via D2, and the third redundant conductive via R2 in the i^{th} conductive via group have failed. Any one of the state parameters being in the enabled state indicates that a corresponding conductive via has not failed; and any one of the state parameters being in the disabled state indicates that a corresponding conductive via has failed.

Referring to FIG. 15, the i^{th} third repair unit 321 includes a seventh switching unit 612, an eighth switching unit 622, a ninth switching unit 632, a seventh logic unit 611, an eighth logic unit 621, and a ninth logic unit 631.

The seventh logic unit 611 is configured to output a seventh control signal Ctr7 in the enabled state only when the i^{th} second via state parameter group satisfies a seventh preset condition, where the seventh preset condition is that the fifth state parameter R1E is in the enabled state and the sixth state parameter D1E is in the disabled state, or that the fifth state parameter R1E and the sixth state parameter D1E are both in the enabled state and the seventh state parameter D2E and the eighth state parameter R2E are both in the disabled state. The seventh switching unit 612 is configured to control the i^{th} second redundant conductive via R1 to be electrically connected to the i^{th} second signal port TA1 only when the seventh control signal Ctr7 is in the enabled state.

The eighth logic unit 621 is configured to output an eighth control signal Ctr8 in the enabled state only when the i^{th} second via state parameter group satisfies an eighth preset condition, where the eighth preset condition is that the sixth state parameter D1E is in the enabled state, and at least one of the seventh state parameter D2E and the eighth state parameter R2E is in the enabled state. The eighth switching unit 622 is configured to control the i^{th} second normal conductive via D1 to be electrically connected to the i^{th} second signal port TA1 only when the eighth control signal Ctr8 is in the enabled state.

The ninth logic unit 631 is configured to output a ninth control signal Ctr9 in the enabled state only when the i^{th} second via state parameter group satisfies a ninth preset condition, where the ninth preset condition is that the fifth state parameter R1E and the sixth state parameter D1E are both in the disabled state, and the seventh state parameter D2E is in the enabled state. The ninth switching unit 632 is configured to control the third normal conductive via D2 to be electrically connected to the second signal port TA1 only when the ninth control signal Ctr9 is in the enabled state.

In some embodiments, referring to FIG. 15, the fourth repair unit 322 includes a tenth switching unit 642, an eleventh switching unit 652, a twelfth switching unit 662, a tenth logic unit 641, an eleventh logic unit 651, and a twelfth logic unit 661.

The tenth logic unit 641 is configured to output the tenth control signal Ctr10 in the enabled state only when the i^{th} second via state parameter group satisfies a tenth preset condition, where the tenth preset condition is that the eighth state parameter R2E is in the enabled state and the seventh state parameter D2E is in the disabled state, or that the eighth state parameter R2E and the seventh state parameter D2E are both in the enabled state and the sixth state parameter D1E and the fifth state parameter R1E are both in the disabled state. The tenth switching unit 642 is configured to control the i^{th} third redundant conductive via R2 to be electrically connected to the i^{th} third signal port TA2 only when the tenth control signal Ctr10 is in the enabled state.

The eleventh logic unit 651 is configured to output an eleventh control signal Ctr11 in the enabled state only when the i^{th} second via state parameter group satisfies an eleventh preset condition, where the eleventh preset condition is that the seventh state parameter D2E is in the enabled state, and at least one of the fifth state parameter R1E and the sixth state parameter D1E is in the enabled state. The eleventh switching unit 652 is configured to control the i^{th} third normal conductive via D2 to be electrically connected to the i^{th} third signal port TA2 only when the eleventh control signal Ctr11 is in the enabled state.

The twelfth logic unit 661 is configured to output a twelfth control signal Ctr12 in the enabled state only when the i^{th} second via state parameter group satisfies a twelfth preset condition, where the twelfth preset condition is that the eighth state parameter R2E and the seventh state parameter D2E are both in the disabled state, and the sixth state parameter D1E is in the enabled state. The twelfth switching unit 662 is configured to control the i^{th} second normal conductive via D1 to be electrically connected to the i^{th} third signal port TA2 only when the twelfth control signal Ctr12 is in the enabled state.

In a specific embodiment, when the enabled state is at a high level and the disabled state is at a low level, the seventh logic unit 611 includes a seventh NOT gate 701, a seventh AND gate 702, and a seventh OR gate 703; the eighth logic unit 621 includes an eighth AND gate 711 and an eighth OR gate 712; the ninth logic unit 631 includes a ninth NOT gate 721 and a ninth AND gate 722; the tenth logic unit 641 includes a tenth NOT gate 731, a tenth AND gate 732, and a tenth OR gate 733; the eleventh logic unit 651 includes an eleventh AND gate 741 and an eleventh OR gate 742; and the twelfth logic unit 631 includes a twelfth NOT gate 751 and a twelfth AND gate 752.

An input end of the seventh NOT gate 701 receives the sixth state parameter D1E, an output end of the seventh NOT gate 701 is connected to one input end of the seventh AND gate 702, another input end of the seventh AND gate 702 receives the fifth state parameter R1E, and an output end of the seventh AND gate 702 and an output end of the twelfth AND gate 752 are respectively connected to two input ends of the seventh OR gate 703. Two input ends of the eighth OR gate 712 respectively receive the seventh state parameter D2E and the eighth state parameter R2E, an output end of the eighth OR gate 712 is connected to one input end of the eighth AND gate 711, and another input end of the eighth AND gate 711 receives the sixth state parameter D1E. An input end of the ninth NOT gate 721 is connected to an output end of the eleventh OR gate 742, an output end of the ninth NOT gate 721 is connected to one input end of the ninth AND gate 722, and another input end of the ninth AND gate 722 receives the seventh state parameter D2E. The seventh OR gate 703 outputs the seventh control signal Ctr7, the eighth AND gate 711 outputs the eighth control signal Ctr8, and the ninth AND gate 722 outputs the ninth control signal Ctr9.

An input end of the tenth NOT gate (731) receives the seventh state parameter D2E, an output end of the tenth NOT gate (731) is connected to one input end of the tenth AND gate (732), another input end of the tenth AND gate (732) receives the eighth state parameter R2E, an output end of the tenth AND gate (732) and an output end of the ninth AND gate (722) are respectively connected to two input ends of the tenth OR gate (733), and the tenth OR gate (733) outputs the tenth control signal Ctr10. Two input ends of the eleventh OR gate (742) respectively receive the fifth state parameter R1E and the sixth state parameter D1E, an output end of the eleventh OR gate (742) is connected to one input end of the eleventh AND gate (741), another input end of the eleventh AND gate (741) receives the seventh state parameter D2E, and the eleventh AND gate (741) outputs the eleventh control signal Ctr11. An input end of the twelfth NOT gate (751) is connected to an output end of the eighth OR gate (712), an output end of the twelfth NOT gate (751) is connected to one input end of the twelfth AND gate (752), another input end of the twelfth AND gate (752) receives the sixth state parameter D1E, and the twelfth AND gate (752) outputs the twelfth control signal Ctr12.

The embodiments of the present disclosure provide a logic chip 70 in which four different global signals are transmitted through four different normal conductive vias with high signal transmission efficiency. Meanwhile, every four different normal conductive vias further correspond to 4a redundant conductive vias, and a redundancy repair function can be achieved. The chip stack structure formed by the memory chip and the logic chip (which also has the characteristics) can achieve a signal rotation transmission effect through the direct connection configuration of the conductive vias, resulting in small parasitic resistance and parasitic capacitance.

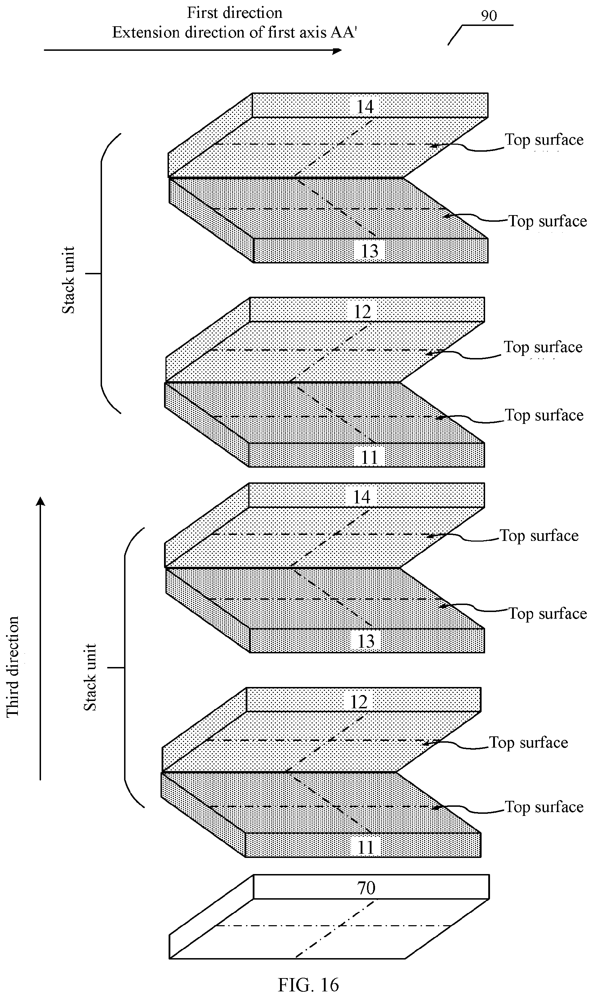

In yet another embodiment of the present disclosure, referring to FIG. 16, a schematic diagram of a composition structure of a chip stack structure 90 according to an embodiment of the present disclosure is shown. As shown in FIG. 16, the chip stack structure 90 includes the aforementioned logic chip 70 and at least one stack unit, and the logic chip 70 and the at least one stack unit are sequentially stacked along the third direction. Each stack unit includes a first memory chip 11, a second memory chip 12, a third memory chip 13, and a fourth memory chip 14 stacked along the third direction; the logic chip 70, and the first memory chip 11, the second memory chip 12, the third memory chip 13, and the fourth memory chip 14 are each the aforementioned memory chip 10.

For each stack unit, the first memory chip 11 and the second memory chip 12 are stacked in a face-to-face manner, the second memory chip 12 and the third memory chip 13 are stacked in a back-to-back manner, and the third memory chip 13 and the fourth memory chip 14 are stacked in a face-to-face manner; the first memory chip 11 in the first stack unit and the logic chip 70 are stacked in a back-to-face manner, or the first memory chip 11 in the first stack unit and the logic chip 70 are stacked in a back-to-back manner.

In the embodiment of the present disclosure, face-to-face stacking means that the top surfaces of two chips are approximately aligned with each other along the third direction; back-to-back stacking means that the top surfaces of two chips are approximately aligned with each other along the third direction; face-to-back stacking means that the top surface of one chip is approximately aligned with the bottom surface of another chip along the third direction. The "chip" may refer to a logic chip or a memory chip in the case that whether it is a logic chip or a memory chip is not specified. In the chip stack structure 90, the center points as well as the first axes AA' and the second axes BB' of top surfaces of all chips are all aligned along the third direction.

It should be noted that in one possibility, for two chips connected in a face-to-face manner, (positions where the conductive vias are aligned along the third direction in) bonding surfaces of the two chips are electrically connected through a hybrid bonding structure (also referred to as a bonding post); for two chips connected in a back-to-back manner or in a back-to-face manner, (positions where the conductive vias are aligned along the third direction in) bonding surfaces of the two chips are electrically connected through conductive bumps (UBumps, also referred to as microbumps).

In another possibility, for two chips connected in a face-to-face manner or for two chips connected in a back-to-back manner or for two chips connected in a back-to-face manner, (positions where the conductive vias are aligned along the third direction in) bonding surfaces of the two chips are connected through a hybrid bonding structure.

In yet another possibility, for two chips connected in a face-to-face manner or for two chips connected in a back-to-back manner or for two chips connected in a back-to-face manner, (positions where the conductive vias are aligned along the third direction in) bonding surfaces of the two chips are connected through conductive bumps.

Here, the above chip may refer to the logic chip 70 or the memory chip 10.

It should be noted that compared to the conductive bumping process, the face-to-face connection using the hybrid bonding process enables adjacent memory chips to fit more closely with almost no gaps, thereby greatly reducing the height of the chip stack structure, which is one of the advantages of the face-to-face stacking. Of course, two memory chips connected in a back-to-back manner may also be connected through a hybrid bonding structure, but the connection performance is not as good as that achieved by the conductive bumping process. In this way, in the embodiment of the present disclosure, the chip stack structure 90 supports face-to-face stacking and achieves a better performance.

As described above, the logic chip 70 or each memory chip may be divided into a upper transmission region and a lower transmission region, and the arrows on each chip in the following drawings are all located in upper transmission regions of the chips. In particular, the upper transmission region and the lower transmission region in the embodiment of the present disclosure only distinguish two regions of the memory chip, but do not impose any additional limitation and do not have any relationship with high-bit data and low-bit data that are often mentioned in a data transmission process.

In the case where the logic chip 30 and the first memory chip 11 are stacked back-to-back and the logic chip 30 and the fourth memory chip 14 are arranged in the same manner, the first specific embodiment and the second specific embodiment are provided. In the case where the logic chip 30 and the first memory chip 11 are stacked back-to-back and the logic chip 30 and the second memory chip 12 are arranged in the same manner, the third specific embodiment and the fourth specific embodiment are provided. Details are described below.

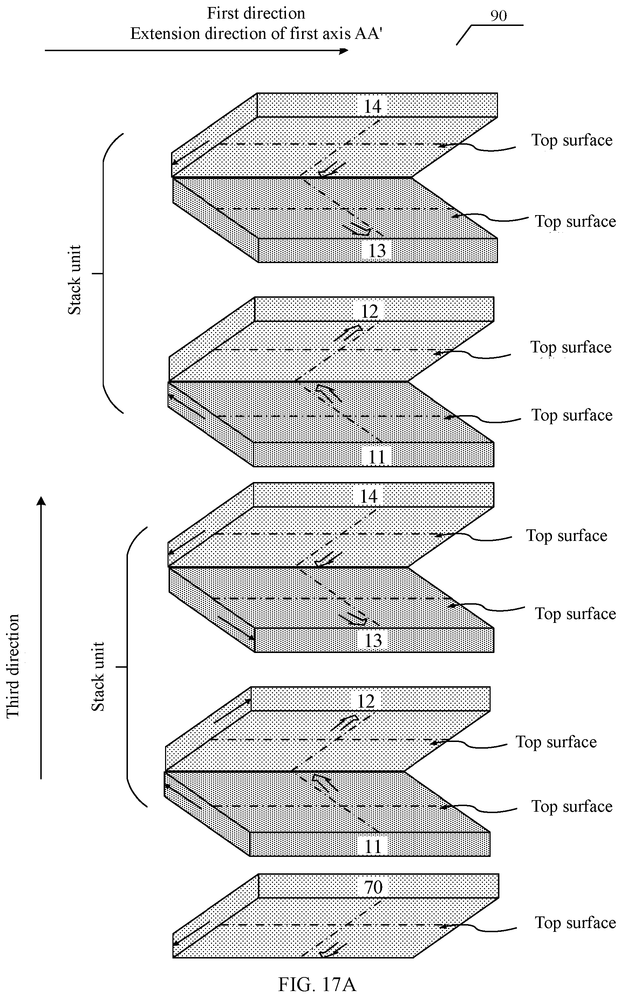

In the first specific embodiment, as shown in FIG. 17A, assuming that the logic chip 70 and each memory chip have their respective first axes AA' that divide each chip into a upper transmission region and a lower transmission region (that is, the first axis AA' extends along the first direction), the upper transmission region of the logic chip 70, the upper transmission region of the first memory chip 11, the lower transmission region of the second memory chip 12, the lower transmission region of the third memory chip 13, and the upper transmission region of the fourth memory chip 14 are aligned along the third direction; and the lower transmission region of the logic chip 70, the lower transmission region of the first memory chip 11, the upper transmission region of the second memory chip 12, the upper transmission region of the third memory chip 13, and the lower transmission region of the fourth memory chip 14 are aligned along the third direction.

In this case, according to the classification rule described above: Top surfaces of the memory chips at a first-type position and a third-type position face upward along the third direction, and top surfaces of the memory chips at a second-type position and a fourth-type position face downward along the third direction; the active surface of each memory chip is divided into a lower transmission region and a upper transmission region, and the lower transmission region in the memory chip at the first-type position, the upper transmission region in the memory chip at the second-type position, the upper transmission region in the memory chip at the third-type position, and the lower transmission region in the memory chip at the fourth-type position are aligned along the third direction.

In this case, the first memory chip 11 is at the first-type position, the second memory chip 12 is at the second-type position, the third memory chip 13 is at the third-type position, and the fourth memory chip 14 is at the fourth-type position.

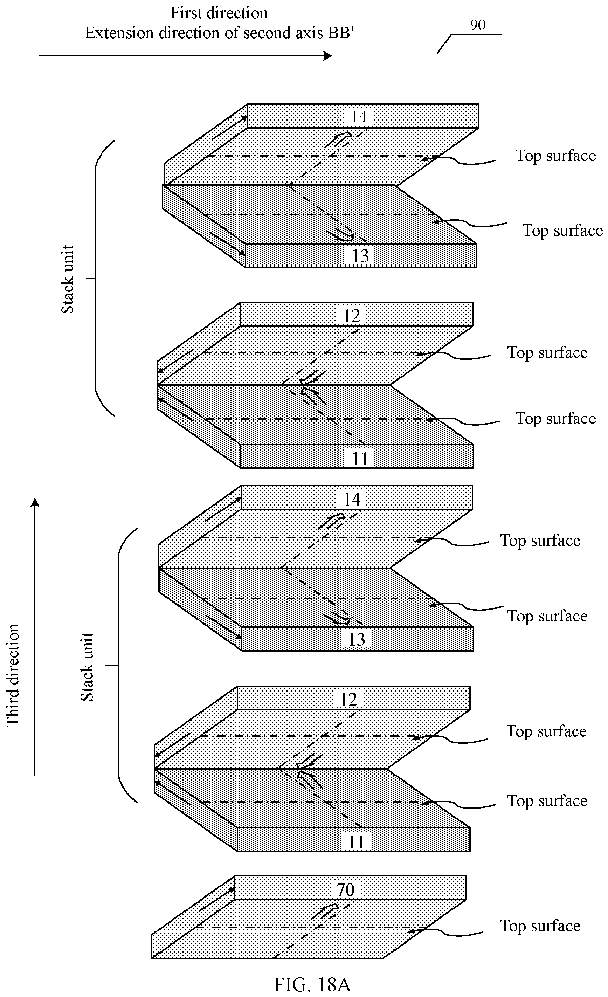

In the second specific embodiment, as shown in FIG. 18A, assuming that the logic chip 70 and each memory chip have their respective second axes BB' that divide each chip into a upper transmission region and a lower transmission region (that is, the second axis BB' extends along the first direction), the upper transmission region of the logic chip 70, the lower transmission region of the first memory chip 11, the lower transmission region of the second memory chip 12, the upper transmission region of the third memory chip 13, and the upper transmission region of the fourth memory chip 14 are aligned along the third direction; and the lower transmission region of the logic chip 70, the upper transmission region of the first memory chip 11, the upper transmission region of the second memory chip 12, the lower transmission region of the third memory chip 13, and the lower transmission region of the fourth memory chip 14 are aligned along the third direction.

Similarly, the first memory chip 11 is at the first-type position, the second memory chip 12 is at the second-type position, the third memory chip 13 is at the third-type position, and the fourth memory chip 14 is at the fourth-type position.

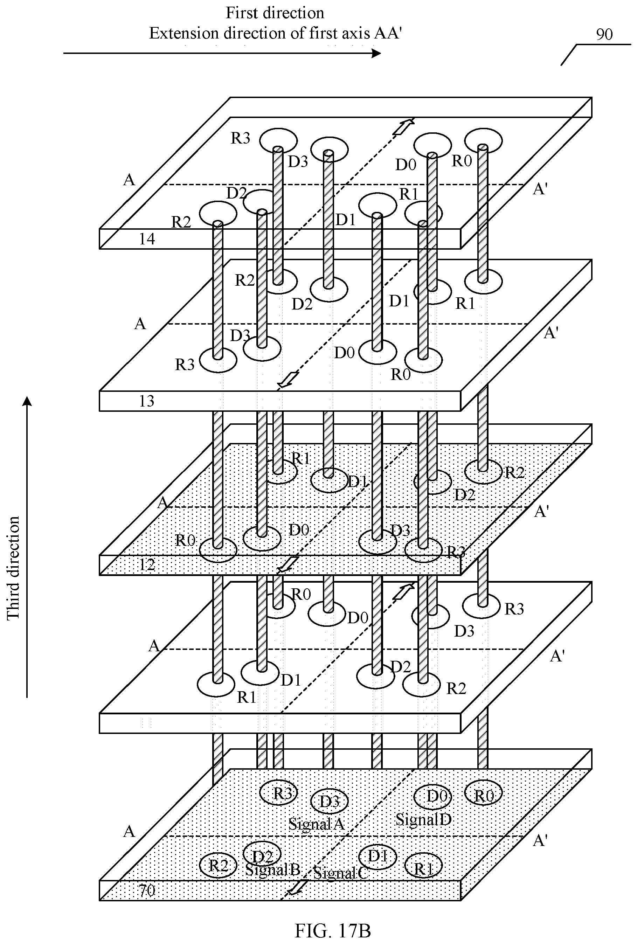

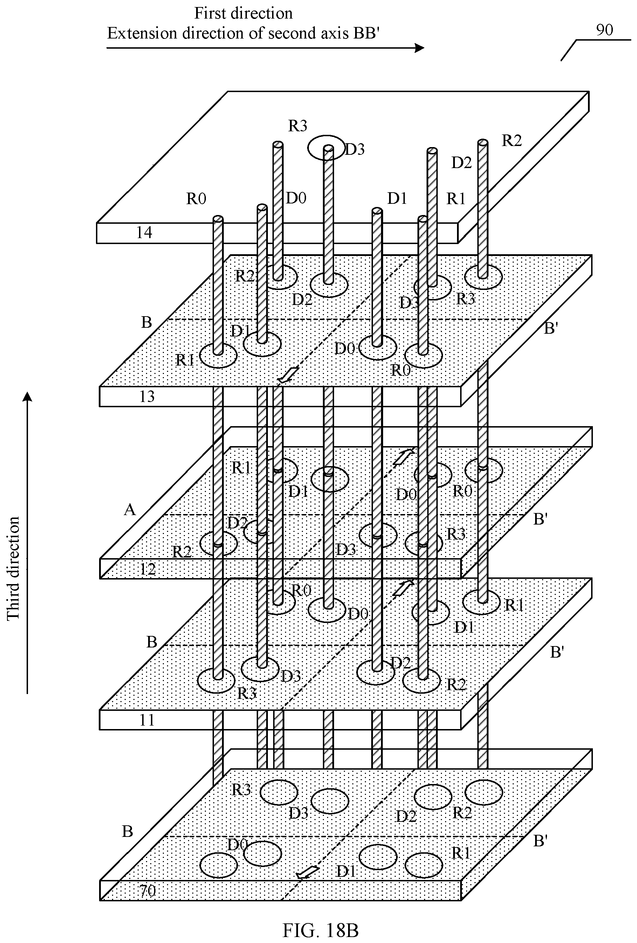

Referring to FIG. 17B or 18B, for the first and second specific embodiments, each via has the following alignment relationship:
The fourth normal conductive via D3 in the i^{th} conductive via group of the logic chip 70, the first normal conductive via D0 in the i^{th} conductive via group of each first memory chip 11, the second normal conductive via D1 in the i^{th} conductive via group of each second memory chip 12, the third normal conductive via D2 in the i^{th} conductive via group of each third memory chip 13, and the fourth normal conductive via D3 in the i^{th} conductive via group of each fourth memory chip 14 are aligned along the third direction and form a normal signal transmission channel, assumed for transmitting SignalA.

The third normal conductive via D2 in the i^{th} conductive via group of the logic chip 70, the second normal conductive via D1 in the i^{th} conductive via group of each first memory chip 11, the first normal conductive via D0 in the i^{th} conductive via group of each second memory chip 12, the fourth normal conductive via D3 in the i^{th} conductive via group of each third memory chip 13, and the third normal conductive via D2 in the i^{th} conductive via group of each fourth memory chip 14 are aligned along the third direction and form a normal signal transmission channel, assumed for transmitting SignalB.

The second normal conductive via D1 in the i^{th} conductive via group of the logic chip 70, the third normal conductive via D2 in the i^{th} conductive via group of each first memory chip 11, the fourth normal conductive via D3 in the i^{th} conductive via group of each second memory chip 12, the first normal conductive via D0 in the i^{th} conductive via group of each third memory chip 13, and the second normal conductive via D1 in the i^{th} conductive via group of each fourth memory chip 14 are aligned along the third direction and form a normal signal transmission channel, assumed for transmitting SignalC.

The first normal conductive via D0 in the i^{th} conductive via group of the logic chip 70, the fourth normal conductive via D3 in the i^{th} conductive via group of each first memory chip 11, the third normal conductive via D2 in the i^{th} conductive via group of each second memory chip 12, the second normal conductive via D1 in the i^{th} conductive via group of each third memory chip 13, and the first normal conductive via D0 in the i^{th} conductive via group of each fourth memory chip 14 are aligned along the third direction and form a normal signal transmission channel, assumed for transmitting SignalD.

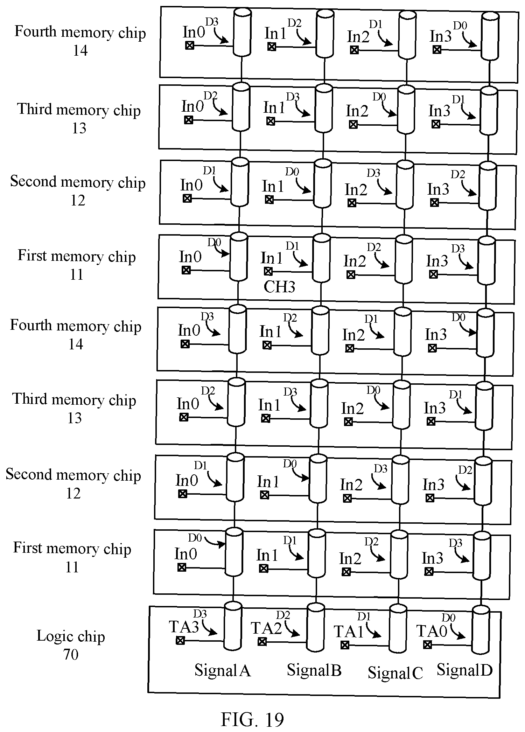

For the chip stack structure in FIG. 17A/17B, refer to FIG. 19 for the signal transmission diagram of the chip stack structure. In the chip stack structure of FIG. 18A/18B, the only difference lies in the connection relationship between the internal ports and the conductive vias of the logic chip 70. That is, whether it is FIG. 17A/17B or FIG. 18A/18B, the correspondence relationship between the four internal ports of each chip and the conductive vias, as well as the specific signals, can be found in the following Table 3. Although the first memory chip 11 to the fourth memory chip 14 are arranged in different manners, the first internal port In0 of each chip receives the same signal SignalA, the second internal port In1 of each chip receives the same signal SignalB, the third internal port In2 of each chip receives the same signal SignalC, and the fourth internal port In3 of each chip receives the same signal SignalD. In particular, in FIG. 19, the internal port/signal port is coupled rather than directly electrically connected to the corresponding conductive via. For example, the first internal port In0 of the first memory chip 11 is coupled to the first conductive via D0, and the others are similar.

**Table 3**

| Memory chip | | | | | Logic chip 70 | |
|---|---|---|---|---|---|---|
| | First memory chip 11 | Second memory chip 12 | Third memory chip 13 | Fourth memory chip 14 | | |
| Select signal | 00 | 10 | 11 | 01 | - | |
| First internal port In0 | D0 (SignalA) | D1 (SignalA) | D2 (SignalA) | D3 (SignalA) | First signal port TA0 | D0 (SignalA) |
| Second internal port In1 | D1 (SignalB) | D0 (SignalB) | D3 (SignalB) | D2 (SignalB) | Second signal port TA1 | D1 (SignalB) |
| Third internal port In2 | D2 (SignalC) | D3 (SignalC) | D0 (SignalC) | D1 (SignalC) | Third signal port TA2 | D2 (SignalC) |
| Fourth internal port In3 | D3 (SignalD) | D2 (SignalD) | D1 (SignalD) | D0 (SignalD) | Fourth signal port TA3 | D3 (SignalD) |

Referring to FIG. 17B or 18B, the fourth redundant conductive via R3 in the i^{th} conductive via group of the logic chip 70, the first redundant conductive via R0 in the i^{th} conductive via group of each first memory chip 11, the second redundant conductive via R1 in the i^{th} conductive via group of each second memory chip 12, the third redundant conductive via R2 in the i^{th} conductive via group of each third memory chip 13, and the fourth redundant conductive via R3 in the i^{th} conductive via group of each fourth memory chip 14 are aligned along the third direction and form a redundant signal transmission channel.

The third redundant conductive via R2 in the i^{th} conductive via group of the logic chip 70, the second redundant conductive via R1 in the i^{th} conductive via group of each first memory chip 11, the first redundant conductive via R0 in the i^{th} conductive via group of each second memory chip 12, the fourth redundant conductive via R3 in the i^{th} conductive via group of each third memory chip 13, and the third redundant conductive via R2 in the i^{th} conductive via group of each fourth memory chip 14 are aligned along the third direction and form a redundant signal transmission channel.

The second redundant conductive via R1 in the i^{th} conductive via group of the logic chip 70, the third redundant conductive via R2 of in i^{th} conductive via group of each first memory chip 11, the fourth redundant conductive via R3 of in i^{th} conductive via group of each second memory chip 12, the first redundant conductive via R0 in the i^{th} conductive via group of each third memory chip 13, and the second redundant conductive via R1 in the i^{th} conductive via group of each fourth memory chip 14 are aligned along the third direction and form a redundant signal transmission channel.

The first redundant conductive via R0 in the i^{th} conductive via group of the logic chip 70, the fourth redundant conductive via R3 in the i^{th} conductive via group of each first memory chip 11, the third redundant conductive via R2 in the i^{th} conductive via group of each second memory chip 12, the second redundant conductive via R1 in the i^{th} conductive via group of each third memory chip 13, and the first redundant conductive via R0 in the i^{th} conductive via group of each fourth memory chip 14 are aligned along the third direction and form a redundant signal transmission channel.

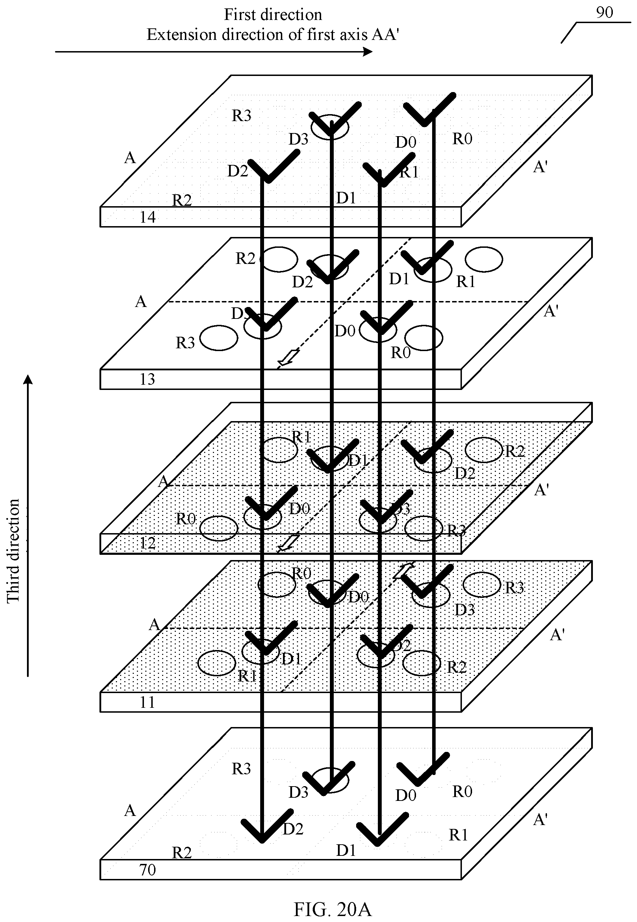

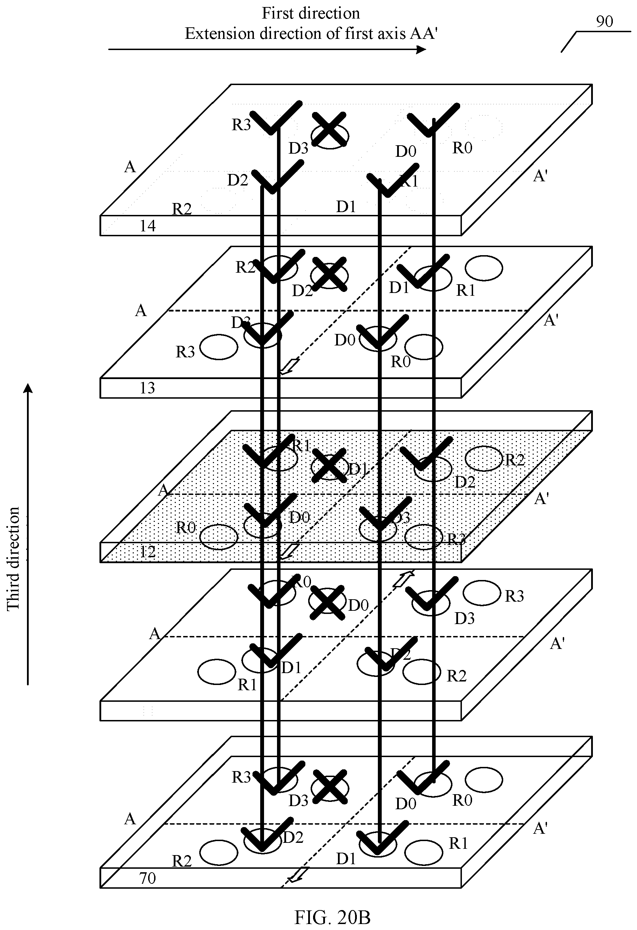

It should be noted that when a normal signal transmission channel of each chip fails, a redundant signal transmission channel will be enabled to replace the normal signal transmission channel to work. The chip stack structure according to FIG. 17A/17B is merely used as an example. Referring to FIGS. 20A and 20B, assuming that the normal signal transmission channel (originally used for transmitting SignalA) formed by D3 in the logic chip 70, D0 in the first memory chip 11, D1 in the second memory chip 12, D2 in the third memory chip 13, and to D3 in the fourth memory chip 14 fails (for example, any conductive via therein or junction is damaged), then R3 in the logic chip 70 replaces D3, R0 in the first memory chip 12 replaces D0, R1 in the second memory chip 11 replaces D1, R2 in the third memory chip 13 replaces D2, R3 in the fourth memory chip 14 replaces D3. In that case, the redundant signal transmission channel formed by R3 in the logic chip 70, R0 in the first memory chip 12, R1 in the second memory chip 11, R2 in the third memory chip 13, and R3 in the fourth memory chip 14 is used for transmitting SignalA. The rest is correspondingly understood in conjunction with the operation principle of the select circuit 30 in the memory chip/the control circuit 80 in the logic chip.

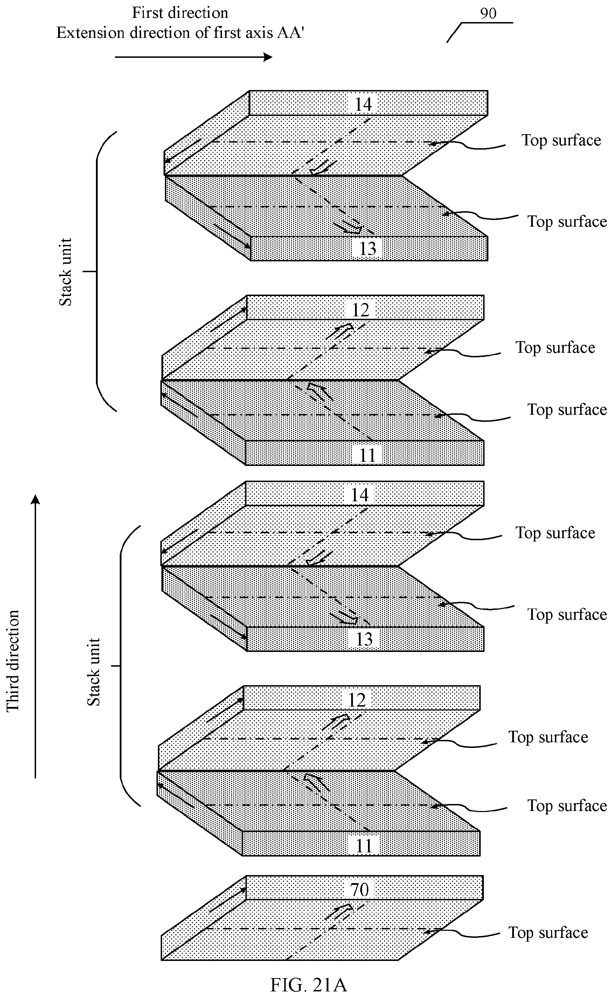

In the third specific embodiment, as shown in FIG. 21A, assuming that the logic chip 70 and each memory chip have their respective first axes AA' that divide each chip into a upper transmission region and a lower transmission region (that is, the first axis AA' extends along the first direction), the lower transmission region of the logic chip 70, the upper transmission region of the first memory chip 11, the lower transmission region of the second memory chip 12, the lower transmission region of the third memory chip 13, and the upper transmission region of the fourth memory chip 14 are aligned along the third direction; and the upper transmission region of the logic chip 70, the lower transmission region of the first memory chip 11, the upper transmission region of the second memory chip 12, the upper transmission region of the third memory chip 13, and the lower transmission region of the fourth memory chip 14 are aligned along the third direction. In this case, the first memory chip 11 is at the first-type position, the second memory chip 12 is at the fourth-type position, the third memory chip 13 is at the third-type position, and the fourth memory chip 14 is at the second-type position.

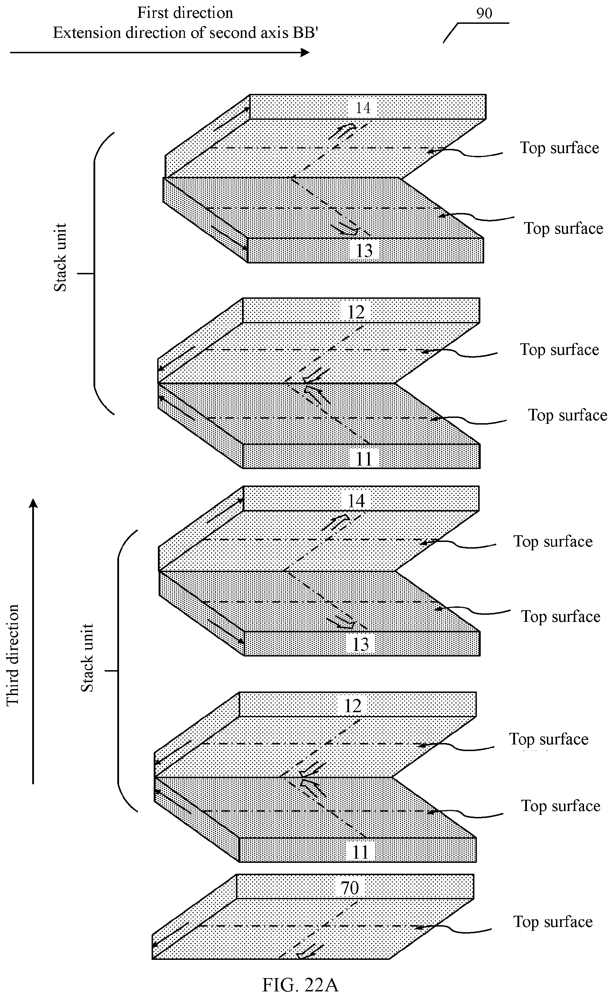

In the fourth specific embodiment, as shown in FIG. 22A, assuming that the logic chip 70 and each memory chip have their respective second axes BB' that divide each chip into a upper transmission region and a lower transmission region (that is, the second axis BB' extends along the first direction), the lower transmission region of the logic chip 70, the lower transmission region of the first memory chip 11, the lower transmission region of the second memory chip 12, the upper transmission region of the third memory chip 13, and the upper transmission region of the fourth memory chip 14 are aligned along the third direction; and the upper transmission region of the logic chip 70, the upper transmission region of the first memory chip 11, the upper transmission region of the second memory chip 12, the lower transmission region of the third memory chip 13, and the lower transmission region of the fourth memory chip 14 are aligned along the third direction. In this case, the first memory chip 11 is at the first-type position, the second memory chip 12 is at the fourth-type position, the third memory chip 13 is at the third-type position, and the fourth memory chip 14 is at the second-type position.

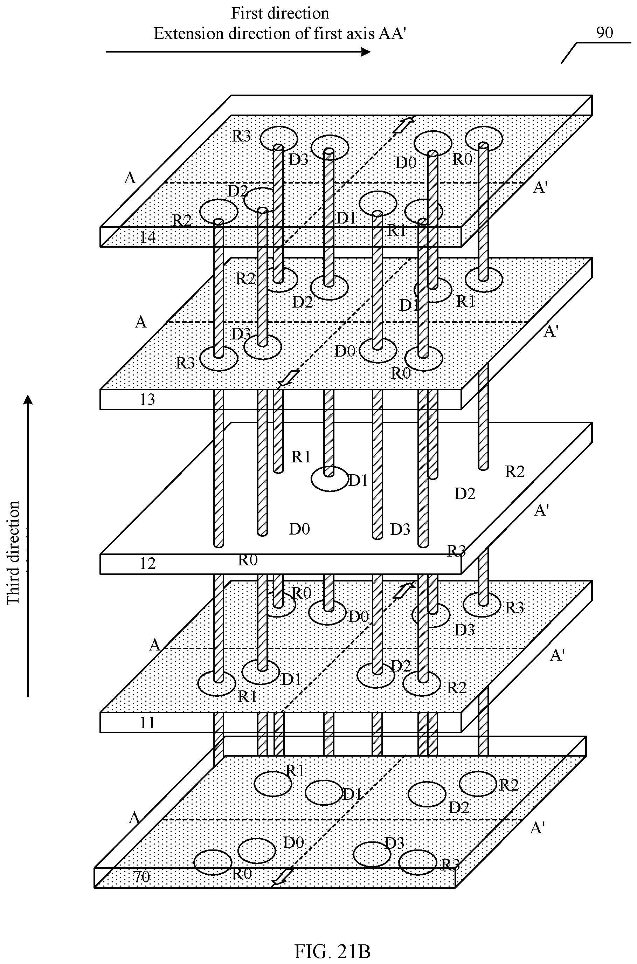

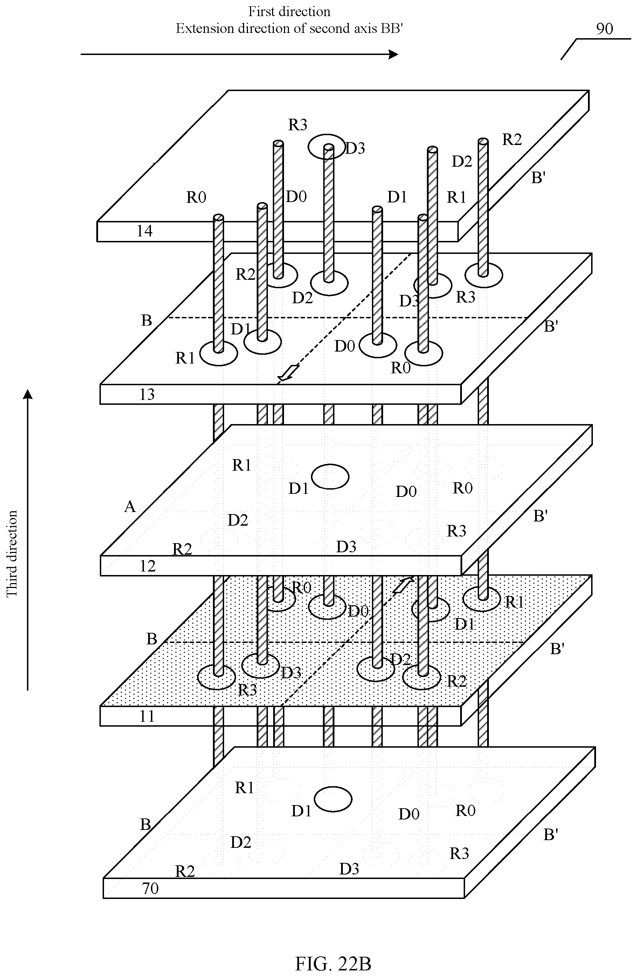

Referring to FIG. 21B or 22B, for the third and fourth specific embodiments, each signal region has the following alignment relationship:
The second normal conductive via D1 in the i^{th} conductive via group of the logic chip 70, the first normal conductive via D0 in the i^{th} conductive via group of each first memory chip 11, the second normal conductive via D1 in the i^{th} conductive via group of each second memory chip 12, the third normal conductive via D2 in the i^{th} conductive via group of each third memory chip 13, and the fourth normal conductive via D3 in the i^{th} conductive via group of each fourth memory chip 14 are aligned along the third direction and form a normal signal transmission channel.

The first normal conductive via D0 in the i^{th} conductive via group of the logic chip 70, the second normal conductive via D1 in the i^{th} conductive via group of each first memory chip 11, the first normal conductive via D0 in the i^{th} conductive via group of each second memory chip 12, the fourth normal conductive via D3 in the i^{th} conductive via group of each third memory chip 13, and the third normal conductive via D2 in the i^{th} conductive via group of each fourth memory chip 14 are aligned along the third direction and form a normal signal transmission channel.

The fourth normal conductive via D3 in the i^{th} conductive via group of the logic chip 70, the third normal conductive via D2 in the i^{th} conductive via group of each first memory chip 11, the fourth normal conductive via D3 in the i^{th} conductive via group of each second memory chip 12, the first normal conductive via D0 in the i^{th} conductive via group of each third memory chip 13, and the second normal conductive via D1 in the i^{th} conductive via group of each fourth memory chip 14 are aligned along the third direction and form a normal signal transmission channel.

The third normal conductive via D2 in the i^{th} conductive via group of the logic chip 70, the fourth normal conductive via D3 in the i^{th} conductive via group of each first memory chip 11, the third normal conductive via D2 in the i^{th} conductive via group of each second memory chip 12, the second normal conductive via D1 in the i^{th} conductive via group of each third memory chip 13, and the first normal conductive via D0 in the i^{th} conductive via group of each fourth memory chip 14 are aligned along the third direction and form a normal signal transmission channel.

Similarly, the first memory chip 11 is at the first-type position, the second memory chip 12 is at the second-type position, the memory chip 13 is at the third-type position, and the memory chip 14 is at the fourth-type position. Therefore, the same internal port receives the same signal.

Meanwhile, referring to FIGS. 21B and 22B. The alignment relationship for the redundant conductive vias is as follows:
The second redundant conductive via R1 in the i^{th} conductive via group of the logic chip 70, the first redundant conductive via R0 in the i^{th} conductive via group of each first memory chip 11, the second redundant conductive via R1 in the i^{th} conductive via group of each second memory chip 12, the third redundant conductive via R2 in the i^{th} conductive via group of each third memory chip 13, and the fourth redundant conductive via R3 in the i^{th} conductive via group of each fourth memory chip 14 are aligned along the third direction and form a redundant signal transmission channel.

The first redundant conductive via R0 in the i^{th} conductive via group of the logic chip 70, the second redundant conductive via R1 in the i^{th} conductive via group of each first memory chip 11, the first redundant conductive via R0 in the i^{th} conductive via group of each second memory chip 12, the fourth redundant conductive via R3 in the i^{th} conductive via group of each third memory chip 13, and the third redundant conductive via R2 in the i^{th} conductive via group of each fourth memory chip 14 are aligned along the third direction and form a redundant signal transmission channel.

The fourth redundant conductive via R3 in the i^{th} conductive via group of the logic chip 70, the third redundant conductive via R2 of in i^{th} conductive via group of each first memory chip 11, the fourth redundant conductive via R3 of in i^{th} conductive via group of each second memory chip 12, the first redundant conductive via R0 in the i^{th} conductive via group of each third memory chip 13, and the second redundant conductive via R1 in the i^{th} conductive via group of each fourth memory chip 14 are aligned along the third direction and form a redundant signal transmission channel.

The third redundant conductive via R2 in the i^{th} conductive via group of the logic chip 70, the fourth redundant conductive via R3 in the i^{th} conductive via group of each first memory chip 11, the third redundant conductive via R2 in the i^{th} conductive via group of each second memory chip 12, the second redundant conductive via R1 in the i^{th} conductive via group of each third memory chip 13, and the first redundant conductive via R0 in the i^{th} conductive via group of each fourth memory chip 14 are aligned along the third direction and form a redundant signal transmission channel.

Meanwhile, for the repair process when the normal signal transmission channel fails, reference may be made to the above description.

Whether it is FIG. 21A/21B or FIG. 22A/22B, the correspondence relationship between the four internal ports of each chip and the conductive vias, as well as the specific signals, can be found in the following Table 4.

**Table 4**

| Memory chip | | | | | Logic chip 70 | |
|---|---|---|---|---|---|---|
| | First memory chip 11 | Second memory chip 12 | Third memory chip 13 | Fourth memory chip 14 | | |
| Select signal | 00 | 01 | 11 | 10 | - | |
| First internal port In0 | D0 (SignalA) | D3 (SignalA) | D2 (SignalA) | D1 (SignalA) | First signal port TA0 | D0 (SignalA) |
| Second internal port In1 | D1 (SignalB) | D2 (SignalB) | D3 (SignalB) | D0 (SignalB) | Second signal port TA1 | D1 (SignalB) |
| Third internal port In2 | D2 (SignalC) | D1 (SignalC) | D0 (SignalC) | D3 (SignalC) | Third signal port TA2 | D2 (SignalC) |
| Fourth internal port In3 | D3 (SignalD) | D0 (SignalD) | D1 (SignalD) | D2 (SignalD) | Fourth signal port TA3 | D3 (SignalD) |

Meanwhile, it can be seen from FIGS. 17A to 22B that for the chip stack structure 90, the signal transmission path from bottom to top is similar to the following form: from the fourth conductive via D3 in the logic chip 70 to the first conductive via D0 in the first memory chip 11 to the second conductive via D1 in the second memory chip 12 to the third conductive via D2 in the third memory chip 13 to the fourth conductive via D3 in the fourth memory chip 14, and so on, for transmission. That is, for the chip stack structure 90, from the perspective of physics, the conductive vias therein are still of a direct connection configuration. However, in terms of the absolute position of the conductive vias on the active surface, the conductive vias can also be considered to have a functional rotation configuration, that is, a signal transmission effect similar to that in FIG. 2 (that is, a rotation transmission effect like from the conductive via D0 to the conductive via D1 to the conductive via D2 to the conductive via D3, and so on) is achieved through the physical direct connection configuration. In brief, the chip stack structure 90 in FIG. 2B needs a physical spiral structure, in which a lateral interconnection structure is necessarily present, whereas the chip stack structure 90 in the embodiment of the present disclosure is a physical direct connection structure and does not need a lateral interconnection structure, such that the parasitic resistance is greatly reduced, and the transmission speed and the transmission performance are greatly improved.

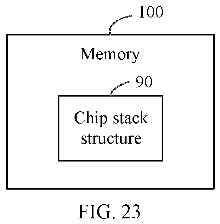

In still another embodiment of the present disclosure, referring to FIG. 23, a schematic diagram of a composition structure of a memory 100 according to an embodiment of the present disclosure is shown. As shown in FIG. 23, the memory 100 includes the chip stack structure 90 of the foregoing embodiment.

In some embodiments, the memory 100 may be, for example, a static random access memory (SRAM), a dynamic random access memory (DRAM), a synchronous dynamic random access memory (SDRAM), a double data rate SDRAM (DDR SDRAM), or the like, which is not specifically limited herein.

In the embodiment of the present disclosure, for the memory 100, the area of the chip can be reduced, such that the manufacturing cost of the chip can be reduced.

For details not disclosed in the embodiment of the present disclosure, reference may be made to the description of the foregoing embodiments for understanding.

The above description shows merely preferred embodiments of the present disclosure and is not intended to limit the protection scope of the present disclosure.

It should be noted that in the present disclosure, the terms "include", "comprise", or any other variants thereof are intended to cover non-exclusive inclusion, such that a process, a method, an item, or an apparatus including a series of elements includes not only those elements but also other elements not explicitly listed, or elements inherent to such process, method, item, or apparatus. Without further limitation, an element defined by the phrase "including a ..." or "comprising a ..." does not exclude the presence of other identical elements in the process, method, item, or apparatus that includes the element.

The serial numbers of the embodiments of the present disclosure described above are for the purpose of describing only and do not represent the superiority or inferiority of the embodiments.

The methods disclosed in the method embodiments provided in the present disclosure may be combined in any manner without conflict to obtain new method embodiments.

The features disclosed in the product embodiments provided in the present disclosure may be combined in any manner without conflict to obtain new product embodiments.

The features disclosed in the method or device embodiments provided in the present disclosure may be combined in any manner without conflict to obtain new method or device embodiments.

The above description is only the specific embodiments of the present disclosure, but the protection scope of the present disclosure is not limited thereto; changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A memory chip (10), wherein a center point of an active surface of the memory chip (10) and an area adjacent to the center point are defined as a global signal region (20), and a center point of the global signal region (20) coincides with the center point of the active surface; the global signal region (20) has a first axis and a second axis, the first axis and the second axis are perpendicular to each other and intersect at the center point of the active surface, the first axis is parallel to a first side of the memory chip (10), and the second axis is parallel to a second side of the memory chip (10);
the global signal region (20) is penetrated by n conductive via groups along a third direction, wherein the third direction is perpendicular to the active surface, and n is a positive integer;
each one of the conductive via groups comprises four normal conductive vias; a first normal conductive via (D0) and a second normal conductive via (D1) are arranged symmetrically about the first axis, a third normal conductive via (D2) and a fourth normal conductive via (D3) are arranged symmetrically about the first axis, and the first normal conductive via (D0) and the fourth normal conductive via (D3) are arranged symmetrically about the second axis;
an internal circuit of the memory chip (10) comprises n internal port groups, and each one of the internal port groups comprises four internal ports; and
the memory chip further comprises n select circuits (30); an i^{th} one of the select circuits (30) is configured to receive a select signal, and electrically connect, based on the select signal, four normal conductive vias in an i^{th} one of the conductive via groups in one-to-one correspondence to four internal ports in an i^{th} one of the internal port groups, wherein a correspondence relationship between the four normal conductive vias and the four internal ports is determined based on the select signal, and i is a positive integer less than or equal to n.

2. The memory chip (10) according to claim 1, wherein each one of the internal port groups comprises a first internal port (In0), a second internal port (In1), a third internal port (In2), and a fourth internal port (In3); and
each one of the select circuits (30) is specifically configured to: electrically connect, if the select signal has a first preset value, the first normal conductive via (D0), the second normal conductive via (D1), the third normal conductive via (D2), and the fourth normal conductive via (D3) in one-to-one correspondence to the first internal port (In0), the second internal port (In1), the third internal port (In2), and the fourth internal port (In3);
electrically connect, if the select signal has a second preset value, the first normal conductive via (D0), the second normal conductive via (D1), the third normal conductive via (D2), and the fourth normal conductive via (D3) in one-to-one correspondence to the second internal port (In1), the first internal port (In0), the fourth internal port (In3), and the third internal port (In2);
electrically connect, if the select signal has a third preset value, the first normal conductive via (D0), the second normal conductive via (D1), the third normal conductive via (D2), and the fourth normal conductive via (D3) in one-to-one correspondence to the third internal port (In2), the fourth internal port (In3), the first internal port (In0), and the second internal port (In1); or
electrically connect, if the select signal has a fourth preset value, the first normal conductive via (D0), the second normal conductive via (D1), the third normal conductive via (D2), and the fourth normal conductive via (D3) in one-to-one correspondence to the fourth internal port (In3), the third internal port (In2), the second internal port (In1), and the first internal port (In0).

3. The memory chip (10) according to claim 2, wherein every four memory chips (10) are stacked along the third direction into one stack unit, and a chip position identification code of each one of the memory chips (10) indicates a position of the memory chip (10) in a corresponding stack unit;
the memory chip (10) further comprises:
a decoding circuit (21), configured to: receive the chip position identification code, and output the select signal with the first preset value if the chip position identification code indicates that the memory chip (10) is at a first-type position; output the select signal with the second preset value if the chip position identification code indicates that the memory chip (10) is at a second-type position; output the select signal with the third preset value if the chip position identification code indicates that the memory chip (10) is at a third-type position; or output the select signal with the fourth preset value if the chip position identification code indicates that the memory chip (10) is at a fourth-type position,
wherein top surfaces of the memory chips (10) at the first-type position and the third-type position face upward along the third direction, and top surfaces of the memory chips (10) at the second-type position and the fourth-type position face downward along the third direction; an active surface of each one of the memory chips (10) is divided into a lower transmission region and a upper transmission region, and the lower transmission region in the memory chip (10) at the first-type position, the upper transmission region in the memory chip (10) at the second-type position, the upper transmission region in the memory chip (10) at the third-type position, and the lower transmission region in the memory chip (10) at the fourth-type position are aligned along the third direction.

4. The memory chip (10) according to claim 2 or 3, wherein
each one of the conductive via groups further comprises a first redundant conductive vias (R0), a second redundant conductive vias (R1), a third redundant conductive vias (R2), and a fourth redundant conductive vias (R3); the a first redundant conductive vias (R0) and the a second redundant conductive vias (R1) are arranged symmetrically about the first axis, the a third redundant conductive vias (R2) and the a fourth redundant conductive vias (R3) are arranged symmetrically about the first axis, and the a first redundant conductive vias (R0) and the a fourth redundant conductive vias (R3) are arranged symmetrically about the second axis, wherein a is a positive integer;
in each one of the conductive via groups, the a first redundant conductive vias (R0), the a second redundant conductive vias (R1), the first normal conductive via (D0), and the second normal conductive via (D1) form one repair unit, and the a third redundant conductive vias (R2), the a fourth redundant conductive vias (R3), the third normal conductive via (D2), and the fourth normal conductive via (D3) form another repair unit; and
the select circuit (30) is further configured to replace, when any one of the normal conductive vias fails, the failed normal conductive via with another conductive via in a same repair unit for an electric connection to a corresponding internal port.

5. The memory chip (10) according to claim 4, wherein in a case where a = 1,
the select circuit (30) is specifically configured to: replace, if the first normal conductive via (D0) fails, the first normal conductive via (D0) with the first redundant conductive via (R0) or the fourth normal conductive via (D3) for an electric connection to a corresponding internal port;
replace, if the fourth normal conductive via (D3) fails, the fourth normal conductive via (D3) with the fourth redundant conductive via (R3) or the first normal conductive via (D0) for an electric connection to a corresponding internal port;
replace, if the second normal conductive via (D1) fails, the second normal conductive via (D1) with the second redundant conductive via (R1) or the third normal conductive via (D2) for an electric connection to a corresponding internal port; or
replace, if the third normal conductive via (D2) fails, the third normal conductive via (D2) with the third redundant conductive via (R2) or the second normal conductive via (D1) for an electric connection to a corresponding internal port.

6. The memory chip (10) according to claim 5, wherein the select signal comprises a first select signal and a second select signal; the i^{th} select circuit (30) comprises an i^{th} first select circuit (31), an i^{th} second select circuit (32), an i^{th} first signal output circuit (33), and an i^{th} second signal output circuit (34);
one side of the i^{th} first select circuit (31) is coupled to the first normal conductive via (D0), the fourth normal conductive via (D3), the first redundant conductive via (R0), and the fourth redundant conductive via (R3) in the i^{th} conductive via group, and the other side of the i^{th} first select circuit is coupled to an i^{th} first secondary node and an i^{th} fourth secondary node; the first select circuit (31) is configured to receive an i^{th} first via state parameter group and the first select signal, and electrically connect one of the coupled conductive vias to the i^{th} first secondary node as well as electrically connect another one of the coupled conductive vias to the i^{th} fourth secondary node based on the i^{th} first via state parameter group and the first select signal;
one side of the i^{th} second select circuit (32) is coupled to the second normal conductive via (D1), the third normal conductive via (D2), the second redundant conductive via (R1), and the third redundant conductive via (R2) in the i^{th} conductive via group, and the other side of the i^{th} second select circuit is coupled to an i^{th} second secondary node and an i^{th} third secondary node; the second select circuit (32) is configured to receive an i^{th} second via state parameter group and the first select signal, and electrically connect one of the coupled conductive vias to the i^{th} second secondary node as well as electrically connect another one of the coupled conductive vias to the i^{th} third secondary node based on the i^{th} second via state parameter group and the first select signal;
the i^{th} first signal output circuit (33) is configured to receive the second select signal, and based on the second select signal, electrically connect the i^{th} first secondary node to an i^{th} first internal port (In0) as well as electrically connect the i^{th} fourth secondary node to an i^{th} fourth internal port (In3); or electrically connect the i^{th} second secondary node to an i^{th} first internal port (In0) as well as electrically connect the i^{th} third secondary node to an i^{th} fourth internal port (In3); and
the i^{th} second signal output circuit (34) is configured to receive the second select signal, and based on the second select signal, electrically connect the i^{th} second secondary node to an i^{th} second internal port (In1) as well as electrically connect the i^{th} third secondary node to an i^{th} third internal port (In2); or electrically connect the i^{th} first secondary node to an i^{th} second internal port (In1) as well as electrically connect the i^{th} fourth secondary node to an i^{th} third internal port (In2).

7. The memory chip (10) according to claim 6, wherein the i^{th} first select circuit (31) comprises an i^{th} first repair circuit (311), an i^{th} second repair circuit (312), and an i^{th} first select output circuit (313);
one side of the i^{th} first repair circuit (311) is coupled to the first redundant conductive via (R0), the first normal conductive via (D0), and the fourth normal conductive via (D3) in the i^{th} conductive via group, and the other side of the i^{th} first repair circuit is coupled to an i^{th} first primary node; the first repair circuit (311) is configured to receive the i^{th} first via state parameter group, and electrically connect one of the coupled conductive vias to the i^{th} first primary node based on the i^{th} first via state parameter group;
one side of the i^{th} second repair circuit (312) is coupled to the first normal conductive via (D0), the fourth normal conductive via (D3), and the fourth redundant conductive via (R3) in the i^{th} conductive via group, and the other side of the i^{th} second repair circuit is coupled to an i^{th} fourth primary node; the second repair circuit (312) is configured to receive the i^{th} first via state parameter group, and electrically connect one of the coupled conductive vias to the i^{th} fourth primary node based on the i^{th} first via state parameter group; and
the i^{th} first select output circuit (313) is configured to receive the first select signal, and based on the first select signal, electrically connect the i^{th} first primary node to the i^{th} first secondary node as well as electrically connect the i^{th} fourth primary node to the i^{th} fourth secondary node; or electrically connect the i^{th} first primary node to the i^{th} fourth secondary node as well as electrically connect the i^{th} fourth primary node to the i^{th} first secondary node.

8. The memory chip (10) according to claim 7, wherein the i^{th} first via state parameter group comprises a first state parameter, a second state parameter, a third state parameter, and a fourth state parameter, which indicates, in a one-to-one corresponding manner, whether the first redundant conductive via (R0), the first normal conductive via (D0), the fourth normal conductive via (D3), and the fourth redundant conductive via (R3) in the i^{th} conductive via group have failed; and
the i^{th} first repair circuit (311) comprises a first switching unit (412), a second switching unit (422), a third switching unit (432), a first logic unit (411), a second logic unit (421), and a third logic unit (431), wherein
the first logic unit (411) is configured to output a first control signal in an enabled state only when the i^{th} first via state parameter group satisfies a first preset condition, wherein the first preset condition is that the first state parameter is in the enabled state and the second state parameter is in a disabled state, or that the first state parameter and the second state parameter are both in the enabled state and the third state parameter and the fourth state parameter are both in the disabled state;
the first switching unit (412) is configured to control the i^{th} first redundant conductive via (R0) to be electrically connected to the i^{th} first primary node only when the first control signal is in the enabled state;
the second logic unit (421) is configured to output a second control signal in the enabled state only when the i^{th} first via state parameter group satisfies a second preset condition, wherein the second preset condition is that the second state parameter is in the enabled state, and at least one of the third state parameter and the fourth state parameter is in the enabled state;
the second switching unit (422) is configured to control the i^{th} first normal conductive via (D0) to be electrically connected to the i^{th} first primary node only when the second control signal is in the enabled state;
the third logic unit (431) is configured to output a third control signal in the enabled state only when the i^{th} first via state parameter group satisfies a third preset condition, wherein the third preset condition is that the first state parameter and the second state parameter are both in the disabled state, and the third state parameter is in the enabled state; and
the third switching unit (432) is configured to control the i^{th} fourth normal conductive via (D3) to be electrically connected to the i^{th} first primary node only when the third control signal is in the enabled state,
wherein any one of the state parameters being in the enabled state indicates that a corresponding conductive via has not failed; and any one of the state parameters being in the disabled state indicates that a corresponding conductive via has failed.

9. The memory chip (10) according to claim 8, wherein the i^{th} second repair circuit (312) comprises a fourth switching unit (442), a fifth switching unit (452), a sixth switching unit (462), a fourth logic unit (441), a fifth logic unit (451), and a sixth logic unit (461), wherein
the fourth logic unit (441) is configured to output a fourth control signal in the enabled state only when the i^{th} first via state parameter group satisfies a fourth preset condition, wherein the fourth preset condition is that the fourth state parameter is in the enabled state and the third state parameter is in the disabled state, or that the fourth state parameter and the third state parameter are both in the enabled state and the second state parameter and the first state parameter are both in the disabled state;
the fourth switching unit (442) is configured to control the i^{th} fourth redundant conductive via (R3) to be electrically connected to the i^{th} fourth primary node only when the fourth control signal is in the enabled state;
the fifth logic unit (451) is configured to output a fifth control signal in the enabled state only when the i^{th} first via state parameter group satisfies a fifth preset condition, wherein the fifth preset condition is that the third state parameter is in the enabled state, and at least one of the second state parameter and the first state parameter is in the enabled state;
the fifth switching unit (452) is configured to control the i^{th} fourth normal conductive via (D3) to be electrically connected to the i^{th} fourth primary node only when the fifth control signal is in the enabled state;
the sixth logic unit (461) is configured to output a sixth control signal in the enabled state only when the i^{th} first via state parameter group satisfies a sixth preset condition, wherein the sixth preset condition is that the fourth state parameter and the third state parameter are both in the disabled state, and the second state parameter is in the enabled state; and
the sixth switching unit (462) is configured to control the i^{th} first normal conductive via (D0) to be electrically connected to the i^{th} fourth primary node only when the sixth control signal is in the enabled state.

10. The memory chip (10) according to claim 9, wherein when the enabled state is at a high level and the disabled state is at a low level, the first logic unit (411) comprises a first NOT gate (501), a first AND gate (502), and a first OR gate (503); the second logic unit (421) comprises a second AND gate (511) and a second OR gate (512); the third logic unit (431) comprises a third NOT gate (521) and a third AND gate (522); the fourth logic unit (441) comprises a fourth NOT gate (531), a fourth AND gate (532), and a fourth OR gate (533); the fifth logic unit (451) comprises a fifth AND gate (541) and a fifth OR gate (542); and the sixth logic unit (461) comprises a sixth NOT gate (551) and a sixth AND gate (552), wherein
an input end of the first NOT gate (501) receives the second state parameter, an output end of the first NOT gate (501) is connected to one input end of the first AND gate (502), another input end of the first AND gate (502) receives the first state parameter, an output end of the first AND gate (502) and an output end of the sixth AND gate (552) are respectively connected to two input ends of the first OR gate (503), and the first OR gate (503) outputs the first control signal;
two input ends of the second OR gate (512) respectively receive the third state parameter and the fourth state parameter, an output end of the second OR gate (512) is connected to one input end of the second AND gate (511), another input end of the second AND gate (511) receives the second state parameter, and the second AND gate (511) outputs the second control signal;
an input end of the third NOT gate (521) is connected to an output end of the fifth OR gate (542), an output end of the third NOT gate (521) is connected to one input end of the third AND gate (522), another input end of the third AND gate (522) receives the third state parameter, and the third AND gate (522) outputs the third control signal;
an input end of the fourth NOT gate (531) receives the third state parameter, an output end of the fourth NOT gate (531) is connected to one input end of the fourth AND gate (532), another input end of the fourth AND gate (532) receives the fourth state parameter, an output end of the fourth AND gate (532) and an output end of the third AND gate (522) are respectively connected to two input ends of the fourth OR gate (533), and the fourth OR gate (533) outputs the fourth control signal;
two input ends of the fifth OR gate (542) respectively receive the first state parameter and the second state parameter, an output end of the fifth OR gate (542) is connected to one input end of the fifth AND gate (541), another input end of the fifth AND gate (541) receives the third state parameter, and the fifth AND gate (541) outputs the fifth control signal; and
an input end of the sixth NOT gate (551) is connected to an output end of the second OR gate (512), an output end of the sixth NOT gate (551) is connected to one input end of the sixth AND gate (552), another input end of the sixth AND gate (552) receives the second state parameter, and the sixth AND gate (552) outputs the sixth control signal.

11. The memory chip (10) according to claim 6, wherein the i^{th} second select circuit (32) comprises an i^{th} third repair unit (321), an i^{th} fourth repair unit (322), and an i^{th} second select output circuit (323), wherein
one side of the i^{th} third repair unit (321) is coupled to the second redundant conductive via (R1), the first normal conductive via (D0), and the second normal conductive via (D1) in the i^{th} conductive via group, and the other side of the i^{th} third repair unit is coupled to an i^{th} second primary node; the third repair unit (321) is configured to receive the i^{th} second via state parameter group, and electrically connect one of the coupled conductive vias to the i^{th} second primary node based on the i^{th} second via state parameter group;
one side of the i^{th} fourth repair unit (322) is coupled to the second normal conductive via (D1), a normal conductive via, and the third redundant conductive via (R2) in the i^{th} conductive via group, and the other side of the i^{th} fourth repair unit is coupled to an i^{th} third primary node; the fourth repair unit (322) is configured to receive the i^{th} second via state parameter group, and electrically connect one of the coupled conductive vias to the i^{th} third primary node based on the i^{th} second via state parameter group; and
the i^{th} second select output circuit (323) is configured to receive the first select signal, and based on the first select signal, electrically connect the i^{th} second primary node to the i^{th} second secondary node as well as electrically connect the i^{th} third primary node to the i^{th} third secondary node; or electrically connect the i^{th} third primary node to the i^{th} second secondary node as well as electrically connect the i^{th} second primary node to the i^{th} third secondary node.

12. The memory chip (10) according to claim 11, wherein the i^{th} second via state parameter group comprises a fifth state parameter, a sixth state parameter, a seventh state parameter, and an eighth state parameter, which indicates, in a one-to-one corresponding manner, whether the second redundant conductive via (R1), the second normal conductive via (D1), the third normal conductive via (D2), and the third redundant conductive via (R2) in the corresponding i^{th} conductive via group have failed; and the i^{th} third repair unit (321) comprises a seventh switching unit (612), an eighth switching unit (622), a ninth switching unit (632), a seventh logic unit (611), an eighth logic unit (621), and a ninth logic unit (631), wherein
the seventh logic unit (611) is configured to output a seventh control signal in an enabled state only when the i^{th} second via state parameter group satisfies a seventh preset condition, wherein the seventh preset condition is that the fifth state parameter is in the enabled state and the sixth state parameter is in a disabled state, or that the fifth state parameter and the sixth state parameter are both in the enabled state and the seventh state parameter and the eighth state parameter are both in the disabled state;
the seventh switching unit (612) is configured to control the i^{th} second redundant conductive via (R1) to be electrically connected to the i^{th} second primary node only when the seventh control signal is in the enabled state;
the eighth logic unit (621) is configured to output an eighth control signal in the enabled state only when the i^{th} second via state parameter group satisfies an eighth preset condition, wherein the eighth preset condition is that the sixth state parameter is in the enabled state, and at least one of the seventh state parameter and the eighth state parameter is in the enabled state;
the eighth switching unit (622) is configured to control the i^{th} second normal conductive via (D1) to be electrically connected to the i^{th} second primary node only when the eighth control signal is in the enabled state;
the ninth switching unit (632) is configured to output a ninth control signal in the enabled state only when the i^{th} second via state parameter group satisfies a ninth preset condition, wherein the ninth preset condition is that the fifth state parameter and the sixth state parameter are both in the disabled state, and the seventh state parameter is in the enabled state; and
the ninth switching unit (632) is configured to control the i^{th} third normal conductive via (D2) to be electrically connected to the i^{th} second primary node only when the ninth control signal is in the enabled state,
wherein any one of the state parameters being in the enabled state indicates that a corresponding conductive via has not failed; and any one of the state parameters being in the disabled state indicates that a corresponding conductive via has failed.

13. The memory chip (10) according to claim 12, wherein the i^{th} fourth repair unit (322) comprises a tenth switching unit (642), an eleventh switching unit (652), a twelfth switching unit (662), a tenth logic unit (641), an eleventh logic unit (651), and a twelfth logic unit (661), wherein
the tenth logic unit (641) is configured to output a tenth control signal in the enabled state only when the i^{th} second via state parameter group satisfies a tenth preset condition, wherein the tenth preset condition is that the eighth state parameter is in the enabled state and the seventh state parameter is in the disabled state, or that the seventh state parameter and the eighth state parameter are both in the enabled state and the fifth state parameter and the sixth state parameter are both in the disabled state; the tenth switching unit (642) is configured to control the i^{th} third redundant conductive via (R2) to be electrically connected to the i^{th} third primary node only when the tenth control signal is in the enabled state;
the eleventh logic unit (651) is configured to output an eleventh control signal in the enabled state only when the i^{th} second via state parameter group satisfies an eleventh preset condition, wherein the eleventh preset condition is that the seventh state parameter is in the enabled state, and at least one of the sixth state parameter and the fifth state parameter is in the enabled state;
the eleventh switching unit (652) is configured to control the i^{th} third normal conductive via (D2) to be electrically connected to the i^{th} third primary node only when the eleventh control signal is in the enabled state;
the twelfth logic unit (661) is configured to output a twelfth control signal in the enabled state only when the i^{th} second via state parameter group satisfies a twelfth preset condition, wherein the twelfth preset condition is that the eighth state parameter and the seventh state parameter are both in the disabled state, and the sixth state parameter is in the enabled state; and
the twelfth switching unit (662) is configured to control the i^{th} second normal conductive via (D1) to be electrically connected to the i^{th} third primary node only when the twelfth control signal is in the enabled state.

14. The memory chip (10) according to claim 13, wherein when the enabled state is at a high level and the disabled state is at a low level, the seventh logic unit (611) comprises a seventh NOT gate (701), a seventh AND gate (702), and a seventh OR gate (703); the eighth logic unit (621) comprises an eighth AND gate (711) and an eighth OR gate (712); the ninth logic unit (631) comprises a ninth NOT gate (721) and a ninth AND gate (722); the tenth logic unit (641) comprises a tenth NOT gate (731), a tenth AND gate (732), and a tenth OR gate (733); the eleventh logic unit (651) comprises an eleventh AND gate (741) and an eleventh OR gate (742); and the twelfth logic unit (661) comprises a twelfth NOT gate (751) and a twelfth AND gate (752), wherein
an input end of the seventh NOT gate (701) receives the sixth state parameter, an output end of the seventh NOT gate (701) is connected to one input end of the seventh AND gate (702), another input end of the seventh AND gate (702) receives the fifth state parameter, an output end of the seventh AND gate (702) and an output end of the twelfth AND gate (752) are respectively connected to two input ends of the seventh OR gate (703), and the seventh OR gate (703) outputs the seventh control signal;
two input ends of the eighth OR gate (712) respectively receive the seventh state parameter and the eighth state parameter, an output end of the eighth OR gate (712) is connected to one input end of the eighth AND gate (711), another input end of the eighth AND gate (711) receives the sixth state parameter, and the eighth AND gate (711) outputs the eighth control signal;
an input end of the ninth NOT gate (721) is connected to an output end of the eleventh OR gate (742), an output end of the ninth NOT gate (721) is connected to one input end of the ninth AND gate (722), another input end of the ninth AND gate (722) receives the seventh state parameter, and the ninth AND gate (722) outputs the ninth control signal;
an input end of the tenth NOT gate (731) receives the seventh state parameter, an output end of the tenth NOT gate (731) is connected to one input end of the tenth AND gate (732), another input end of the tenth AND gate (732) receives the sixth state parameter, an output end of the tenth AND gate (732) and an output end of the ninth AND gate (722) are respectively connected to two input ends of the tenth OR gate (733), and the tenth OR gate (733) outputs the tenth control signal;
two input ends of the eleventh OR gate (742) respectively receive the fifth state parameter and the sixth state parameter, an output end of the eleventh OR gate (742) is connected to one input end of the eleventh AND gate (741), another input end of the eleventh AND gate (741) receives the seventh state parameter, and the eleventh AND gate (741) outputs the eleventh control signal; and
an input end of the twelfth NOT gate (751) is connected to an output end of the eighth OR gate (712), an output end of the twelfth NOT gate (751) is connected to one input end of the twelfth AND gate (752), another input end of the twelfth AND gate (752) receives the sixth state parameter, and the twelfth AND gate (752) outputs the twelfth control signal.

15. The memory chip (10) according to any one of claims 1-3 and 5-14, wherein
the conductive vias are prepared by any one or more of a via-first process, a via-middle process, a via-last process, and a back side via-last process, and different conductive vias in a same memory chip (10) are electrically isolated from each other.

16. A logic chip (70), wherein a center point of an active surface of the logic chip (70) and an area adjacent to the center point are defined as a global signal region (20), and a center point of the global signal region (20) coincides with the center point of the active surface; the global signal region (20) has a first axis and a second axis, the first axis and the second axis are perpendicular to each other and intersect at the center point of the active surface, the first axis is parallel to a first side of the logic chip (70), and the second axis is parallel to a second side of the logic chip (70);
the global signal region (20) is penetrated by n conductive via groups along a third direction, wherein the third direction is perpendicular to the active surface, and n is a positive integer;
each one of the conductive via groups comprises four normal conductive vias; a first normal conductive via (D0) and a second normal conductive via (D1) are arranged symmetrically about the first axis, a third normal conductive via (D2) and a fourth normal conductive via (D3) are arranged symmetrically about the first axis, and the first normal conductive via (D0) and the fourth normal conductive via (D3) are arranged symmetrically about the second axis;
the logic chip (70) further comprises n control circuits (80), and an internal circuit of the logic chip (70) comprises n first signal ports, n second signal ports, n third signal ports, and n fourth signal ports, wherein
an i^{th} one of the control circuits (80) is configured to electrically connect the first normal conductive via (D0), the second normal conductive via (D1), the third normal conductive via (D2), and the fourth normal conductive via (D3) in an i^{th} one of the conductive via groups in one-to-one correspondence to an i^{th} one of the first signal ports, an i^{th} one of the second signal ports, an i^{th} one of the third signal ports, and an i^{th} one of the fourth signal ports.

17. The logic chip (70) according to claim 16, wherein
each one of the conductive via groups further comprises 4a redundant conductive vias; a first redundant conductive vias (R0) and a second redundant conductive vias (R1) are arranged symmetrically about the first axis, a third redundant conductive vias (R2) and a fourth redundant conductive vias (R3) are arranged symmetrically about the first axis, and the a first redundant conductive vias (R0) and the a fourth redundant conductive vias (R3) are arranged symmetrically about the second axis;
the a first redundant conductive vias (R0), the a second redundant conductive vias (R1), the first normal conductive via (D0), and the second normal conductive via (D1) form one repair unit, and the a third redundant conductive vias (R2), the a fourth redundant conductive vias (R3), the third normal conductive via (D2), and the fourth normal conductive via (D3) form another repair unit; and
the i^{th} control circuit (80) is further configured to replace, when any one of the normal conductive vias fails, the failed normal conductive via with another conductive via in a same repair unit for an electric connection to a corresponding signal port.

18. The logic chip (70) according to claim 17, wherein in a case where a = 1,
each one of the control circuits (80) is specifically configured to: replace, if the first normal conductive via (D0) fails, the first normal conductive via (D0) with the first redundant conductive via (R0) or the fourth normal conductive via (D3) for an electric connection to a corresponding signal port;
replace, if the fourth normal conductive via (D3) fails, the fourth normal conductive via (D3) with the fourth redundant conductive via (R3) or the first normal conductive via (D0) for an electric connection to a corresponding signal port;
replace, if the second normal conductive via (D1) fails, the second normal conductive via (D1) with the second redundant conductive via (R1) or the third normal conductive via (D2) for an electric connection to a corresponding signal port; or
replace, if the third normal conductive via (D2) fails, the third normal conductive via (D2) with the third redundant conductive via (R2) or the second normal conductive via (D1) for an electric connection to a corresponding signal port.

19. The logic chip (70) according to claim 18, wherein the i^{th} control circuit (80) comprises an i^{th} first control circuit (81) and an i^{th} second control circuit (82), wherein
one side of the i^{th} first control circuit (81) is coupled to the first normal conductive via (D0), the fourth normal conductive via (D3), the first redundant conductive via (R0), and the fourth redundant conductive via (R3) in the i^{th} conductive via group, and the other side of the i^{th} first control circuit is coupled to the i^{th} first signal port and the i^{th} fourth signal port; the i^{th} first control circuit (81) is configured to receive an i^{th} first via state parameter group, and electrically connect one of the coupled conductive vias to the i^{th} first signal port as well as electrically connect another one of the coupled conductive vias to the i^{th} fourth signal port based on the i^{th} first via state parameter group; and
one side of the i^{th} second control circuit (82) is coupled to the second normal conductive via (D1), the third normal conductive via (D2), the second redundant conductive via (R1), and the third redundant conductive via (R2) in the i^{th} conductive via group, and the other side of the i^{th} second control circuit is coupled to the i^{th} second signal port and the i^{th} third signal port; the i^{th} second control circuit (82) is configured to receive an i^{th} second via state parameter group, and electrically connect one of the coupled conductive vias to the i^{th} second signal port as well as electrically connect another one of the coupled conductive vias to the i^{th} third signal port based on the i^{th} second via state parameter group.

20. The logic chip (70) according to claim 19, wherein the i^{th} first control circuit (81) comprises an i^{th} first repair circuit (311) and an i^{th} second repair circuit (312), wherein
one side of the i^{th} first repair circuit (311) is coupled to the first redundant conductive via (R0), the first normal conductive via (D0), and the fourth normal conductive via (D3) in the i^{th} conductive via group, and the other side of the i^{th} first repair circuit is coupled to the i^{th} first signal port; the first repair circuit (311) is configured to receive the i^{th} first via state parameter group, and electrically connect one of the coupled conductive vias to the i^{th} first signal port based on the i^{th} first via state parameter group; and one side of the i^{th} second repair circuit (312) is coupled to the first normal conductive via (D0), the fourth normal conductive via (D3), and the fourth redundant conductive via (R3) in the i^{th} conductive via group, and the other side of the i^{th} second repair circuit is coupled to the i^{th} fourth signal port; the second repair circuit (312) is configured to receive the i^{th} first via state parameter group, and electrically connect one of the coupled conductive vias to the i^{th} fourth signal port based on the i^{th} first via state parameter group.

21. The logic chip (70) according to claim 20, wherein the i^{th} first via state parameter group comprises a first state parameter, a second state parameter, a third state parameter, and a fourth state parameter, which indicates, in a one-to-one corresponding manner, whether the first redundant conductive via (R0), the first normal conductive via (D0), the fourth normal conductive via (D3), and the fourth redundant conductive via (R3) in the i^{th} conductive via group have failed; and
the i^{th} first repair circuit (311) comprises a first switching unit (412), a second switching unit (422), a third switching unit (432), a first logic unit (411), a second logic unit (421), and a third logic unit (431), wherein
the first logic unit (411) is configured to output a first control signal in an enabled state only when the i^{th} first via state parameter group satisfies a first preset condition, wherein the first preset condition is that the first state parameter is in the enabled state and the second state parameter is in a disabled state, or that the first state parameter and the second state parameter are both in the enabled state and the third state parameter and the fourth state parameter are both in the disabled state;
the first switching unit (412) is configured to control the i^{th} first redundant conductive via (R0) to be electrically connected to the i^{th} first signal port only when the first control signal is in the enabled state; the second logic unit (421) is configured to output a second control signal in the enabled state only when the i^{th} first via state parameter group satisfies a second preset condition, wherein the second preset condition is that the second state parameter is in the enabled state, and at least one of the third state parameter and the fourth state parameter is in the enabled state;
the second switching unit (422) is configured to control the i^{th} first normal conductive via (D0) to be electrically connected to the i^{th} first signal port only when the second control signal is in the enabled state;
the third logic unit (431) is configured to output a third control signal in the enabled state only when the i^{th} first via state parameter group satisfies a third preset condition, wherein the third preset condition is that the first state parameter and the second state parameter are both in the disabled state, and the third state parameter is in the enabled state; and
the third switching unit (432) is configured to control the i^{th} fourth normal conductive via (D3) to be electrically connected to the i^{th} first signal port only when the third control signal is in the enabled state, wherein any one of the state parameters being in the enabled state indicates that a corresponding conductive via has not failed; and any one of the state parameters being in the disabled state indicates that a corresponding conductive via has failed.

22. The logic chip (70) according to claim 21, wherein the i^{th} second repair circuit (312) comprises a fourth switching unit (442), a fifth switching unit (452), a sixth switching unit (462), a fourth logic unit (441), a fifth logic unit (451), and a sixth logic unit (461), wherein
the fourth logic unit (441) is configured to output a fourth control signal in the enabled state only when the i^{th} first via state parameter group satisfies a fourth preset condition, wherein the fourth preset condition is that the fourth state parameter is in the enabled state and the third state parameter is in the disabled state, or that the fourth state parameter and the third state parameter are both in the enabled state and the second state parameter and the first state parameter are both in the disabled state;
the fourth switching unit (442) is configured to control the i^{th} fourth redundant conductive via (R3) to be electrically connected to the i^{th} fourth signal port only when the fourth control signal is in the enabled state;
the fifth logic unit (451) is configured to output a fifth control signal in the enabled state only when the i^{th} first via state parameter group satisfies a fifth preset condition, wherein the fifth preset condition is that the third state parameter is in the enabled state, and at least one of the second state parameter and the first state parameter is in the enabled state;
the fifth switching unit (452) is configured to control the i^{th} fourth normal conductive via (D3) to be electrically connected to the i^{th} fourth signal port only when the fifth control signal is in the enabled state;
the sixth switching unit (462) is configured to output a sixth control signal in the enabled state only when the i^{th} first via state parameter group satisfies a sixth preset condition, wherein the sixth preset condition is that the fourth state parameter and the third state parameter are both in the disabled state, and the second state parameter is in the enabled state; and
the sixth switching unit (462) is configured to control the i^{th} first normal conductive via (D0) to be electrically connected to the i^{th} fourth signal port only when the sixth control signal is in the enabled state.

23. The logic chip (70) according to claim 22, wherein when the enabled state is at a high level and the disabled state is at a low level, the first logic unit (411) comprises a first NOT gate (501), a first AND gate (502), and a first OR gate (503); the second logic unit (421) comprises a second AND gate (511) and a second OR gate (512); the third logic unit (431) comprises a third NOT gate (521) and a third AND gate (522); the fourth logic unit (441) comprises a fourth NOT gate (531), a fourth AND gate (532), and a fourth OR gate (533); the fifth logic unit (451) comprises a fifth AND gate (541) and a fifth OR gate (542); and the sixth logic unit (461) comprises a sixth NOT gate (551) and a sixth AND gate (552), wherein
an input end of the first NOT gate (501) receives the second state parameter, an output end of the first NOT gate (501) is connected to one input end of the first AND gate (502), another input end of the first AND gate (502) receives the first state parameter, an output end of the first AND gate (502) and an output end of the sixth AND gate (552) are respectively connected to two input ends of the first OR gate (503), and the first OR gate (503) outputs the first control signal;
two input ends of the second OR gate (512) respectively receive the third state parameter and the fourth state parameter, an output end of the second OR gate (512) is connected to one input end of the second AND gate (511), another input end of the second AND gate (511) receives the second state parameter, and the second AND gate (511) outputs the second control signal;
an input end of the third NOT gate (521) is connected to an output end of the fifth OR gate (542), an output end of the third NOT gate (521) is connected to one input end of the third AND gate (522), another input end of the third AND gate (522) receives the third state parameter, and the third AND gate (522) outputs the third control signal;
an input end of the fourth NOT gate (531) receives the third state parameter, an output end of the fourth NOT gate (531) is connected to one input end of the fourth AND gate (532), another input end of the fourth AND gate (532) receives the fourth state parameter, an output end of the fourth AND gate (532) and an output end of the third AND gate (522) are respectively connected to two input ends of the fourth OR gate (533), and the fourth OR gate (533) outputs the fourth control signal;
two input ends of the fifth OR gate (542) respectively receive the first state parameter and the second state parameter, an output end of the fifth OR gate (542) is connected to one input end of the fifth AND gate (541), another input end of the fifth AND gate (541) receives the third state parameter, and the fifth AND gate (541) outputs the fifth control signal; and
an input end of the sixth NOT gate (551) is connected to an output end of the second OR gate (512), an output end of the sixth NOT gate (551) is connected to one input end of the sixth AND gate (552), another input end of the sixth AND gate (552) receives the second state parameter, and the sixth AND gate (552) outputs the sixth control signal.

24. The logic chip (70) according to claim 19, wherein the i^{th} second control circuit (82) comprises an i^{th} third repair unit (321) and an i^{th} fourth repair unit (322), wherein
one side of the i^{th} third repair unit (321) is coupled to the second redundant conductive via (R1), the second normal conductive via (D1), and a third normal conductive via (D2) in the i^{th} conductive via group, and the other side of the i^{th} third repair unit is coupled to the i^{th} second signal port; the third repair unit (321) is configured to receive the second via state parameter group, and electrically connect one of the coupled conductive vias to the i^{th} second signal port based on the second via state parameter group; and
one side of the i^{th} fourth repair unit (322) is coupled to the second normal conductive via (D1), the third normal conductive via (D2), and the fourth redundant conductive via (R3) in the i^{th} conductive via group, and the other side of the i^{th} fourth repair unit is coupled to the i^{th} third signal port; the fourth repair unit (322) is configured to receive the second via state parameter group, and electrically connect one of the coupled conductive vias to the i^{th} third signal port based on the second via state parameter group.

25. The logic chip (70) according to claim 24, wherein the i^{th} second via state parameter group comprises a fifth state parameter, a sixth state parameter, a seventh state parameter, and an eighth state parameter, which are used to indicate, in a one-to-one corresponding manner, whether the second redundant conductive via (R1), the second normal conductive via (D1), the third normal conductive via (D2), and the third redundant conductive via (R2) in the i^{th} conductive via group have failed; and
the i^{th} third repair unit (321) comprises a seventh switching unit (612), an eighth switching unit (622), a ninth switching unit (632), a seventh logic unit (611), an eighth logic unit (621), and a ninth logic unit (631), wherein
the seventh logic unit (611) is configured to output a seventh control signal in an enabled state only when the i^{th} second via state parameter group satisfies a seventh preset condition, wherein the seventh preset condition is that the fifth state parameter is in the enabled state and the sixth state parameter is in a disabled state, or that the fifth state parameter and the sixth state parameter are both in the enabled state and the seventh state parameter and the eighth state parameter are both in the disabled state;
the seventh switching unit (612) is configured to control the i^{th} second redundant conductive via (R1) to be electrically connected to the i^{th} second signal port only when the seventh control signal is in the enabled state;
the eighth logic unit (621) is configured to output an eighth control signal in the enabled state only when the i^{th} second via state parameter group satisfies an eighth preset condition, wherein the eighth preset condition is that the sixth state parameter is in the enabled state, and at least one of the seventh state parameter and the eighth state parameter is in the enabled state;
the eighth switching unit (622) is configured to control the i^{th} second normal conductive via (D1) to be electrically connected to the i^{th} second signal port only when the eighth control signal is in the enabled state;
the ninth logic unit (631) is configured to output a ninth control signal in the enabled state only when the i^{th} second via state parameter group satisfies a ninth preset condition, wherein the ninth preset condition is that the fifth state parameter and the sixth state parameter are both in the disabled state, and the seventh state parameter is in the enabled state; and
the ninth switching unit (632) is configured to control the third normal conductive via (D2) to be electrically connected to the i^{th} second signal port only when the ninth control signal is in the enabled state,
wherein any one of the state parameters being in the enabled state indicates that a corresponding conductive via has not failed; and any one of the state parameters being in the disabled state indicates that a corresponding conductive via has failed.

26. The logic chip (70) according to claim 25, wherein the fourth repair unit (322) comprises a tenth switching unit (642), an eleventh switching unit (652), a twelfth switching unit (662), a tenth logic unit (641), an eleventh logic unit (651), and a twelfth logic unit (661), wherein
the tenth logic unit (641) is configured to output a tenth control signal in the enabled state only when the i^{th} second via state parameter group satisfies a tenth preset condition, wherein the tenth preset condition is that the eighth state parameter is in the enabled state and the seventh state parameter is in the disabled state, or that the eighth state parameter and the seventh state parameter are both in the enabled state and the sixth state parameter and the fifth state parameter are both in the disabled state; the tenth switching unit (642) is configured to control the i^{th} third redundant conductive via (R2) to be electrically connected to the i^{th} third signal port only when the tenth control signal is in the enabled state; the eleventh logic unit (651) is configured to output an eleventh control signal in the enabled state only when the i^{th} second via state parameter group satisfies an eleventh preset condition, wherein the eleventh preset condition is that the seventh state parameter is in the enabled state, and at least one of the sixth state parameter and the fifth state parameter is in the enabled state;
the eleventh switching unit (652) is configured to control the i^{th} third normal conductive via (D2) to be electrically connected to the i^{th} third signal port only when the eleventh control signal is in the enabled state;
the twelfth logic unit (661) is configured to output a twelfth control signal in the enabled state only when the i^{th} second via state parameter group satisfies a twelfth preset condition, wherein the twelfth preset condition is that the eighth state parameter and the seventh state parameter are both in the disabled state, and the sixth state parameter is in the enabled state; and
the twelfth switching unit (662) is configured to control the i^{th} second normal conductive via (D1) to be electrically connected to the i^{th} third signal port only when the twelfth control signal is in the enabled state.

27. The logic chip (70) according to claim 26, wherein when the enabled state is at a high level and the disabled state is at a low level, the seventh logic unit (611) comprises a seventh NOT gate (701), a seventh AND gate (702), and a seventh OR gate (703); the eighth logic unit (621) comprises an eighth AND gate (711) and an eighth OR gate (712); the ninth logic unit (631) comprises a ninth NOT gate (721) and a ninth AND gate (722); the tenth logic unit (641) comprises a tenth NOT gate (731), a tenth AND gate (732), and a tenth OR gate (733); the eleventh logic unit (651) comprises an eleventh AND gate (741) and an eleventh OR gate (742); and the twelfth logic unit (661) comprises a twelfth NOT gate (751) and a twelfth AND gate (752), wherein
an input end of the seventh NOT gate (701) receives the sixth state parameter, an output end of the seventh NOT gate (701) is connected to one input end of the seventh AND gate (702), another input end of the seventh AND gate (702) receives the fifth state parameter, an output end of the seventh AND gate (702) and an output end of the twelfth AND gate (752) are respectively connected to two input ends of the seventh OR gate (703), and the seventh OR gate (703) outputs the seventh control signal; two input ends of the eighth OR gate (712) respectively receive the seventh state parameter and the eighth state parameter, an output end of the eighth OR gate (712) is connected to one input end of the eighth AND gate (711), another input end of the eighth AND gate (711) receives the sixth state parameter, and the eighth AND gate (711) outputs the eighth control signal; an input end of the ninth NOT gate (721) is connected to an output end of the eleventh OR gate (742), an output end of the ninth NOT gate (721) is connected to one input end of the ninth AND gate (722), another input end of the ninth AND gate (722) receives the seventh state parameter, and the ninth AND gate (722) outputs the ninth control signal; and an input end of the tenth NOT gate (731) receives the seventh state parameter, an output end of the tenth NOT gate (731) is connected to one input end of the tenth AND gate (732), another input end of the tenth AND gate (732) receives the sixth state parameter, an output end of the tenth AND gate (732) and an output end of the ninth AND gate (722) are respectively connected to two input ends of the tenth OR gate (733), and the tenth OR gate (733) outputs the tenth control signal; two input ends of the eleventh OR gate (742) respectively receive the fifth state parameter and the sixth state parameter, an output end of the eleventh OR gate (742) is connected to one input end of the eleventh AND gate (741), another input end of the eleventh AND gate (741) receives the seventh state parameter, and the eleventh AND gate (741) outputs the eleventh control signal; an input end of the twelfth NOT gate (751) is connected to an output end of the eighth OR gate (712), an output end of the twelfth NOT gate (751) is connected to one input end of the twelfth AND gate (752), another input end of the twelfth AND gate (752) receives the sixth state parameter, and the twelfth AND gate (752) outputs the twelfth control signal.

28. A chip stack structure (90), comprising the logic chip (70) according to any one of claims 16-27 and at least one stack unit, wherein the logic chip (70) and the at least one stack unit are sequentially stacked along a third direction; each one of the at least one stack unit comprises a first memory chip (11), a second memory chip (12), a third memory chip (13), and a fourth memory chip (14) sequentially stacked along the third direction, with the third direction being perpendicular to a top surface of each one of the memory chips (10); the first memory chip (11), the second memory chip (12), the third memory chip (13), and the fourth memory chip (14) are each the memory chip (10) according to any one of claims 1-15;
the first memory chip (11) and the second memory chip (12) are stacked in a face-to-face manner, the second memory chip (12) and the third memory chip (13) are stacked in a back-to-back manner, and the third memory chip (13) and the fourth memory chip (14) are stacked in a face-to-face manner;
the first memory chip (11) and the logic chip (70) in a first one of the at least one stack unit are stacked in a back-to-face manner, or the first memory chip (11) and the logic chip (70) in the first one of the at least one stack unit are stacked in a back-to-back manner.

29. The chip stack structure (90) according to claim 28, wherein
a chip position identification code of the first memory chip (11) indicates a first-type position, a chip position identification code of the second memory chip (12) indicates a second-type position, a chip position identification code of the third memory chip (13) indicates a third-type position, and a chip position identification code of the fourth memory chip (14) indicates a fourth-type position;
or
a chip position identification code of the first memory chip (11) indicates a first-type position, a chip position identification code of the second memory chip (12) indicates a fourth-type position, a chip position identification code of the third memory chip (13) indicates a third-type position, and a chip position identification code of the fourth memory chip (14) indicates a second-type position.

30. The chip stack structure (90) according to claim 29, wherein in a case where the logic chip (70) and the first memory chip (11) are stacked back-to-back,
a fourth normal conductive via (D3) in an i^{th} conductive via group in the logic chip (70), a first normal conductive via (D0) in an i^{th} conductive via group of each first memory chip (11), a second normal conductive via (D1) in an i^{th} conductive via group of each second memory chip (12), a third normal conductive via (D2) in an i^{th} conductive via group of each third memory chip (13), and a fourth normal conductive via (D3) in an i^{th} conductive via group of each fourth memory chip (14) are aligned along the third direction and form a normal signal transmission channel;
a third normal conductive via (D2) in the i^{th} conductive via group of the logic chip (70), a second normal conductive via (D1) in the i^{th} conductive via group of each first memory chip (11), a first normal conductive via (D0) in the i^{th} conductive via group of each second memory chip (12), a fourth normal conductive via (D3) in the i^{th} conductive via group of each third memory chip (13), and a third normal conductive via (D2) in the i^{th} conductive via group of each fourth memory chip (14) are aligned along the third direction and form a normal signal transmission channel;
a second normal conductive via (D1) in the i^{th} conductive via group of the logic chip (70), a third normal conductive via (D2) in the i^{th} conductive via group of each first memory chip (11), a fourth normal conductive via (D3) in the i^{th} conductive via group of each second memory chip (12), a first normal conductive via (D0) in the i^{th} conductive via group of each third memory chip (13), and a second normal conductive via (D1) in the i^{th} conductive via group of each fourth memory chip (14) are aligned along the third direction and form a normal signal transmission channel; and
a first normal conductive via (D0) in the i^{th} conductive via group of the logic chip (70), a fourth normal conductive via (D3) in the i^{th} conductive via group of each first memory chip (11), a third normal conductive via (D2) in the i^{th} conductive via group of each second memory chip (12), a second normal conductive via (D1) in the i^{th} conductive via group of each third memory chip (13), and a first normal conductive via (D0) in the i^{th} conductive via group of each fourth memory chip (14) are aligned along the third direction and form a normal signal transmission channel,
wherein i is a positive integer less than or equal to n.

31. The chip stack structure (90) according to claim 30, wherein
a fourth redundant conductive via (R3) in the i^{th} conductive via group of the logic chip (70), a first redundant conductive via (R0) in the i^{th} conductive via group of each first memory chip (11), a second redundant conductive via (R1) in the i^{th} conductive via group of each second memory chip (12), a third redundant conductive via (R2) in the i^{th} conductive via group of each third memory chip (13), and a fourth redundant conductive via (R3) in the i^{th} conductive via group of each fourth memory chip (14) are aligned along the third direction and form a redundant signal transmission channel;
a third redundant conductive via (R2) in the i^{th} conductive via group of the logic chip (70), a second redundant conductive via (R1) in the i^{th} conductive via group of each first memory chip (11), a first redundant conductive via (R0) in the i^{th} conductive via group of each second memory chip (12), a fourth redundant conductive via (R3) in the i^{th} conductive via group of each third memory chip (13), and a third redundant conductive via (R2) in the i^{th} conductive via group of each fourth memory chip (14) are aligned along the third direction and form a redundant signal transmission channel;
a second redundant conductive via (R1) in the i^{th} conductive via group of the logic chip (70), a third redundant conductive via (R2) in the i^{th} conductive via group of each first memory chip (11), a fourth redundant conductive via (R3) in the i^{th} conductive via group of each second memory chip (12), a first redundant conductive via (R0) in the i^{th} conductive via group of each third memory chip (13), and a second redundant conductive via (R1) in the i^{th} conductive via group of each fourth memory chip (14) are aligned along the third direction and form a redundant signal transmission channel; and
a first redundant conductive via (R0) in the i^{th} conductive via group of the logic chip (70), a fourth redundant conductive via (R3) in the i^{th} conductive via group of each first memory chip (11), a third redundant conductive via (R2) in the i^{th} conductive via group of each second memory chip (12), a second redundant conductive via (R1) in the i^{th} conductive via group of each third memory chip (13), and a first redundant conductive via (R0) in the i^{th} conductive via group of each fourth memory chip (14) are aligned along the third direction and form a redundant signal transmission channel.

32. The chip stack structure (90) according to claim 29, wherein in a case where the logic chip (70) and the first memory chip (11) are stacked back-to-back,
a second normal conductive via (D1) in an i^{th} conductive via group of the logic chip (70), a first normal conductive via (D0) in an i^{th} conductive via group of each first memory chip (11), a second normal conductive via (D1) in an i^{th} conductive via group of each second memory chip (12), a third normal conductive via (D2) in an i^{th} conductive via group of each third memory chip (13), and a fourth normal conductive via (D3) in an i^{th} conductive via group of each fourth memory chip (14) are aligned along the third direction and form a normal signal transmission channel;
a first normal conductive via (D0) in the i^{th} conductive via group of the logic chip (70), a second normal conductive via (D1) in the i^{th} conductive via group of each first memory chip (11), a first normal conductive via (D0) in the i^{th} conductive via group of each second memory chip (12), a fourth normal conductive via (D3) in the i^{th} conductive via group of each third memory chip (13), and a third normal conductive via (D2) in the i^{th} conductive via group of each fourth memory chip (14) are aligned along the third direction and form a normal signal transmission channel;
a fourth normal conductive via (D3) in the i^{th} conductive via group of the logic chip (70), a third normal conductive via (D2) in the i^{th} conductive via group of each first memory chip (11), a fourth normal conductive via (D3) in the i^{th} conductive via group of each second memory chip (12), a first normal conductive via (D0) in the i^{th} conductive via group of each third memory chip (13), and a second normal conductive via (D1) in the i^{th} conductive via group of each fourth memory chip (14) are aligned along the third direction and form a normal signal transmission channel; and
a third normal conductive via (D2) in the i^{th} conductive via group of the logic chip (70), a fourth normal conductive via (D3) in the i^{th} conductive via group of each first memory chip (11), a third normal conductive via (D2) in the i^{th} conductive via group of each second memory chip (12), a second normal conductive via (D1) in the i^{th} conductive via group of each third memory chip (13), and a first normal conductive via (D0) in the i^{th} conductive via group of each fourth memory chip (14) are aligned along the third direction and form a normal signal transmission channel,

33. The chip stack structure (90) according to claim 32, wherein
a second redundant conductive via (R1) in the i^{th} conductive via group of the logic chip (70), a first redundant conductive via (R0) in the i^{th} conductive via group of each first memory chip (11), a second redundant conductive via (R1) in the i^{th} conductive via group of each second memory chip (12), a third redundant conductive via (R2) in the i^{th} conductive via group of each third memory chip (13), and a fourth redundant conductive via (R3) in the i^{th} conductive via group of each fourth memory chip (14) are aligned along the third direction and form a redundant signal transmission channel;
a first redundant conductive via (R0) in the i^{th} conductive via group of the logic chip (70), a second redundant conductive via (R1) in the i^{th} conductive via group of each first memory chip (11), a first redundant conductive via (R0) in the i^{th} conductive via group of each second memory chip (12), a fourth redundant conductive via (R3) in the i^{th} conductive via group of each third memory chip (13), and a third redundant conductive via (R2) in the i^{th} conductive via group of each fourth memory chip (14) are aligned along the third direction and form a redundant signal transmission channel;
a fourth redundant conductive via (R3) in the i^{th} conductive via group of the logic chip (70), a third redundant conductive via (R2) in the i^{th} conductive via group of each first memory chip (11), a fourth redundant conductive via (R3) in the i^{th} conductive via group of each second memory chip (12), a first redundant conductive via (R0) in the i^{th} conductive via group of each third memory chip (13), and a second redundant conductive via (R1) in the i^{th} conductive via group of each fourth memory chip (14) are aligned along the third direction and form a redundant signal transmission channel; and
a third redundant conductive via (R2) in the i^{th} conductive via group of the logic chip (70), a fourth redundant conductive via (R3) in the i^{th} conductive via group of each first memory chip (11), a third redundant conductive via (R2) in the i^{th} conductive via group of each second memory chip (12), a second redundant conductive via (R1) in the i^{th} conductive via group of each third memory chip (13), and a first redundant conductive via (R0) in the i^{th} conductive via group of each fourth memory chip (14) are aligned along the third direction and form a redundant signal transmission channel.

34. The chip stack structure (90) according to any one of claims 28-33, wherein
for two chips connected in a face-to-face manner, positions in the two chips where the conductive vias are aligned along the third direction are electrically connected through a hybrid bonding process; for two chips connected in a back-to-back manner or for two chips connected in a back-to-face manner, positions in the two chips where the conductive vias are aligned along the third direction are electrically connected through a conductive bumping process; or
for two chips connected in a face-to-face manner or for two chips connected in a back-to-back manner or for two chips connected in a back-to-face manner, positions in the two chips where the conductive vias are aligned along the third direction are electrically connected through the hybrid bonding process; or
for two chips connected in a face-to-face manner or for two chips connected in a back-to-back manner or for two chips connected in a back-to-face manner, positions in the two chips where the conductive vias are aligned along the third direction are electrically connected through the conductive bumping process.

35. A memory (100), comprising the chip stack structure (90) according to any one of claims 28-34.
